# EUROPEAN PATENT APPLICATION

(11) **EP 4 514 103 A1**
(43) Date of publication of application: **26.02.2025**
(21) Application number: 23902400.3
(22) Date of filing: 16.11.2023
(51) Int. Cl.: H10K 59/121

(54) **DISPLAY PANEL AND DISPLAY DEVICE**

(30) Priority: 16.12.2022 CN 202211627442
(71) Applicant: Boe Technology Group Co., Ltd., Beijing 100015 (CN); Chengdu BOE Optoelectronics Technology Co., Ltd., Chengdu, Sichuan 611731 (CN)
(72) Inventor: LIU, Changchang, Beijing 100176 (CN); FANG, Fei, Beijing 100176 (CN); SHI, Ling, Beijing 100176 (CN); ZHANG, Yuxin, Beijing 100176 (CN)
(74) Representative: Haseltine Lake Kempner LLP
(86) International application number: PCT/CN2023/132044
(87) International publication number: WO 2024/125200

(57) **Abstract**

A display panel (10) and a display device. A plurality of first pixel circuits (1021) and a plurality of second pixel circuits (1022) in each pixel circuit group (102) comprised in the display panel (10) are alternately arranged, and the plurality of first pixel circuits (1021) and the plurality of second pixel circuits (1022) are designed in opposite directions, and are arranged in an offset mode in a first direction. Thus, the distance between a first connection part of each first pixel circuit (1021) and a second connection part of each second pixel circuit (1022) in the first direction is relatively small, first signal lines (103) can be directly connected to the first connection part and the second connection part without designing adapter holes between adjacent first pixel circuits (1021) and second pixel circuits (1022) and without being connected by means of wiring layers, such that the number of adapter holes needing to be designed in a layout is reduced, and even if the PPI requirement of the display panel (10) is high, enough space can be provided for designing a small number of adapter holes to achieve signal transmission.

## Description

The present disclosure claims priority to Chinese Patent Application No. 202211627442.X, filed on December 16, 2022, and entitled "DISPLAY PANEL AND DISPLAY DEVICE", the content of which is herein incorporated by reference in its entirety.

### TECHNICAL FIELD

The present disclosure relates to the field of display technologies, and in particular, relates to a display panel and a display device.

### BACKGROUND

Organic light-emitting diode (OLED) display panels are widely used due to their advantages of self-illumination, low driving voltage, fast response, and the like. An OLED display panel generally includes a plurality of pixel units, and each pixel unit includes a light-emitting device and a pixel circuit connected to the light-emitting device.

### SUMMARY

The present disclosure provides a display panel and a display device. The technical solutions are as follows.

In an aspect, a display panel is provided. The display panel includes:
a base substrate, wherein the base substrate is provided with a first display region, the first display region being provided with an optical sensor;
a plurality of pixel circuit groups disposed in the first display region and arranged in a first direction, wherein at least one of the plurality of pixel circuit groups includes a plurality of first pixel circuits arranged in a second direction and a plurality of second pixel circuits arranged in the second direction, wherein the plurality of first pixel circuits and the plurality of second pixel circuits are arranged alternately, each pixel circuit includes a first boundary and a second boundary that extend along the second direction and are arranged in the first direction, an arrangement direction of a first boundary and a second boundary of the first pixel circuit is opposite to an arrangement direction of a first boundary and a second boundary of the second pixel circuit; and for each of the plurality of pixel circuit groups, a distance, in the first direction, between the first boundary of the first pixel circuit and the first boundary of the second pixel circuit is greater than a first distance, and a distance, in the first direction, between the second boundary of the first pixel circuit and the second boundary of the second pixel circuit is less than the first distance, the first distance being a distance, in the first direction, between the first boundary and the second boundary of a same pixel circuit; and
a plurality of first signal lines in one-to-one correspondence with the plurality of pixel circuit groups, wherein each of the plurality of first signal lines is connected to each first pixel circuit in a corresponding pixel circuit group at a first connection and is connected to each second pixel circuit in the corresponding pixel circuit group at a second connection;
wherein a distance between the first connection and the first boundary of the first pixel circuit is equal to a distance between the second connection and the first boundary of the second pixel circuit, and a distance, in the first direction, between the first connection and the second connection is less than a second distance, the second distance being a distance, in the first direction, between the first boundary of the first pixel circuit and the second boundary of the second pixel circuit.

Optionally, the first signal line is a light-emitting control signal line.

Optionally, the plurality of pixel circuit groups at least include a first pixel circuit group and a second pixel circuit group arranged in the first direction, wherein a distance, in the first direction, between a first boundary of a second pixel circuit in the first pixel circuit group and a first boundary of a first pixel circuit in the second pixel circuit group is less than the second distance; and
the display panel further includes a plurality of second signal lines disposed in the first display region, wherein each of the plurality of second signal lines is connected to a second pixel circuit in the first pixel circuit group and a first pixel circuit in the second pixel circuit group.

Optionally, the base substrate is further provided with a second display region, the second display region at least partially surrounding the first display region; and the display panel further includes a first connection trace disposed in the second display region, the first connection trace at least partially surrounding the first display region;
wherein at least one end of each second signal line of the plurality of second signal lines is connected to the first connecting trace, and the each second signal line transmits a signal received from the first connection trace to a pixel circuit connected to the second signal line.

Optionally, the second signal line is a first reset power line.

Optionally, the display panel further includes: a plurality of third signal lines in one-to-one correspondence with the plurality of pixel circuit groups; wherein
each of the plurality of third signal lines is connected to a first pixel circuit and a second pixel circuit in a corresponding pixel circuit group;
wherein a signal transmitted by the third signal line is different from a signal transmitted by the first signal line.

Optionally, each of the first pixel circuits and the second pixel circuits in each of the plurality of pixel circuit groups includes:
a first transistor, wherein a gate of the first transistor is connected to a first reset signal line, a first electrode of the first transistor is connected to a first reset power line, and a second electrode of the first transistor is connected to a second node;
a second transistor, wherein a gate of the second transistor is connected to a first gate signal line in the display panel, a first electrode of the second transistor is connected to a third node, and a second electrode of the second transistor is connected to the second node;
a third transistor, wherein a gate of the third transistor is connected to the second node, a first electrode of the third transistor is connected to a first node, and a second electrode of the third transistor is connected to the third node;
a fourth transistor, wherein a gate of the fourth transistor is connected to a second gate signal line in the display panel, a first electrode of the fourth transistor is connected to a data signal line in the display panel, and a second electrode of the fourth transistor is connected to the first node;
a fifth transistor, wherein a gate of the fifth transistor is connected to a light-emitting control signal line, a first electrode of the fifth transistor is connected to a driving power line in the display panel, and a second electrode of the fifth transistor is connected to the first node;
a sixth transistor, wherein a gate of the sixth transistor is connected to the light-emitting control signal line, a first electrode of the sixth transistor is connected to the third node, and a second electrode of the sixth transistor is connected to the light-emitting unit;
a seventh transistor, wherein a gate of the seventh transistor is connected to a second gate signal line in the display panel, a first electrode of the seventh transistor is connected to a second reset power line, and a second electrode of the seventh transistor is connected to the light-emitting unit; and
a storage capacitor, wherein one terminal of the storage capacitor is connected to the driving power line, and another terminal of the storage capacitor is connected to the second node.

Optionally, the third signal line is the second gate signal line.

Optionally, the first transistor and the second transistor are oxide thin film transistors; and
the third transistor, the fourth transistor, the fifth transistor, the sixth transistor, and the seventh transistor are low-temperature polysilicon thin film transistors.

Optionally, the display panel includes: an active layer, a first gate insulating layer, a first gate layer, a second gate insulating layer, a second gate layer, a buffer layer, an oxide layer, a third gate insulating layer, a third gate layer, an interlayer dielectric layer, and a first source-drain layer that constitute the pixel circuit and are sequentially stacked in a direction away from the base substrate;
the second transistor is composed of the second gate layer, the oxide layer, and the third gate layer;
the first transistor, the third transistor, the fourth transistor, the fifth transistor, the sixth transistor, the seventh transistor, and the eighth thin film transistor are composed of the active layer, the first gate layer, and the first source-drain layer.

Optionally, the display panel includes: an active layer, a first gate insulating layer, a first gate layer, a second gate insulating layer, a second gate layer, a buffer layer, an oxide layer, a third gate insulating layer, a third gate layer, an interlayer dielectric layer, and a first source-drain layer that constitute the pixel circuit and are sequentially stacked in a direction away from the base substrate;
wherein the first signal line is disposed in the first gate layer, and the second signal line is disposed in the first source-drain layer; and
the third signal line includes a first portion, a second portion, and a third portion that are connected in sequence, wherein an orthographic projection of the first portion on the base substrate is at least partially overlapped with an orthographic projection of the first pixel circuit on the base substrate, an orthographic projection of the second portion on the base substrate is not overlapped with the orthographic projection of the first pixel circuit on the base substrate and an orthographic projection of the second pixel circuit on the base substrate, and an orthographic projection of the third portion on the base substrate is at least partially overlapped with the orthographic projection of the second pixel circuit on the base substrate; and the first portion and the third portion are disposed in the first gate layer, and the second portion is disposed in the first source-drain layer.

Optionally, each of the first pixel circuits and the second pixel circuits in each of the plurality of pixel circuit groups further includes: an eighth transistor, wherein a gate of the eighth transistor is connected to the second reset signal line, a first electrode of the eighth transistor is connected to a third reset power line in the display panel, and a second electrode of the eighth transistor is connected to the first node;
wherein the third signal line is the third reset power line.

Optionally, the second transistor is an oxide thin film transistor; and
the first transistor, the third transistor, the fourth transistor, the fifth transistor, the sixth transistor, the seventh transistor, and the eighth transistor are low-temperature polysilicon thin film transistors.

Optionally, the display panel includes: an active layer, a first gate insulating layer, a first gate layer, a second gate insulating layer, a second gate layer, a buffer layer, an oxide layer, a third gate insulating layer, a third gate layer, an interlayer dielectric layer, and a first source-drain layer that constitute the pixel circuit and are sequentially stacked in a direction away from the base substrate; wherein
the second transistor is composed of the second gate layer, the oxide layer, and the third gate layer; and
the first transistor, the third transistor, the fourth transistor, the fifth transistor, the sixth transistor, the seventh transistor, and the eighth thin film transistor are composed of the active layer, the first gate layer, and the first source-drain layer.

Optionally, the display panel includes: an active layer, a first gate insulating layer, a first gate layer, a first gate layer, a second gate insulating layer, a second gate layer, a third gate insulating layer, an oxide layer, a fourth gate insulating layer, a third gate layer, an interlayer dielectric layer, and a first source-drain layer that constitute the pixel circuit and are sequentially stacked in a direction away from the base substrate;
wherein the first signal line is disposed in the first gate layer, the second signal line is disposed in the first source-drain layer, and the third signal line is disposed in the third gate layer.

Optionally, the display panel further includes: a passivation layer, a first trace layer, a first planarization layer, a second trace layer, a second planarization layer, a second source-drain layer, and a third planarization layer that constitute the pixel circuit and are sequentially stacked in a direction away from the first source-drain layer.

Optionally, each target signal line in the display panel includes a first sub-signal line, a second sub-signal line, and a second connection trace; wherein
the first sub-signal line is disposed in the first display region, and the first sub-signal line is connected to a plurality of first pixel circuits in one of the plurality of pixel circuit groups;
the second sub-signal line is disposed in the first display region, and the second sub-signal line is connected to a plurality of second pixel circuits in one of the plurality of pixel circuit groups, wherein the plurality of second pixel circuits connected to the second sub-signal line of each target signal line and the plurality of first pixel circuits connected to the first sub-signal line of the target signal line belong to a same pixel circuit group; and
the second connection trace is disposed in a second display region, one end of the second connection trace is connected to the first sub-signal line, and another end of the second connection trace is connected to the second sub-signal line;
wherein the target signal line is a signal line providing a signal along the second direction other than the first signal line, the second signal line, and the third signal line in the display panel.

Optionally, the first sub-signal line includes a fourth portion and a fifth portion that are connected; wherein an orthographic projection of the fourth portion on the base substrate is at least partially overlapped with an orthographic projection of a first pixel circuit on the base substrate, and an orthographic projection of the fifth portion on the base substrate is between orthographic projections of two adjacent first pixel circuits on the base substrate; and
the second sub-signal line includes a sixth portion and a seventh portion that are connected; wherein an orthographic projection of the sixth portion on the base substrate is at least partially overlapped with an orthographic projection of a second pixel circuit on the base substrate, and an orthographic projection of the seventh portion on the base substrate is between orthographic projections of two adjacent second pixel circuits on the base substrate;
wherein the fourth portion and the sixth portion are disposed in a same layer, and the fourth portion and the sixth portion are disposed in a metal layer; and the fifth portion and the seventh portion are disposed in a same layer, and the fifth portion and the seventh portion are disposed in a trace layer.

In another aspect, a display panel is provided. The display panel includes:
a base substrate, wherein the base substrate is provided with a first display region, the first display region being configured to be provided with an optical sensor;
a plurality of pixel circuit groups disposed in the first display region and arranged in a first direction, wherein at least one of the plurality of pixel circuit groups includes a plurality of first pixel circuits arranged in a second direction and a plurality of second pixel circuits arranged in the second direction, wherein the plurality of first pixel circuits and the plurality of second pixel circuits are arranged alternately, each pixel circuit includes a first boundary and a second boundary that extend along the second direction and are arranged in the first direction, an arrangement direction of a first boundary and a second boundary of the first pixel circuit is opposite to an arrangement direction of a first boundary and a second boundary of the second pixel circuit; and for each of the plurality of pixel circuit groups, a distance, in the first direction, between the first boundary of the first pixel circuit and the first boundary of the second pixel circuit is greater than a first distance, and a distance, in the first direction, between the second boundary of the first pixel circuit and the second boundary of the second pixel circuit is less than the first distance, the first distance being a distance, in the first direction, between the first boundary and the second boundary of a same pixel circuit; and
a plurality of first signal lines in one-to-one correspondence with the plurality of pixel circuit groups, wherein each of the plurality of first signal lines is connected to a first pixel circuit and a second pixel circuit in a corresponding pixel circuit group;
wherein first pixel circuits and second pixel circuits in two adjacent pixel circuit groups of the plurality of pixel circuit groups enclose a plurality of target regions, wherein orthographic projections of the target regions on the base substrate are not overlapped with orthographic projection of the first pixel circuits on the base substrate and orthographic projection of the second pixel circuits on the base substrate, and transmittance of the target regions is greater than transmittance of the regions where the first pixel circuits and the second pixel circuits are disposed

In still another aspect, a display device is provided. The display device includes: the display panel as described in the above aspect and an optical sensor; wherein an orthographic projection of the optical sensor on the display panel is at least partially overlapped with a first display region of the display panel.

### BRIEF DESCRIPTION OF THE DRAWINGS

To describe the technical solutions in the embodiments of the present disclosure more clearly, the following briefly introduces the accompanying drawings required for describing the embodiments. The accompanying drawings in the following descriptions show merely some embodiments of the present disclosure, and persons of ordinary skill in the art may still derive other drawings from these accompanying drawings without creative effort.
FIG. 1 is a top view of a display panel according to some embodiments of the present disclosure;
FIG. 2 is a partial schematic structural diagram of the display panel shown in FIG. 1 in a first display region;
FIG. 3 is a partial schematic structural diagram of a second signal line and a first connection trace according to some embodiments of the present disclosure;
FIG. 4 is a partial schematic structural diagram of another display panel according to some embodiments of the present disclosure;
FIG. 5 is an equivalent circuit diagram of a pixel circuit in the display panel shown in FIG. 4;
FIG. 6 is a timing diagram of various signal lines in a pixel circuit according to some embodiments of the present disclosure;
FIG. 7 is a sectional view of a display panel according to some embodiments of the present disclosure;
FIG. 8 is a partial schematic diagram of an active layer in a display panel according to some embodiments of the present disclosure;
FIG. 9 is a partial schematic diagram of a first gate layer in a display panel according to some embodiments of the present disclosure;
FIG. 10 is a partial schematic diagram of superposition of an active layer and a first gate layer in a display panel according to some embodiments of the present disclosure;
FIG. 11 is a partial schematic diagram of a second gate layer in a display panel according to some embodiments of the present disclosure;
FIG. 12 is a partial schematic diagram of superposition of an active layer, a first gate layer, and a second gate layer in a display panel according to some embodiments of the present disclosure;
FIG. 13 is a partial schematic diagram of an oxide layer in a display panel according to some embodiments of the present disclosure;
FIG. 14 is a partial schematic diagram of superposition of an active layer, a first gate layer, a second gate layer, and an oxide layer in a display panel according to some embodiments of the present disclosure;
FIG. 15 is a partial schematic diagram of a third gate layer in a display panel according to some embodiments of the present disclosure;
FIG. 16 is a partial schematic diagram of superposition of an active layer, a first gate layer, a second gate layer, an oxide layer, and a third gate layer in a display panel according to some embodiments of the present disclosure;
FIG. 17 is a partial schematic diagram of a first interlayer dielectric layer in a display panel according to some embodiments of the present disclosure;
FIG. 18 is a partial schematic diagram of superposition of an active layer, a first gate layer, a second gate layer, an oxide layer, a third gate layer, and a first interlayer dielectric layer in a display panel according to some embodiments of the present disclosure;
FIG. 19 is a partial schematic diagram of a second interlayer dielectric layer in a display panel according to some embodiments of the present disclosure;
FIG. 20 is a partial schematic diagram of superposition of an active layer, a first gate layer, a second gate layer, an oxide layer, a third gate layer, a first interlayer dielectric layer, and a second interlayer dielectric layer in a display panel according to some embodiments of the present disclosure;
FIG. 21 is a partial schematic diagram of a first source-drain layer in a display panel according to some embodiments of the present disclosure;
FIG. 22 is a partial schematic diagram of superposition of an active layer, a first gate layer, a second gate layer, an oxide layer, a third gate layer, a first interlayer dielectric layer, a second interlayer dielectric layer, and a first source-drain layer in a display panel according to some embodiments of the present disclosure;
FIG. 23 is a partial schematic diagram of a passivation layer in a display panel according to some embodiments of the present disclosure;
FIG. 24 is a partial schematic diagram of superposition of an active layer, a first gate layer, a second gate layer, an oxide layer, a third gate layer, a first interlayer dielectric layer, a second interlayer dielectric layer, a first source-drain layer, and a passivation layer in a display panel according to some embodiments of the present disclosure;
FIG. 25 is a partial schematic diagram of a first trace layer in a display panel according to some embodiments of the present disclosure;
FIG. 26 is a partial schematic diagram of superposition of an active layer, a first gate layer, a second gate layer, an oxide layer, a third gate layer, a first interlayer dielectric layer, a second interlayer dielectric layer, a first source-drain layer, a passivation layer, and a trace layer in a display panel according to some embodiments of the present disclosure;
FIG. 27 is a partial schematic diagram of a first planarization layer in a display panel according to some embodiments of the present disclosure;
FIG. 28 is a partial schematic diagram of superposition of an active layer, a first gate layer, a second gate layer, an oxide layer, a third gate layer, a first interlayer dielectric layer, a second interlayer dielectric layer, a first source-drain layer, a passivation layer, a first trace layer, and a first planarization layer in a display panel according to some embodiments of the present disclosure;
FIG. 29 is a partial schematic diagram of a second trace layer in a display panel according to some embodiments of the present disclosure;
FIG. 30 is a partial schematic diagram of superposition of an active layer, a first gate layer, a second gate layer, an oxide layer, a third gate layer, a first interlayer dielectric layer, a second interlayer dielectric layer, a first source-drain layer, a passivation layer, a first trace layer, a first planarization layer, and a second trace layer in a display panel according to some embodiments of the present disclosure;
FIG. 31 is a partial schematic diagram of a second planarization layer in a display panel according to some embodiments of the present disclosure;
FIG. 32 is a partial schematic diagram of superposition of an active layer, a first gate layer, a second gate layer, an oxide layer, a third gate layer, a first interlayer dielectric layer, a second interlayer dielectric layer, a first source-drain layer, a passivation layer, a first trace layer, a first planarization layer, a second trace layer, and a second planarization layer in a display panel according to some embodiments of the present disclosure;
FIG. 33 is a partial schematic diagram of a second source-drain layer in a display panel according to some embodiments of the present disclosure;
FIG. 34 is a partial schematic diagram of superposition of an active layer, a first gate layer, a second gate layer, an oxide layer, a third gate layer, a first interlayer dielectric layer, a second interlayer dielectric layer, a first source-drain layer, a passivation layer, a first trace layer, a first planarization layer, a second trace layer, a second planarization layer, and a second source-drain layer in a display panel according to some embodiments of the present disclosure;
FIG. 35 is a partial schematic diagram of a third planarization layer in a display panel according to some embodiments of the present disclosure;
FIG. 36 is a partial schematic diagram of superposition of an active layer, a first gate layer, a second gate layer, an oxide layer, a third gate layer, a first interlayer dielectric layer, a second interlayer dielectric layer, a first source-drain layer, a passivation layer, a first trace layer, a first planarization layer, a second trace layer, a second planarization layer, a first source-drain layer, and a third planarization layer in a display panel according to some embodiments of the present disclosure;
FIG. 37 is a partial schematic diagram of an anode layer in a display panel according to some embodiments of the present disclosure;
FIG. 38 is a partial schematic diagram of superposition of an active layer, a first gate layer, a second gate layer, an oxide layer, a third gate layer, a first interlayer dielectric layer, a second interlayer dielectric layer, a first source-drain layer, a passivation layer, a first trace layer, a first planarization layer, a second trace layer, a second planarization layer, a second source-drain layer, a third planarization layer, and an anode layer in a display panel according to some embodiments of the present disclosure;
FIG. 39 is a partial schematic structural diagram of yet another display panel according to some embodiments of the present disclosure;
FIG. 40 is a partial schematic structural diagram of yet another display panel according to some embodiments of the present disclosure;
FIG. 41 is an equivalent circuit diagram of a pixel circuit in the display panel shown in FIG. 39 or FIG. 40;
FIG. 42 is a timing diagram of signal lines in another pixel circuit according to some embodiments of the present disclosure;
FIG. 43 is a partial schematic diagram of an active layer in another display panel according to some embodiments of the present disclosure;
FIG. 44 is a partial schematic diagram of a first gate layer in another display panel according to some embodiments of the present disclosure;
FIG. 45 is a partial schematic diagram of superposition of an active layer and a first gate layer in another display panel according to some embodiments of the present disclosure;
FIG. 46 is a partial schematic diagram of a second gate layer in another display panel according to some embodiments of the present disclosure;
FIG. 47 is a partial schematic diagram of superposition of an active layer, a first gate layer, and a second gate layer in another display panel according to some embodiments of the present disclosure;
FIG. 48 is a partial schematic diagram of an oxide layer in another display panel according to some embodiments of the present disclosure;
FIG. 49 is a partial schematic diagram of superposition of an active layer, a first gate layer, a second gate layer, and an oxide layer in another display panel according to some embodiments of the present disclosure;
FIG. 50 is a partial schematic diagram of a third gate layer in another display panel according to some embodiments of the present disclosure;
FIG. 51 is a partial schematic diagram of superposition of an active layer, a first gate layer, a second gate layer, an oxide layer, and a third gate layer in another display panel according to some embodiments of the present disclosure;
FIG. 52 is a partial schematic diagram of a first interlayer dielectric layer in another display panel according to some embodiments of the present disclosure;
FIG. 53 is a partial schematic diagram of superposition of an active layer, a first gate layer, a second gate layer, an oxide layer, a third gate layer, and a first interlayer dielectric layer in another display panel according to some embodiments of the present disclosure;
FIG. 54 is a partial schematic diagram of a second interlayer dielectric layer in another display panel according to some embodiments of the present disclosure;
FIG. 55 is a partial schematic diagram of superposition of an active layer, a first gate layer, a second gate layer, an oxide layer, a third gate layer, a first interlayer dielectric layer, and a second interlayer dielectric layer in another display panel according to some embodiments of the present disclosure;
FIG. 56 is a partial schematic diagram of a first source-drain layer in another display panel according to some embodiments of the present disclosure;
FIG. 57 is a partial schematic diagram of superposition of an active layer, a first gate layer, a second gate layer, an oxide layer, a third gate layer, a first interlayer dielectric layer, a second interlayer dielectric layer, and a first source-drain layer in another display panel according to some embodiments of the present disclosure;
FIG. 58 is a partial schematic diagram of a passivation layer in another display panel according to some embodiments of the present disclosure;
FIG. 59 is a partial schematic diagram of superposition of an active layer, a first gate layer, a second gate layer, an oxide layer, a third gate layer, a first interlayer dielectric layer, a second interlayer dielectric layer, a first source-drain layer, and a passivation layer in another display panel according to some embodiments of the present disclosure;
FIG. 60 is a partial schematic diagram of a first trace layer in another display panel according to some embodiments of the present disclosure;
FIG. 61 is a partial schematic diagram of superposition of an active layer, a first gate layer, a second gate layer, an oxide layer, a third gate layer, a first interlayer dielectric layer, a second interlayer dielectric layer, a first source-drain layer, a passivation layer, and a first trace layer in another display panel according to some embodiments of the present disclosure;
FIG. 62 is a partial schematic diagram of a first planarization layer in another display panel according to some embodiments of the present disclosure;
FIG. 63 is a partial schematic diagram of superposition of an active layer, a first gate layer, a second gate layer, an oxide layer, a third gate layer, a first interlayer dielectric layer, a second interlayer dielectric layer, a first source-drain layer, a passivation layer, a first trace layer, and a first planarization layer in another display panel according to some embodiments of the present disclosure;
FIG. 64 is a partial schematic diagram of a second trace layer in another display panel according to some embodiments of the present disclosure;
FIG. 65 is a partial schematic diagram of superposition of an active layer, a first gate layer, a second gate layer, an oxide layer, a third gate layer, a first interlayer dielectric layer, a second interlayer dielectric layer, a first source-drain layer, a passivation layer, a first trace layer, a first planarization layer, and a second trace layer in another display panel according to some embodiments of the present disclosure;
FIG. 66 is a partial schematic diagram of a second planarization layer in another display panel according to some embodiments of the present disclosure;
FIG. 67 is a partial schematic diagram of superposition of an active layer, a first gate layer, a second gate layer, an oxide layer, a third gate layer, a first interlayer dielectric layer, a second interlayer dielectric layer, a first source-drain layer, a passivation layer, a first trace layer, a first planarization layer, a second trace layer, and a second planarization layer in another display panel according to some embodiments of the present disclosure;
FIG. 68 is a partial schematic diagram of a second source-drain layer in another display panel according to some embodiments of the present disclosure;
FIG. 69 is a partial schematic diagram of superposition of an active layer, a first gate layer, a second gate layer, an oxide layer, a third gate layer, a first interlayer dielectric layer, a second interlayer dielectric layer, a first source-drain layer, a passivation layer, a first trace layer, a first planarization layer, a second trace layer, a second planarization layer, and a second source-drain layer in another display panel according to some embodiments of the present disclosure;
FIG. 70 is a partial schematic diagram of a third planarization layer in another display panel according to some embodiments of the present disclosure;
FIG. 71 is a partial schematic diagram of superposition of an active layer, a first gate layer, a second gate layer, an oxide layer, a third gate layer, a first interlayer dielectric layer, a second interlayer dielectric layer, a first source-drain layer, a passivation layer, a first trace layer, a first planarization layer, a second trace layer, a second planarization layer, a first source-drain layer, and a third planarization layer in another display panel according to some embodiments of the present disclosure;
FIG. 72 is a partial schematic diagram of an anode layer in another display panel according to some embodiments of the present disclosure;
FIG. 73 is a partial schematic diagram of superposition of an active layer, a first gate layer, a second gate layer, an oxide layer, a third gate layer, a first interlayer dielectric layer, a second interlayer dielectric layer, a first source-drain layer, a passivation layer, a first trace layer, a first planarization layer, a second trace layer, a second planarization layer, a second source-drain layer, a third planarization layer, and an anode layer in another display panel according to some embodiments of the present disclosure;
FIG. 74 is a partial schematic structural diagram of yet another display panel according to some embodiments of the present disclosure;
FIG. 75 is a partial sectional view of a first sub-signal line according to some embodiments of the present disclosure;
FIG. 76 is a partial schematic diagram of a first gate layer in yet another display panel according to some embodiments of the present disclosure;
FIG. 77 is a partial schematic diagram of superposition of an active layer and a first gate layer in yet another display panel according to some embodiments of the present disclosure;
FIG. 78 is a partial schematic diagram of a second gate layer in yet another display panel according to some embodiments of the present disclosure;
FIG. 79 is a partial schematic diagram of superposition of an active layer, a first gate layer, and a second gate layer in yet another display panel according to some embodiments of the present disclosure;
FIG. 80 is a partial schematic diagram of an oxide layer in yet another display panel according to some embodiments of the present disclosure;
FIG. 81 is a partial schematic diagram of superposition of an active layer, a first gate layer, a second gate layer, and an oxide layer in yet another display panel according to some embodiments of the present disclosure;
FIG. 82 is a partial schematic diagram of a third gate layer in yet another display panel according to some embodiments of the present disclosure;
FIG. 83 is a partial schematic diagram of superposition of an active layer, a first gate layer, a second gate layer, an oxide layer, and a third gate layer in yet another display panel according to some embodiments of the present disclosure;
FIG. 84 is a partial schematic diagram of a first source-drain layer in yet another display panel according to some embodiments of the present disclosure;
FIG. 85 is a partial schematic diagram of superposition of an active layer, a first gate layer, a second gate layer, an oxide layer, a third gate layer, a first interlayer dielectric layer, a second interlayer dielectric layer, and a first source-drain layer in yet another display panel according to some embodiments of the present disclosure;
FIG. 86 is a partial schematic diagram of a first trace layer in yet another display panel according to some embodiments of the present disclosure;
FIG. 87 is a partial schematic diagram of superposition of an active layer, a first gate layer, a second gate layer, an oxide layer, a third gate layer, a first interlayer dielectric layer, a second interlayer dielectric layer, a first source-drain layer, and a first trace layer in yet another display panel according to some embodiments of the present disclosure;
FIG. 88 is a partial schematic structural diagram of a second trace layer according to some embodiments of the present disclosure;
FIG. 89 is a partial schematic diagram of superposition of an active layer, a first gate layer, a second gate layer, an oxide layer, a third gate layer, a first interlayer dielectric layer, a second interlayer dielectric layer, a first source-drain layer, a first trace layer, a first planarization layer, and a second trace layer in yet another display panel according to some embodiments of the present disclosure;
FIG. 90 is a partial schematic diagram of superposition of an active layer, a first gate layer, a second gate layer, an oxide layer, a third gate layer, a first interlayer dielectric layer, a second interlayer dielectric layer, a first source-drain layer, a first trace layer, a first planarization layer, a second trace layer, and a second planarization layer in yet another display panel according to some embodiments of the present disclosure;
FIG. 91 is a partial schematic diagram of superposition of an active layer, a first gate layer, a second gate layer, an oxide layer, a third gate layer, a first interlayer dielectric layer, a second interlayer dielectric layer, a first source-drain layer, a first trace layer, a first planarization layer, a second trace layer, a second planarization layer, and a second source-drain layer in yet another display panel according to some embodiments of the present disclosure;
FIG. 92 is a partial schematic diagram of superposition of an active layer, a first gate layer, a second gate layer, an oxide layer, a third gate layer, a first interlayer dielectric layer, a second interlayer dielectric layer, a first source-drain layer, a first trace layer, a first planarization layer, a second trace layer, a second planarization layer, a second source-drain layer, and a third planarization layer in yet another display panel according to some embodiments of the present disclosure;
FIG. 93 is a partial schematic diagram of superposition of an active layer, a first gate layer, a second gate layer, an oxide layer, a third gate layer, a first interlayer dielectric layer, a second interlayer dielectric layer, a first source-drain layer, a first trace layer, a first planarization layer, a second trace layer, a second planarization layer, a second source-drain layer, a third planarization layer, and an anode layer in yet another display panel according to some embodiments of the present disclosure;
FIG. 94 is a partial schematic structural diagram of still another display panel according to some embodiments of the present disclosure; and
FIG. 95 is a schematic structural diagram of a display device according to some embodiments of the present disclosure.

### DETAILED DESCRIPTION

For clearer descriptions of the objectives, technical solutions, and advantages of the present disclosure, embodiments of the present disclosure are described in detail hereinafter with reference to the accompanying drawings.

In the related art, in order to increase the screen-to-body ratio of a display panel, a camera of a display device is provided in a display region of the display panel. In order to increase the transmittance of the region where the camera is disposed (i.e., the camera region), one or more trace layers are usually added, and a plurality of signal connection lines are provided in the trace layer to connect the pixel circuits of one row or column of pixel units in the camera region, such that the driving circuit disposed in a peripheral region of the display panel can provide driving signals to the pixel circuits of the row or column of pixel units to drive a light-emitting device to emit light.

However, the requirement for pixels per inch (PPI) of the display panel is high, and the space between adjacent pixel circuits is relatively small, making signal communication between pixel circuits difficult.

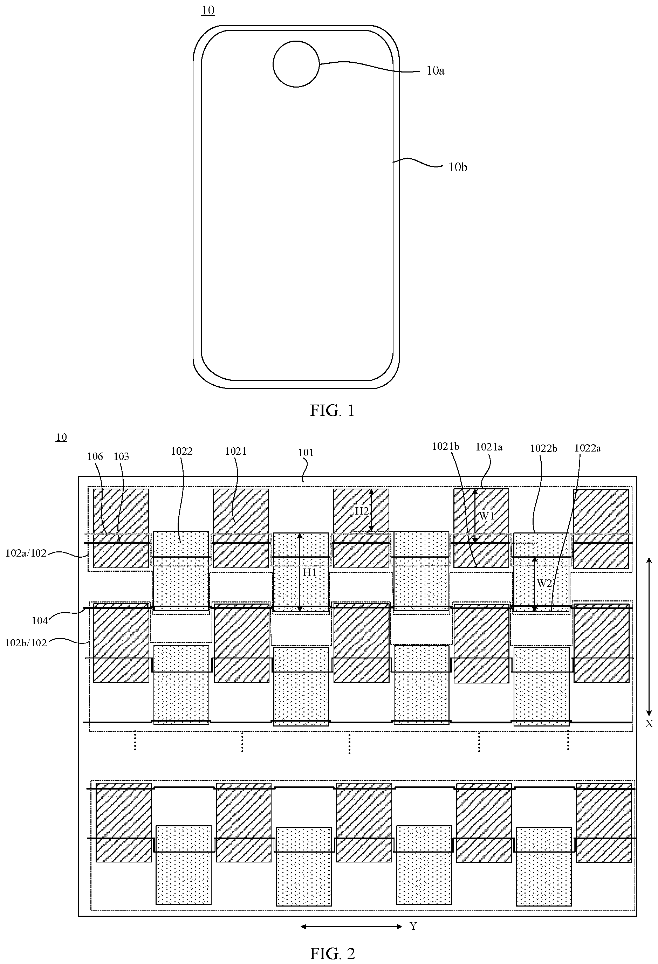

FIG. 1 is a top view of a display panel according to some embodiments of the present disclosure. Referring to FIG. 1, the base substrate 101 of the display panel 10 is provided with a first display region 10a. The first display region 10a is configured to be provided with an optical sensor. Optionally, the optical sensor is a front camera, and the first display region 10a is referred to as a full display with camera (FDC) region.

FIG. 2 is a partial schematic structural diagram of the display panel shown in FIG. 1. Referring to FIG. 2, the display panel 10 includes a base substrate 101, a plurality of pixel circuit groups 102, and a plurality of first signal lines 103 in one-to-one correspondence with the plurality of pixel circuit groups 102.

In the embodiments of the present disclosure, the plurality of pixel circuit groups 102 are disposed in the first display region 10a and are arranged along a first direction X. At least one pixel circuit group 102 includes a plurality of first pixel circuits 1021 arranged along a second direction Y and a plurality of second pixel circuits 1022 arranged along the second direction Y The first direction X is perpendicular to the second direction Y. For example, the first direction X is a pixel column direction, and the second direction Y is a pixel row direction.

The plurality of first pixel circuits 1021 and the plurality of second pixel circuits 1022 in each pixel circuit group 102 are alternately arranged, and each of the plurality of first pixel circuits 1021 and the plurality of second pixel circuits 1022 includes a first boundary and a second boundary that extend along the second direction Y and are arranged in the first direction X. The arrangement direction of a first boundary 1021a and a second boundary 1021b of the first pixel circuit 1021 is opposite to the arrangement direction of a first boundary 1022a and a second boundary 1022b of the second pixel circuit 1022.

Additionally, for each pixel circuit group 102, the distance, in the first direction X, between the first boundary 1021a of the first pixel circuit 1021 and the first boundary 1022a of the second pixel circuit 1022 is greater than a first distance H1, and the distance, in the first direction X, between the second boundary 1021b of the first pixel circuit 1021 and the second boundary 1022b of the second pixel circuit 1022 is less than the first distance H1. The first distance H1 is the distance, in the first direction X, between the first boundary and the second boundary of the same pixel circuit. For example, the first distance H1 is the distance, in the first direction X, between the first boundary and the second boundary of the first pixel circuit 1021 or the second pixel circuit 1022. The distance, in the first direction X, between the first boundary 1021a and the second boundary 1021b of the first pixel circuit 1021 is equal to the distance, in the first direction X, between the first boundary 1022a and the second boundary 1022b of the second pixel circuit 1022.

The first boundary 1021a of the first pixel circuit 1021 corresponds to the first boundary 1022a of the second pixel circuit 1022, and the second boundary 1021b of the first pixel circuit 1021 corresponds to the second boundary 1022b of the second pixel circuit 1022. Two boundaries corresponding to each other means that the pixel circuits at the locations of the two boundaries are of the same structure, and the plurality of first pixel circuits 1021 and the plurality of second pixel circuits 1022 are designed in opposite directions. Assuming that the design direction of the first pixel circuits 1021 is a forward direction, then the design direction of the second pixel circuits 1022 is a reverse direction. Alternatively, assuming that the design direction of the first pixel circuits 1021 is a reverse direction, then the design direction of the second pixel circuits 1022 is a forward direction.

In the embodiments of the present disclosure, the first boundary or the second boundary of the pixel circuit 1021 is used to describe and show the strict boundary division of the pixel circuit 1021, and the boundary of the pixel circuit 1021 is not exactly the rectangle shown in FIG. 1. In the embodiments of the present disclosure, the boundary of the pixel circuit 1021 is a boundary that forms the smallest region of a plurality of patterns of the pixel circuit 1021. The smallest region is the smallest circumscribed pattern of the pixel circuit. Therefore, the first boundary and the second boundary of the pixel circuit 1021 are respectively two boundaries that are farthest in the first direction X.

Therefore, with the above arrangement of the first pixel circuits 1021 and the second pixel circuits 1022, there is a certain offset, in the first direction X, between the plurality of first pixel circuits 1021 and the plurality of second pixel circuits 1022. With the offset, the second boundaries 1021b of the plurality of first pixel circuits 1021 and the second boundaries 1022b of the plurality of second pixel circuits 1022 are all disposed between the extension line of the first boundary 1021a of the first pixel circuit 1021 and the extension line of the first boundary 1022a of the second pixel circuit 1022.

In the embodiments of the present disclosure, each first signal line 103 is of an integral structure and is connected to each of the plurality of first pixel circuits 1021 and the plurality of second pixel circuits 1022 in the corresponding pixel circuit group 102. In this way, each first signal line 103 provides signals for all pixel circuits disposed in the first display region 10a in the corresponding pixel circuit group 102. The first signal line 103 being of an integral structure refers to that the portion of the first signal line 103 in the first display region 10a is disposed in only one film layer of the display panel 10, without the need to cross layers.

Optionally, as the plurality of first pixel circuits 1021 and the plurality of second pixel circuits 1022 are offset in the first direction X and are designed in opposite directions, there is a certain offset between the connection positions of the first signal line 103 and the plurality of first pixel circuits 1021 and the connection positions of the first signal line 103 and the plurality of second pixel circuits 1022 in the first direction X. For example, each first signal line 103 is connected to each first pixel circuit 1021 in the corresponding pixel circuit group 102 at a first connection (i.e., the connection position of the first signal line 103 and the first pixel circuit 1021 is referred to as the first connection), and the first signal line 103 is connected to each second pixel circuit 1022 in the corresponding pixel circuit group 102 at a second connection (i.e., the connection position of the first signal line 103 and the second pixel circuit 1022 is referred to as the second connection).

The position of the first connection in the first pixel circuit 1021 corresponds to the position of the second connection in the second pixel circuit 1022. That is, the distance w1 between the first connection and the first boundary of the first pixel circuit 1021 is equal to the distance w1 between the second connection and the first boundary of the second pixel circuit 1022.

In the embodiments of the present disclosure, by designing the plurality of first pixel circuits 1021 and the plurality of second pixel circuits 1022 in different directions to have a certain offset in the first direction X and to be alternately arranged, the distance between the first connection and the second connection in the first direction X is smaller, for example, in the second direction Y, the first connection and the second connection are in the same horizontal line or near the same horizontal line.

The distance, in the first direction X, between the first connection and the second connection is less than a second distance H2. The second distance H2 is the distance, in the first direction X, between the first boundary 1021a of the first pixel circuit 1021 and the second boundary 1022b of the second pixel circuit 1022 (i.e., the offset distance between the first pixel circuit 1021 and the second pixel circuit 1022 in the first direction X). In this way, the first signal line 103 can be directly connected to the pixel circuits (the plurality of first pixel circuits 1021 and the plurality of second pixel circuits 1022) in the pixel circuit group 102, without the need to design connection holes between adjacent pixel circuits and implement the connection by a trace layer. Furthermore, the number of connection holes to be designed in the layout can be reduced, and there is sufficient space to design a smaller number of connection holes for signal transmission even if the requirement on the PPI of the display panel is high.

In summary, the embodiments of the present disclosure provide a display panel. The plurality of first pixel circuits and the plurality of second pixel circuits in each pixel circuit group in the display panel are alternately arranged, the plurality of first pixel circuits and the plurality of second pixel circuits in each pixel circuit group are designed in opposite directions, and the plurality of first pixel circuits and the plurality of second pixel circuits are offset in the first direction. In this way, the distance between the first connection of the first pixel circuit and the second connection of the second pixel circuit in the first direction is smaller. Furthermore, the first signal line is directly connected to the first connection and the second connection, without the need to design connection holes between adjacent pixel circuits and implement the connection by a trace layer. According to the solution of the embodiments of the present disclosure, the number of connection holes to be designed in the layout can be reduced, and there is sufficient space to design a smaller number of connection holes for signal transmission even if the requirement on the PPI of the display panel is high.

Optionally, the first signal line 103 is a light-emitting control signal line EM.

Referring to FIG. 1, it can be seen that the plurality of pixel circuit groups 102 at least include a first pixel circuit group 102a and a second pixel circuit group 102b arranged in the first direction X. The distance, in the first direction X, between the first boundary 1022a of the second pixel circuit 1022 in the first pixel circuit group 102a and the first boundary 1021a of the first pixel circuit 1021 in the second pixel circuit group 102b is less than the second distance H2. That is, the second pixel circuit 1022 in the first pixel circuit group 102a and the first pixel circuit 1021 in the second pixel circuit 1022 are closer in the first direction X.

The display panel 10 further includes a plurality of second signal lines 104 disposed in the first display region 10a. Each second signal line 104 is connected to the second pixel circuits 1022 in the first pixel circuit group 102a and the first pixel circuits 1021 in the second pixel circuit group 102b. In this way, the second signal line 104 provides signals for the second pixel circuits 1022 in the first pixel circuit group 102a and the first pixel circuits 1021 in the second pixel circuit group 102b at the same time. Optionally, this second signal line 104 is a first reset power line vinit1.

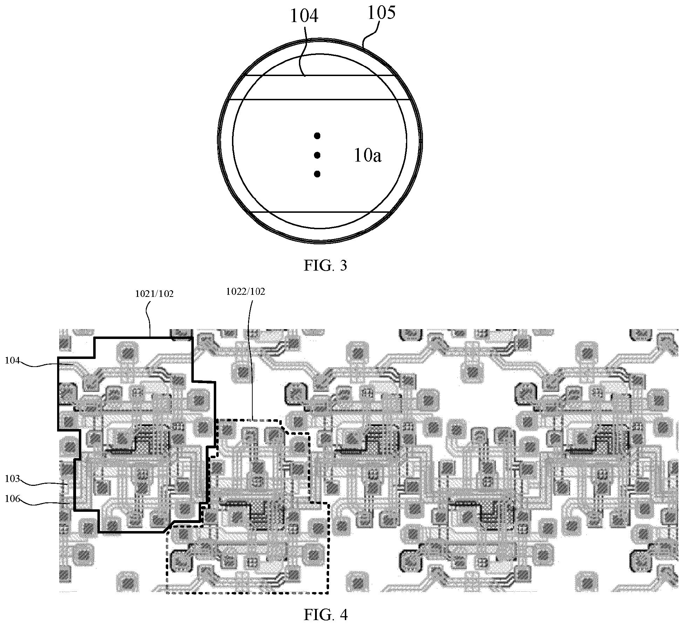

Referring to FIG. 1, the base substrate 101 of the display panel 10 is further provided with a second display region 10b, and the second display region 10b at least partially surrounds the first display region 10a. FIG. 3 is a partial schematic structural diagram of another display panel according to some embodiments of the present disclosure. Referring to FIG. 3, the display panel 10 further includes a first connection trace 105 disposed in the second display region 10b. The first connection trace 105 at least partially surrounds the first display region 10a. For example, the first display region 10a is a rectangle, the first connection trace 105 is a rectangular looped trace, which surrounds the first display region 10a. The second signal line is simply illustrated as a straight line in FIG. 3, and in fact, the second signal line is not a straight line.

At least one end of each of the plurality of second signal lines 104 is connected to the first connection trace 105. For example, in FIG. 3, both ends of each second signal line 104 are connected to the first connection trace. Each second signal line 104 transmits a signal received from the first connection trace 105 to a pixel circuit connected to the second signal line 104. As each second signal line 104 of the plurality of second signal lines 104 is connected to the first connection trace 105, the signals transmitted by the plurality of second signal lines 104 to which the first connection trace 105 is connected are the same. The same signals mean that the signals have the same type and potential.

Referring to FIG. 1, the display panel 10 further includes a plurality of third signal lines 106 in one-to-one correspondence with the plurality of pixel circuit groups 102. Each third signal line 106 is connected to the plurality of first pixel circuits 1021 and the plurality of second pixel circuits 1022 in the corresponding pixel circuit group 102, such that each third signal line 106 provides signals for the first pixel circuits 1021 and the second pixel circuits 1022 in the corresponding pixel circuit group 102.

The third signal line 106 may be or may not be of an integral structure. The third signal line 106 being of an integral structure means that the portion of the third signal line 106 in the first display region 10a is disposed in only one film layer of the display panel, without the need to cross layers. The third signal line 106 being not of an integral structure means that the portion of the third signal line 106 in the first display region 10a requires a cross-layer design, and the film layer in which the third signal line 106 is disposed is a metal layer.

Each third signal line 106 is connected to the first pixel circuits 1021 and the second pixel circuits 1022 in the corresponding pixel circuit group 102. In addition, the signal transmitted by the third signal line 106 is different from the signal transmitted by the first signal line 103. Different signals mean that the signals at least have different types. For example, the first signal line 103 is a light-emitting control signal line EM, and the signal transmitted is a light-emitting control EM signal, while the signal transmitted by the third signal line 106 is not an EM signal.

In a first optional implementation, each of the plurality of first pixel circuits 1021 and the plurality of second pixel circuits 1022 in each pixel circuit group 102 includes eight transistors and one storage capacitor Cst (i.e., 8T1C), such as shown in FIG. 4. For a clear illustration of the pixel circuit, FIG. 4 only shows up to the first source-drain layer, but does not show the film layers on the side of the first source-drain layer away from the base substrate 101.

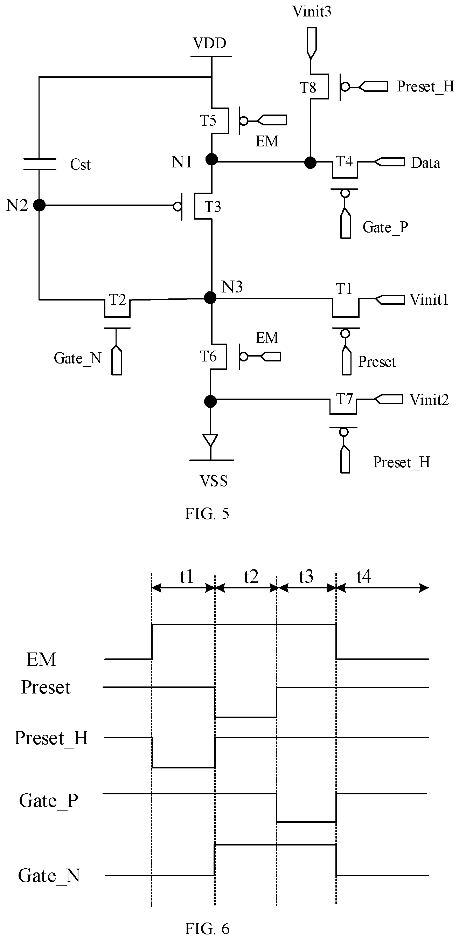

FIG. 5 is an equivalent circuit diagram of a pixel circuit in the display panel shown in FIG. 4. Referring to FIG. 5, the pixel circuit includes a first transistor T1, a second transistor T2, a third transistor T3, a fourth transistor T4, a fifth transistor T5, a sixth transistor T6, a seventh transistor T7, an eighth transistor T8, and a storage capacitor Cst.

A gate of the first transistor T1 is connected to a first reset signal line Preset in the display panel, a first electrode of the first transistor T1 is connected to a first reset power line vinit1, and a second electrode of the first transistor T1 is connected to a third node N3. The first transistor T1 is also referred to as a reset transistor.

A gate of the second transistor T2 is connected to a first gate signal line Gate_N in the display panel, a first electrode of the second transistor T2 is connected to the third node N3, and a second electrode of the second transistor T2 is connected to a second node N2. The second transistor T2 is also referred to as a compensation transistor.

A gate of the third transistor T3 is connected to the second node N2, a first electrode of the third transistor T3 is connected to a first node N1, and a second electrode of the third transistor T3 is connected to the third node N3. This third transistor T3 is also referred to as a driving transistor.

A gate of the fourth transistor T4 is connected to a second gate signal line Gate_P in the display panel, a first electrode of the fourth transistor T4 is connected to a data signal line Data in the display panel, and a second electrode of the fourth transistor T4 is connected to the first node N1. The fourth transistor T4 is a data-writing transistor in the pixel circuit.

A gate of the fifth transistor T5 is connected to the light-emitting control signal line EM, a first electrode of the fifth transistor T5 is connected to a driving power line VDD, and a second electrode of the fifth transistor T5 is connected to the first node N1. As the gate of the fifth transistor T5 is connected to the light-emitting control signal line EM, the fifth transistor T5 is also referred to as a light-emitting control transistor.

A gate of the sixth transistor T6 is connected to the light-emitting control signal line EM, a first electrode of the sixth transistor T6 is connected to the third node N3, and a second electrode of the sixth transistor T6 is connected to a light-emitting unit. As the gate of the sixth transistor T6 is connected to the light-emitting control signal line EM, the sixth transistor T6 is also referred to as a light-emitting control transistor.

A gate of the seventh transistor T7 is connected to a second reset signal line Preset_H in the display panel, a first electrode of the seventh transistor T7 is connected to a second reset power line vinit2, and a second electrode of the seventh transistor T7 is connected to the light-emitting unit. The seventh transistor T7 is a reset transistor in the pixel circuit.

A gate of the eighth transistor T8 is connected to the second reset signal line Preset_H, a first electrode of the eighth transistor T8 is connected to a third reset power line vinit3 in the display panel, and a second electrode of the eighth transistor T8 is connected to the first node N1. The eighth transistor T8 is a reset transistor in the pixel circuit.

One terminal of the storage capacitor Cst is connected to the driving power line VDD, and the other terminal of the storage capacitor Cst is connected to the second node N2.

Optionally, the storage capacitor Cst includes two capacitance plates Cst1 and Cst2. In the embodiments of the present disclosure, the capacitance plate Cst1 is referred to as one terminal, a first terminal, or a first storage capacitance electrode of the storage capacitor Cst, and the capacitance plate Cst2 is referred to as the other terminal, a second terminal, or a second storage capacitance electrode of the storage capacitor Cst.

In the embodiments of the present disclosure, the third signal line 106 is a third reset power line vinit3. That is, in the case that the pixel circuit includes eight transistors and one storage capacitor Cst, the above third signal line 106 is the third reset power line vinit3, and the third reset power line vinit3 provides third reset power signals for the plurality of first pixel circuits 1021 and the plurality of second pixel circuits 1022 in one pixel circuit group 102.

Optionally, the second transistor T2 is an N-type transistor. The first transistor T1, the third transistor T3, the fourth transistor T4, the fifth transistor T5, the sixth transistor T6, the seventh transistor T7, and the eighth transistor T8 are all P-type transistors.

Optionally, in the embodiments of the present disclosure, each N-type transistor is an oxide thin film transistor, and each P-type transistor is a low temperature poly-silicon (LTPS) thin film transistor. The oxide material includes indium gallium zinc oxide (IGZO), i.e., the oxide thin film transistor is an IGZO thin film transistor. The pixel circuit consisting of the eight transistors is also referred to as an LTPO pixel circuit. A display panel having the LTPO pixel circuit is also referred to as an LTPO display panel.

Taking the pixel circuit shown in FIG. 5 in which a first potential is a high potential relative to the second potential as an example, the driving principle of the pixel circuit in the embodiments of the present disclosure is described as follows. FIG. 6 is a timing diagram of various signal lines in a pixel circuit according to some embodiments of the present disclosure. As shown in FIG. 6:

In an initialization stage t1, the potential of a first reset signal provided by the first reset signal line Preset, the potential of a second gate driving signal provided by the second gate signal line Gate_P, and the potential of a light-emitting control signal provided by the light-emitting control signal line EM are the first potential; and the potential of a first gate driving signal provided by the first gate signal line Gate_N and the potential of a second reset signal provided by the second reset signal line Preset_H are the second potential. Accordingly, the seventh transistor T7 and the eighth transistor T8 are turned on. The first transistor T1, the second transistor T2, the third transistor T3, the fourth transistor T4, the fifth transistor T5, and the sixth transistor T6 are turned off. In this way, the second reset power signal at the second potential provided by the second reset power line vinit2 can be transmitted to an anode of the light-emitting unit through the turned-on seventh transistor T7, and the third reset power signal at the second potential provided by the third reset power line vinit3 can be transmitted to the first node N1 through the turned-on eighth transistor T8, thereby resetting the anode of the light-emitting unit and the first node N1.

In a compensation stage t2, the potential of the first reset signal provided by the first reset signal line Preset jumps to the second potential, the potential of the first gate driving signal provided by the first gate signal line Gate_N jumps to the first potential, and the potential of the light-emitting control signal provided by the light-emitting control signal line EM maintains at the first potential. Accordingly, the first transistor T1 and the second transistor T2 are turned on, and the fourth transistor T4, the fifth transistor T5, the sixth transistor T6, the seventh transistor T7, and the eighth transistor T8 are turned off. In this way, the data signal at the first potential can be transmitted to the first node N1 through the turned-on fourth transistor T4, and then transmitted to the third node N3 through the turned-on third transistor T3, and the second transistor T2 adjusts the potential of the second node N2 based on the potential of the third node N3. In addition, the reset power signal at the second potential provided by the first reset power line vinit1 can be transmitted to the second node N2 through the turned-on first transistor T1 and second transistor T2, thereby resetting the second node N2.

In a writing stage t3, the potential of the first reset signal provided by the first reset signal line Preset jumps to the second potential, the second reset signal provided by the second reset signal line Prese_H maintains at the second potential, the potential of the second gate driving signal provided by the second gate signal line Gate_P jumps to the first potential, the first gate signal line Gate_N maintains at the second potential, and the potential of the light-emitting control signal provided by the light-emitting control signal line EM maintains at the first potential. Under the bootstrap effect of the storage capacitor Cst, the potential of the second node N2 maintains at the second potential. Accordingly, the second transistor T2, the third transistor T3, and the fourth transistor T4 are turned on, and the first transistor T1, the fifth transistor T5, the sixth transistor T6, the seventh transistor T7, and the eighth transistor T8 are turned off. In this way, the data signal provided by the data signal line Data can be transmitted to the second node N2 through the turned-on fourth transistor T4, third transistor T3, and second transistor T2 in sequence.

In a light-emitting stage t4, the potential of the first reset signal provided by the first reset signal line Preset maintains at the second potential, the second reset signal provided by the second reset signal line Prese_H maintains at the second potential, the potential of the second gate driving signal provided by the second gate signal line Gate_P jumps to the first potential, the first gate signal line Gate_N jumps to the first potential, and the potential of the light-emitting signal provided by the light-emitting control signal line EM jumps to the first potential. Under the bootstrap effect of the storage capacitor Cst, the potential of the second node N2 maintains at the second potential of the data signal line Data. Accordingly, the third transistor T3, the fifth transistor T5, and the sixth transistor T6 are turned on, and the first transistor T1, the second transistor T2, the fourth transistor T4, the seventh transistor T7, and the eighth transistor T8 are turned off. In this way, the driving power signal provided by the driving power line VDD can be transmitted to the first node N1 through the turned-on fifth transistor T5, and the third transistor T3 can transmit a driving current to the third node N3 based on the potential of the second node N2 and the potential transmitted to the first node N1. Then, the driving current can be transmitted again to the anode of the light-emitting unit through the turned-on sixth transistor T6, a voltage difference is generated between the anode of the light-emitting unit and a cathode layer, and the light-emitting unit emits light. The cathode layer is connected to the driving power line VSS.

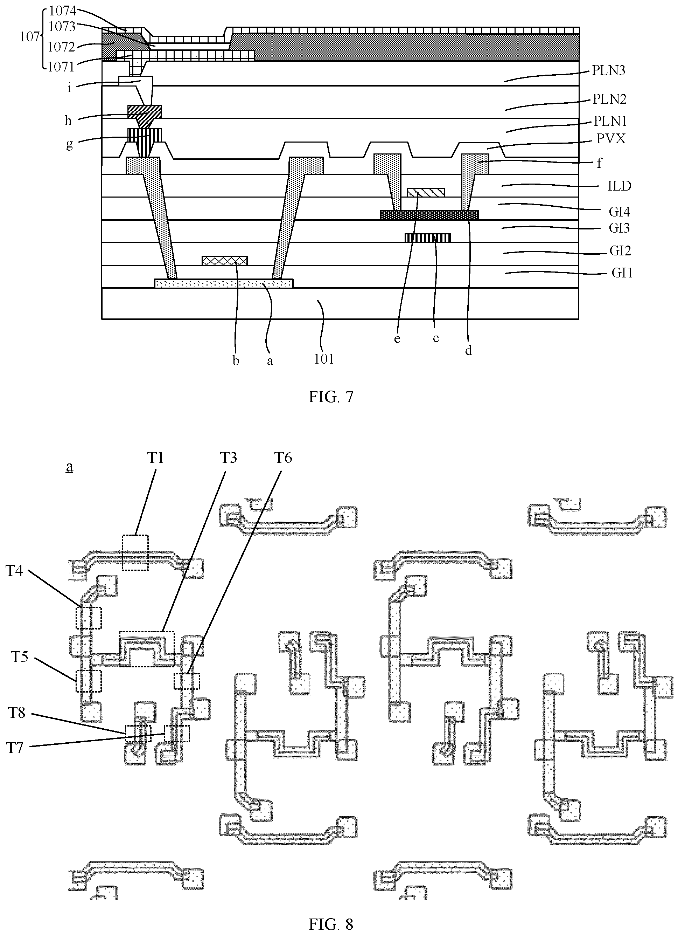

FIG. 7 is a sectional view of a display panel according to some embodiments of the present disclosure. Referring to FIG. 7, it can be seen that the display panel 10 includes an active layer a, a first gate insulating layer GI1, a first gate layer b, a second gate insulating layer GI2, a second gate layer c, a third gate insulating layer GI3, an oxide layer d, a fourth gate insulating layer GI4, a third gate layer e, an interlayer dielectric layer ILD, and a first source-drain layer f that constitute the pixel circuit and are sequentially stacked in the direction away from the base substrate 101. The display panel 10 further includes a passivation layer PVX, a first trace layer g, a first planarization layer PLN1, a second trace layer h, a second planarization layer PLN2, a second source-drain layer i, and a third planarization layer PLN3 that constitute the pixel circuit and are sequentially stacked in the direction away from the first source-drain layer f. The first signal line 103 is disposed in the first gate layer b, and the third signal line 106 is disposed in the third gate layer e.

It should be noted that FIG. 7 is only intended to show the lamination relationship of the various film layers, but not intended to indicate a specific sectional view of the display panel and the connection relationship of the transistors of the pixel circuit in the display panel. FIG. 7 shows one oxide thin film transistor and one LTPS thin film transistor. For example, the oxide thin film transistor is the second transistor T2, and the LTPS thin film transistor is the sixth transistor T6.

In the embodiments of the present disclosure, the second transistor T2 is an oxide thin film transistor, and thus the second transistor T2 is composed of the second gate layer c, the oxide layer d, and the third gate layer e. The oxide layer d is made of IGZO.

Exemplarily, the second transistor T2 is a dual gate transistor. The second gate layer c includes a gate pattern of a bottom gate of the second transistor T2. The oxide layer d includes an oxide pattern of the second transistor T2. The third gate layer e includes a gate pattern of a top gate of the second transistor T2.

In addition, the first transistor T1, the third transistor T3, the fourth transistor T4, the fifth transistor T5, the sixth transistor T6, the seventh transistor T7, and the eighth transistor T8 are LTPS thin film transistors, and thus the first transistor T1, the third transistor T3, the fourth transistor T4, the fifth transistor T5, the sixth transistor T6, the seventh transistor T7, and the eighth transistor T8 are composed of the active layer a, the first gate layer b, and the first source-drain layer f.

Exemplarily, the active layer a includes an active pattern of the first transistor T1, an active pattern of the third transistor T3, an active pattern of the fourth transistor T4, an active pattern of the fifth transistor T5, an active pattern of the sixth transistor T6, an active pattern of the seventh transistor T7, and an active pattern of the eighth transistor T8.

The first gate layer b includes a gate pattern of the first transistor T1, a gate pattern of the third transistor T3, a gate pattern of the fourth transistor T4, a gate pattern of the fifth transistor T5, a gate pattern of the sixth transistor T6, a gate pattern of the seventh membrane transistor T7, and a gate pattern of the eighth transistor T8.

In the embodiments of the present disclosure, in the first display region 10a, the light-emitting control signal line EM is disposed in the first gate layer b, the first reset power line vinit1 is disposed in the first source-drain layer f, and the third reset power line vinit3 is disposed in the third gate layer e. That is, in the embodiments, the third signal line 106 (the third reset power line vinit3) is of an integral structure.

In addition, other transverse signal lines, e.g., the first gate signal line Gate_N, the second gate signal line Gate_P, the first reset signal line Preset, and the second reset signal line Preset_H, are designed to be disposed in multiple film layers, i.e., they need to cross layers, as described below. The longitudinal signal lines, e.g., the data signal line Data and the driving power line VDD, are disposed in the second source-drain layer i. The transverse signal lines mainly provide signals for the plurality of pixel circuits arranged in the transverse direction, and the longitudinal signal lines mainly provide signals for the plurality of pixel circuits arranged in the longitudinal direction.

In the embodiments of the present disclosure, for a clear illustration of the various film layers, the various film layers in the case that the pixel circuit includes eight transistors are introduced by describing each layer and a step-by-step stacking of layers.

FIG. 8 is a partial schematic diagram of an active layer in a display panel according to some embodiments of the present disclosure. Referring to FIG. 8, the active layer a is provided with structures in a curved or bent shape, the active layer a includes active patterns (channel regions) and doped region patterns (source-drain doped regions) of the various transistors, and the active patterns and the doped region patterns of the various transistors in the same pixel circuit are arranged integrally.

It should be noted that the active layer a may include a low-temperature polysilicon layer integrally formed, and the source region and the drain region may be conducted by doping or the like to electrically connect various structures. That is, the semiconductor layers of the transistors of the various pixel circuits are an integral pattern formed of p-silicon, and the transistors in the same pixel circuit include doped region patterns (i.e., source regions and drain regions) and active patterns, and the active patterns of different transistors are spaced apart from each other.

The active layer a is made of amorphous silicon, polysilicon, oxide semiconductor material, or the like. It should be noted that the source region and the drain region described above may be regions doped with n-type impurities or p-type impurities.

The display panel includes a first gate insulating layer disposed on the side of the active layer a away from the base substrate 101 for insulating the active layer a from the first gate layer b formed subsequently.

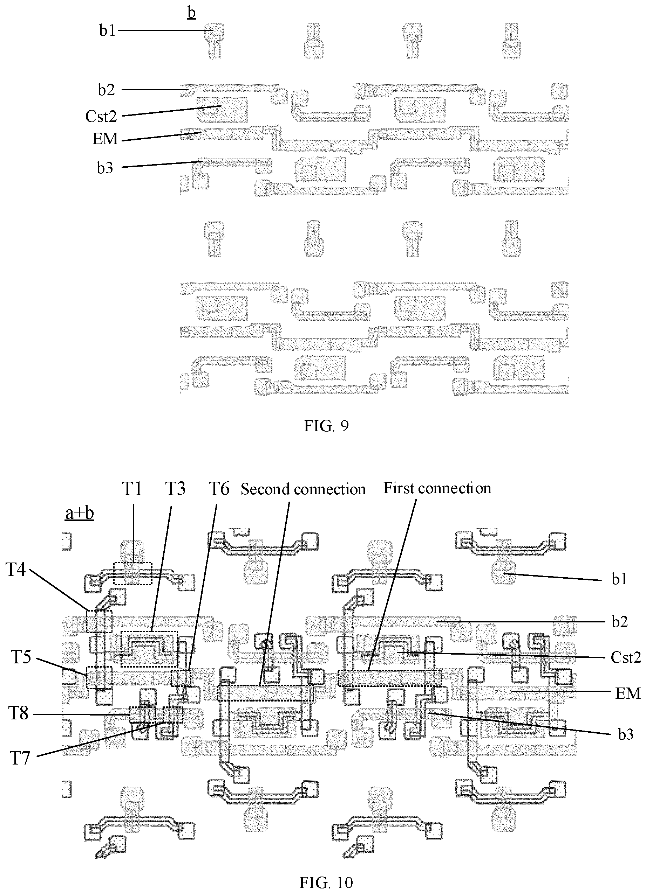

FIG. 9 is a partial schematic diagram of a first gate layer in a display panel according to some embodiments of the present disclosure. FIG. 10 is a partial schematic diagram of superposition of an active layer and a first gate layer in a display panel according to some embodiments of the present disclosure. The first gate layer b in the display panel shown in FIG. 9 and FIG. 10 is disposed on a first gate insulating layer, so as to be insulated from the active layer a. The first gate layer b includes the second storage capacitance electrode Cst2, the light-emitting control signal line EM, a gate layer pattern b1 of the first reset signal line Preset that provides the first reset signal for the gate of the first transistor T1, a gate layer pattern b2 of the second gate signal line Gate_P, and a gate layer pattern b3 of the second reset signal line Preset_H that provides the second reset signal for the gate of the eighth transistor T8. There is a gap between the various patterns in the first gate layer b, and the overlapping portions of the first gate layer b and the active layer a constitute the gates of the various transistors.

For example, in combination with FIG. 8 to FIG. 10, the gate of the first transistor T1 is the overlapping portion of the gate layer pattern b1 of the first reset signal line Preset and the active layer a. The gate of the third transistor T3 is the second storage capacitance electrode Cst2. The gate of the fourth transistor T4 is the overlapping portion of the gate layer pattern b2 of the second gate signal line Gate_P and the active layer a. The gate of the fifth transistor T5 and the gate of the sixth transistor T6 are the overlapping portions of the light-emitting control signal line EM and different regions of the active layer a, respectively. The seventh transistor T7 and the eighth transistor T8 are the overlapping portions of the gate layer pattern b3 of the second reset signal line Preset_H and different regions of the active layer a, respectively.

It should be noted that the dashed rectangular boxes in FIG. 10 illustrate the overlapping portions of the first gate layer b and the active layer a. For the channel region of each transistor, the active layers a on two sides of the channel region are conducted by processes such as ion doping and serve as the first electrode and the second electrode of the transistor. The source and the drain of the transistor are structurally symmetrical, and thus the source and the drain of the transistor are physically indistinguishable. In the embodiments of the present disclosure, in order to differentiate the transistors, except for the gate which serves as a control electrode, one electrode of the transistor is directly described as the first electrode, and the other electrode is described as the second electrode. Therefore, the first electrodes and the second electrodes of all or some of the transistors in the embodiments of the present disclosure are interchangeable as needed.

As shown in FIG. 9 and FIG. 10, the light-emitting control signal line EM is of an integral structure disposed in the first gate layer b. Additionally, a second gate insulating layer is formed on the first gate layer b for insulating the first gate layer b from a second gate layer c formed subsequently.

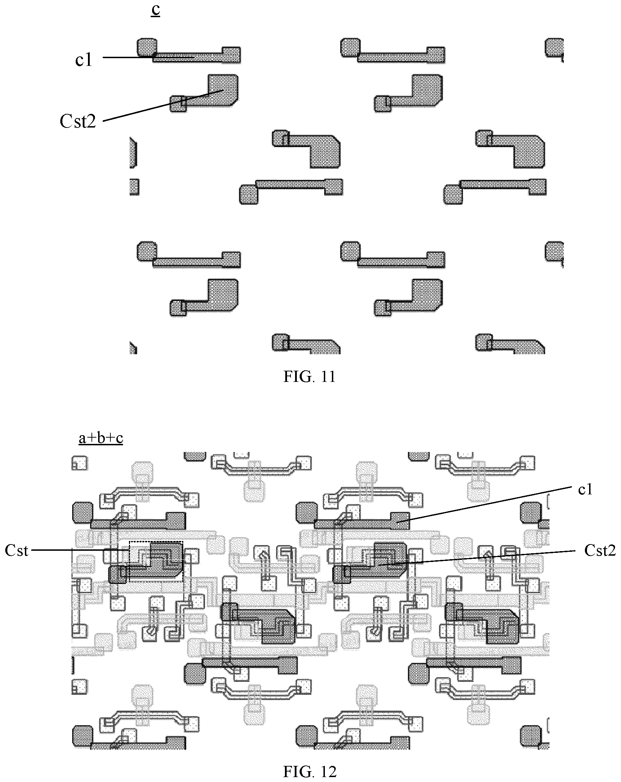

FIG. 11 is a partial schematic diagram of a second gate layer in a display panel according to some embodiments of the present disclosure; and FIG. 12 is a partial schematic diagram of superposition of an active layer, a first gate layer, and a second gate layer in a display panel according to some embodiments of the present disclosure. As shown in FIG. 11 and FIG. 12, the second gate layer c includes a first storage capacitance electrode Cst1 and a bottom gate pattern c1 of the second transistor T2 which is disposed in the second gate layer c. The first storage capacitance electrode Cst1 disposed in the second gate layer c is at least partially overlapped with the second storage capacitance electrode Cst2 disposed in the first gate layer b to form the storage capacitor Cst. The bottom gate pattern c1 is also used as a portion of the first gate signal line Gate_N that is disposed in the second gate layer c.

Additionally, a third gate insulating layer is formed on the second gate layer c for insulating the second gate layer c from an oxide layer d formed subsequently.

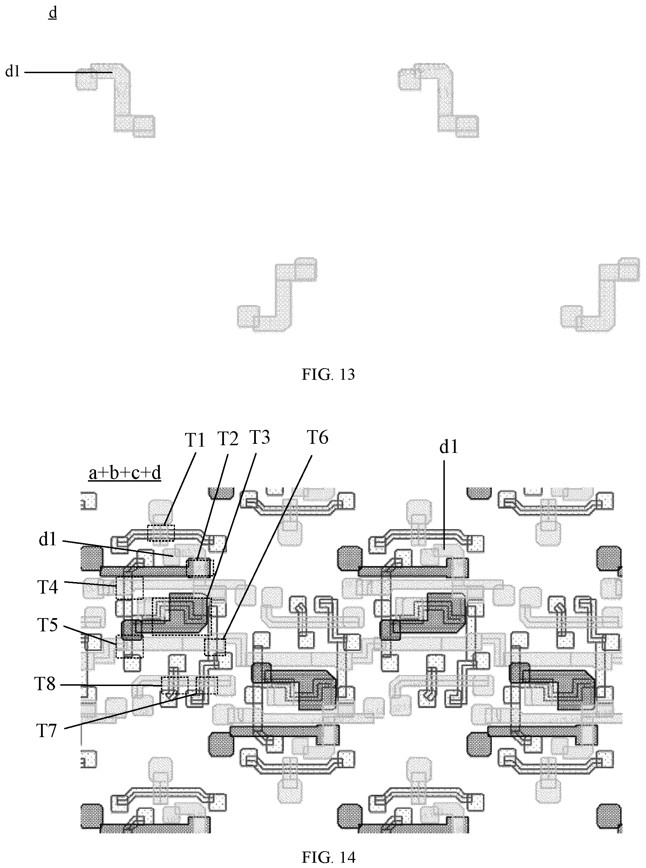

FIG. 13 is a partial schematic diagram of an oxide layer in a display panel according to some embodiments of the present disclosure; and FIG. 14 is a partial schematic diagram of superposition of an active layer, a first gate layer, a second gate layer, and an oxide layer in a display panel according to some embodiments of the present disclosure. As shown in FIG. 13 and FIG. 14, the oxide layer d includes an oxide pattern d1 for forming the second transistor T2.

Additionally, a fourth gate insulating layer is formed on the oxide layer d for insulating the oxide layer d from a third gate layer e formed subsequently.

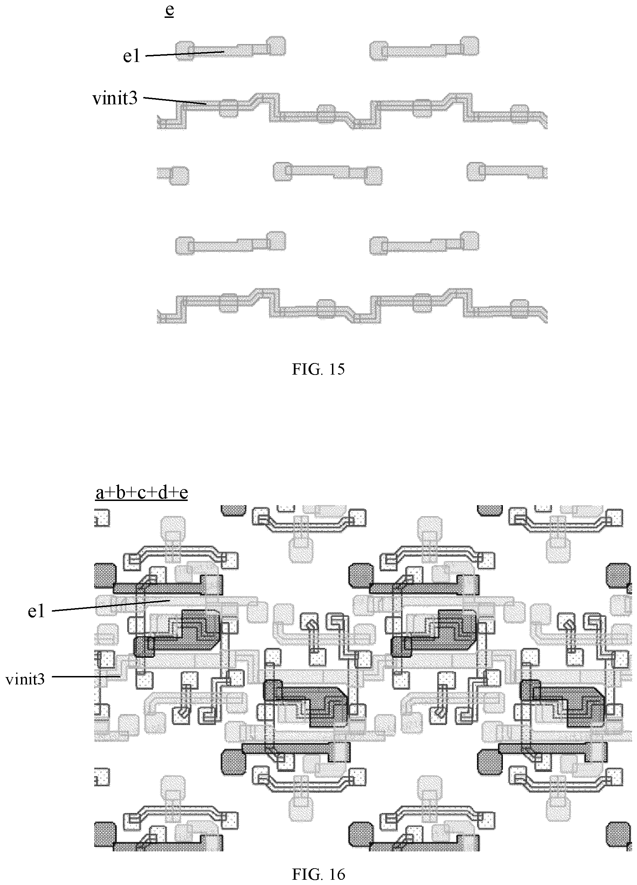

FIG. 15 is a partial schematic diagram of a third gate layer in a display panel according to some embodiments of the present disclosure, and FIG. 16 is a partial schematic diagram of superposition of an active layer, a first gate layer, a second gate layer, an oxide layer, and a third gate layer in a display panel according to some embodiments of the present disclosure. As shown in FIG. 15 and FIG. 16, the third gate layer e includes a top gate pattern e1 of the second transistor T2 that is disposed in the third gate layer e, and the third reset power line vinit3. The third reset power line vinit3 is of an integral structure disposed in the third gate layer e.

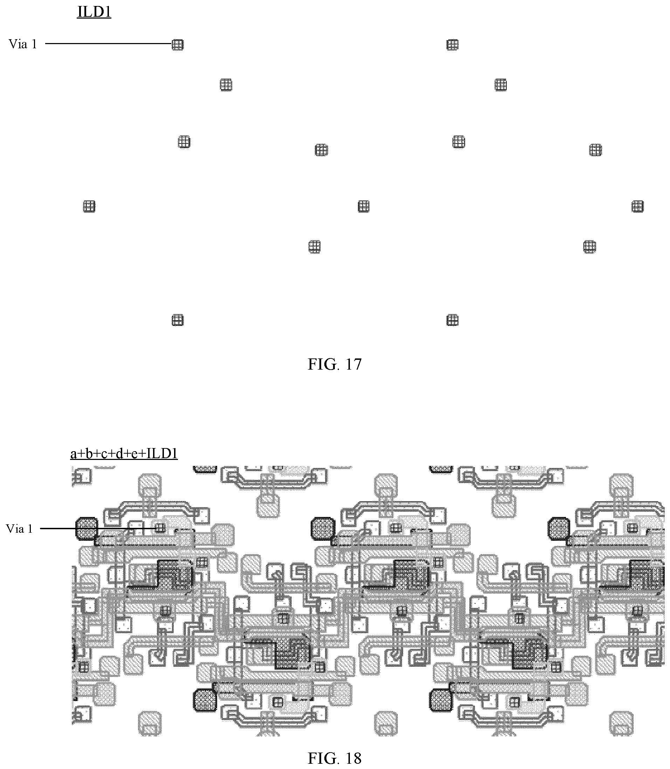

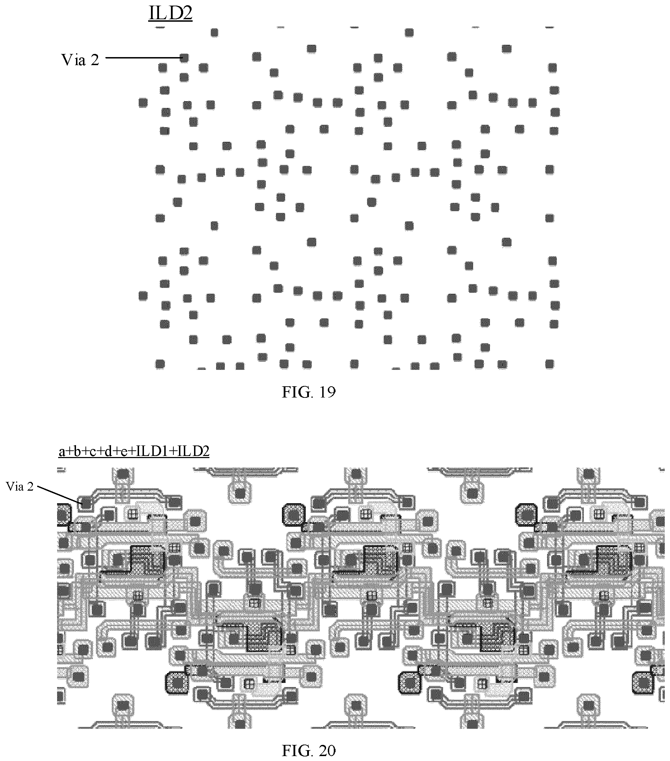

Additionally, two interlayer dielectric layers are formed on the second gate layer c for insulating the third gate layer e from the first source-drain layer f formed subsequently. FIG. 17 is a partial schematic diagram of a first interlayer dielectric layer in a display panel according to some embodiments of the present disclosure; FIG. 18 is a partial schematic diagram of superposition of an active layer, a first gate layer, a second gate layer, an oxide layer, a third gate layer, and a first interlayer dielectric layer in a display panel according to some embodiments of the present disclosure; FIG. 19 is a partial schematic diagram of a second interlayer dielectric layer in a display panel according to some embodiments of the present disclosure; and FIG. 20 is a partial schematic diagram of superposition of an active layer, a first gate layer, a second gate layer, an oxide layer, a third gate layer, a first interlayer dielectric layer, and a second interlayer dielectric layer in a display panel according to some embodiments of the present disclosure.

For an illustration of various vias 1 in the first interlayer dielectric layer ILD1 and various vias 2 in the second interlayer dielectric layer ILD2, fill patterns are used to represent the vis in FIG. 17 to FIG. 20. Other regions without a fill pattern represent regions of the interlayer dielectric layer where materials are provided. It should be noted that the vias formed in the interlayer dielectric layer are configured to connect the film layers formed subsequently and the film layer on the side of the interlayer dielectric layer close to the base substrate 101. That is, the vias are used for connecting film layers.

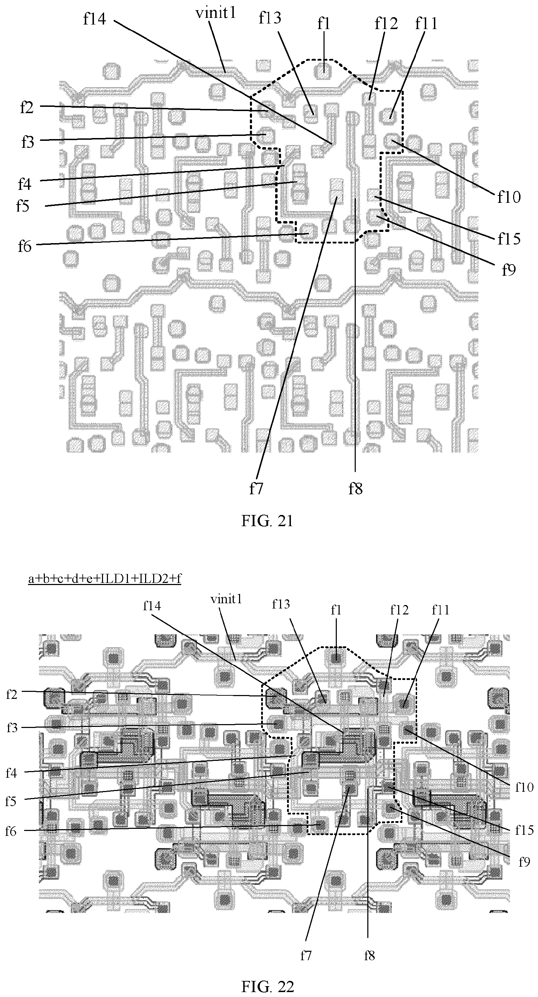

FIG. 21 is a partial schematic diagram of a first source-drain layer in a display panel according to some embodiments of the present disclosure, and FIG. 22 is a partial schematic diagram of superposition of an active layer, a first gate layer, a second gate layer, an oxide layer, a third gate layer, a first interlayer dielectric layer, a second interlayer dielectric layer, and a first source-drain layer in a display panel according to some embodiments of the present disclosure.

As shown in FIG. 21 and FIG. 22, the first source-drain layer f includes:
a first reset power line vinit1, wherein the first reset power line vinit1 implements signal transmission directly through the first source-drain layer f, without the need to design lap holes in the trace layer, which facilitates the layout design of other traces;
a first source-drain pattern f1, wherein the first source-drain pattern f1 is configured to connect the first electrode of the first transistor T1;
a second source-drain pattern f2, wherein the second source-drain pattern f2 is configured to connect a gate layer pattern c1 of the first gate signal line Gate_N that is disposed in the second gate layer c and a gate layer pattern e1 of the first gate signal line Gate_N that is disposed in the third gate layer e, and the second source-drain pattern f2 is further configured to connect a pattern of a first trace layer g formed subsequently;
a third source-drain pattern f3, wherein the third source-drain pattern f3 is configured to connect a gate layer pattern of the second gate signal line Gate_P that is disposed in the first gate layer b and a pattern of the first trace layer g formed subsequently;
a fourth source-drain pattern f4, wherein the fourth source-drain pattern f4 is configured to connect the second electrode of the fourth transistor T4 and the second electrode of the eighth transistor T8, and the second electrode of the fourth transistor T4 and the second electrode of the eighth transistor T8 are both connected to the second node N2;
a fifth source-drain pattern f5, wherein the fifth source-drain pattern f5 is configured to connect the first electrode of the fifth transistor T5, and the first electrode of the fifth transistor T5 is connected to the driving power line VDD (the driving power line VDD is disposed in the second trace layer h);
a sixth source-drain pattern f6, wherein the sixth source-drain pattern f6 is configured to connect a gate layer pattern of the second reset signal line Preset_H that is disposed in the first gate layer b and a pattern of the first trace layer g formed subsequently;
a seventh source-drain pattern f7, wherein the seventh source-drain pattern f7 is configured to connect the first electrode of the eighth transistor T8 and the third reset power line vinit3;
an eighth source-drain pattern f8, wherein the eighth source-drain pattern f8 is a pattern of the second reset power line vinit2 that is disposed in the first source-drain layer f, and the second reset power line vinit is connected to the first electrode of the seventh transistor T7;
a ninth source-drain pattern f9, wherein the ninth source-drain pattern f9 is configured to connect a gate layer pattern of the second reset signal line Preset_H that is disposed in the first gate layer b and a pattern of the first trace layer g formed subsequently;
a tenth source-drain pattern f10, wherein the tenth source-drain pattern fl0 i is configured to connect a gate layer pattern of the second gate signal line Gate_P that is disposed in the first gate layer b and a pattern of the first trace layer g formed subsequently;
an eleventh source-drain pattern f11, wherein the eleventh source-drain pattern f11 is connected to a gate layer pattern of the first gate signal line Gate_N that is disposed in the third gate layer e and a pattern of the first trace layer g formed subsequently;
a twelfth source-drain pattern f12, wherein the twelfth source-drain pattern f12 is connected to the second electrode of the first transistor T1 and the first electrode of the second transistor T2, and the twelfth source-drain pattern f12 is further used to connect the first electrode of the second transistor T2 and the first electrode of the sixth transistor T6, and the second electrode of the first transistor T1, the first electrode of the second transistor T2, and the first electrode of the sixth transistor T6 are all connected to the third node N3,
a thirteenth source-drain pattern f13, wherein the thirteenth source-drain pattern f13 is connected to the first electrode of the fourth transistor T4 and a data signal line in a second trace layer h formed subsequently;
a fourteenth source-drain pattern f14, wherein the fourteenth source-drain pattern f14 is connected to the second electrode of the second transistor T2 and the gate of the third transistor T3, and the second electrode of the second transistor T2 and the gate of the third transistor T3 are both connected to the second node N2; and
a fifteenth source-drain pattern f15, wherein the fifteenth source-drain pattern f15 is a dummy pattern for improving the design uniformity of the pattern of the first source-drain layer f.

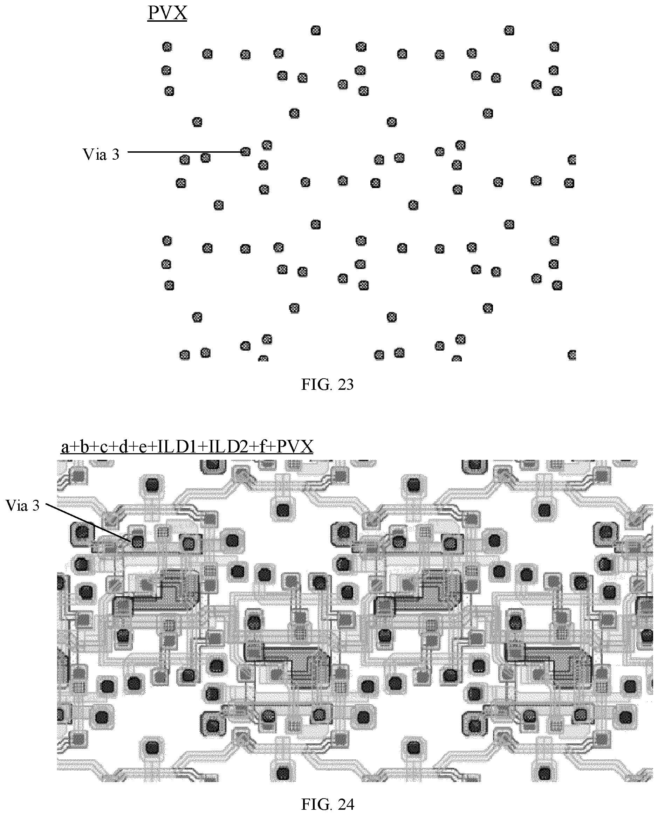

In addition, a passivation layer is formed on the first source-drain layer f for insulating the first source-drain layer f from the first trace layer g formed subsequently. FIG. 23 is a partial schematic diagram of a passivation layer in a display panel according to some embodiments of the present disclosure; and FIG. 24 is a partial schematic diagram of superposition of an active layer, a first gate layer, a second gate layer, an oxide layer, a third gate layer, a first interlayer dielectric layer, a second interlayer dielectric layer, a first source-drain layer, and a passivation layer in a display panel according to some embodiments of the present disclosure.

For an illustration of vias 3 in the passivation layer, fill patterns are used to represent the vias in FIG. 23 to FIG. 24. Other regions without a fill pattern represent the regions of the passivation layer where materials are provided. It should be noted that the vias formed in the passivation layer are configured to connect the film layers formed subsequently and the film layer on the side of the passivation layer close to the base substrate 101. That is, the vias are vias for connecting film layers.

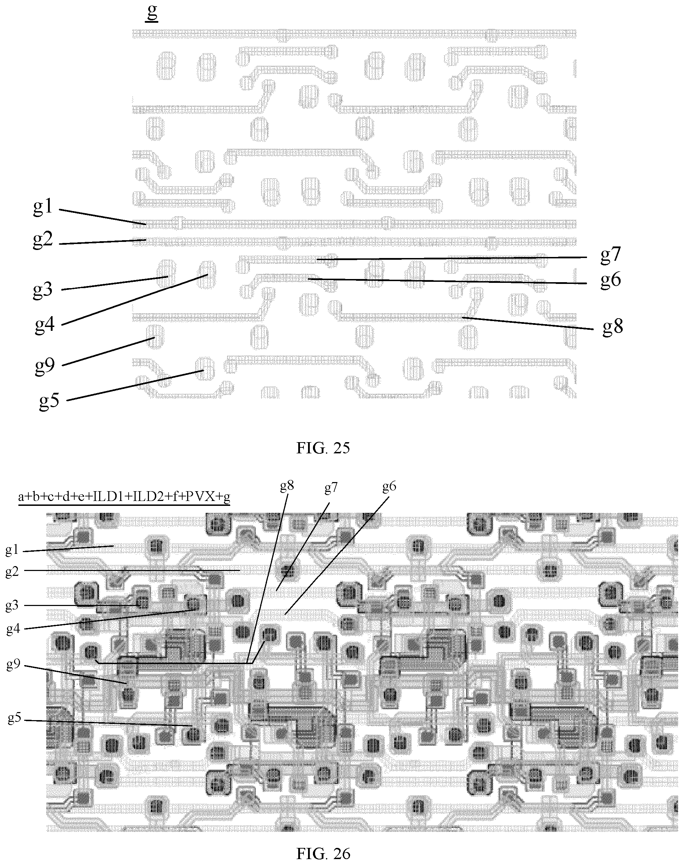

FIG. 25 is a partial schematic diagram of a first trace layer in a display panel according to some embodiments of the present disclosure; and FIG. 26 is a partial schematic diagram of superposition of an active layer, a first gate layer, a second gate layer, an oxide layer, a third gate layer, a first interlayer dielectric layer, a second interlayer dielectric layer, a first source-drain layer, a passivation layer, and a trace layer in a display panel according to some embodiments of the present disclosure.

As shown in FIG. 25 and FIG. 26, the first trace layer g includes:
a first trace pattern g1, wherein the first trace pattern g1 is a pattern of the first reset signal line Preset for connecting the plurality of first pixel circuits 1021;
a second trace pattern g2, wherein the second trace pattern g2 is a pattern of the first reset signal line Preset for connecting the plurality of second pixel circuits 1022;
a third trace pattern g3, wherein the third trace pattern g3 is connected to the first electrode of the fourth transistor T4 and a data signal line Data in the second trace layer h formed subsequently;
a fourth trace pattern g4 and a fifth trace pattern g5, wherein the fourth trace pattern g4 and the fifth trace pattern g5 are connected to the second reset power line vinit2 in the second trace layer h formed subsequently;
a sixth trace pattern g6, wherein the sixth trace pattern g6 is a trace layer pattern of the second gate signal line Gate_P;
a seventh trace pattern g7, wherein the seventh trace pattern g7 is a trace layer pattern of the first gate signal line Gate_N;
an eighth trace pattern g8, wherein the eighth trace pattern g8 is a trace layer pattern for the second reset signal line Preset _H; and
a ninth trace pattern g9, wherein the ninth trace pattern g9 is connected to the driving power line VDD in the second trace layer h formed subsequently.

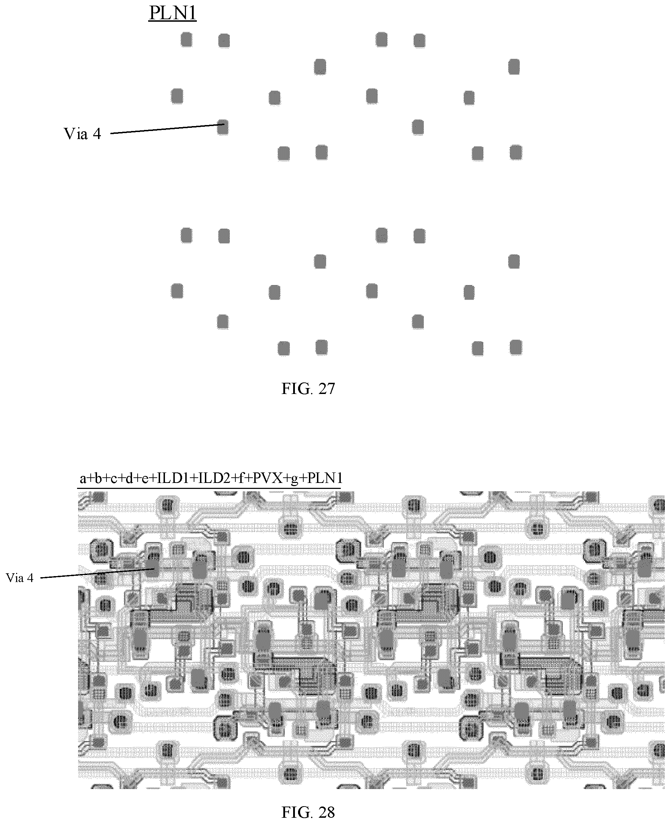

Additionally, a first planarization layer is formed on the first trace layer g for insulating the first trace layer g from the second trace layer h formed subsequently. FIG. 27 is a partial schematic diagram of a first planarization layer in a display panel according to some embodiments of the present disclosure, and FIG. 28 is a partial schematic diagram of superposition of an active layer, a first gate layer, a second gate layer, an oxide layer, a third gate layer, a first interlayer dielectric layer, a second interlayer dielectric layer, a first source-drain layer, a passivation layer, a first trace layer, and a first planarization layer in a display panel according to some embodiments of the present disclosure.

For an illustration of vias 4 in the first planarization layer, fill patterns are used to represent the vias in FIG. 27 to FIG. 28. Other regions without a fill pattern represent the regions of the first planarization layer where materials are provided. It should be noted that the vias formed in the first planarization layer are configured to connect the film layers formed subsequently and the film layer on the side of the first planarization layer close to the base substrate 101. That is, the vias are used for connecting film layers.

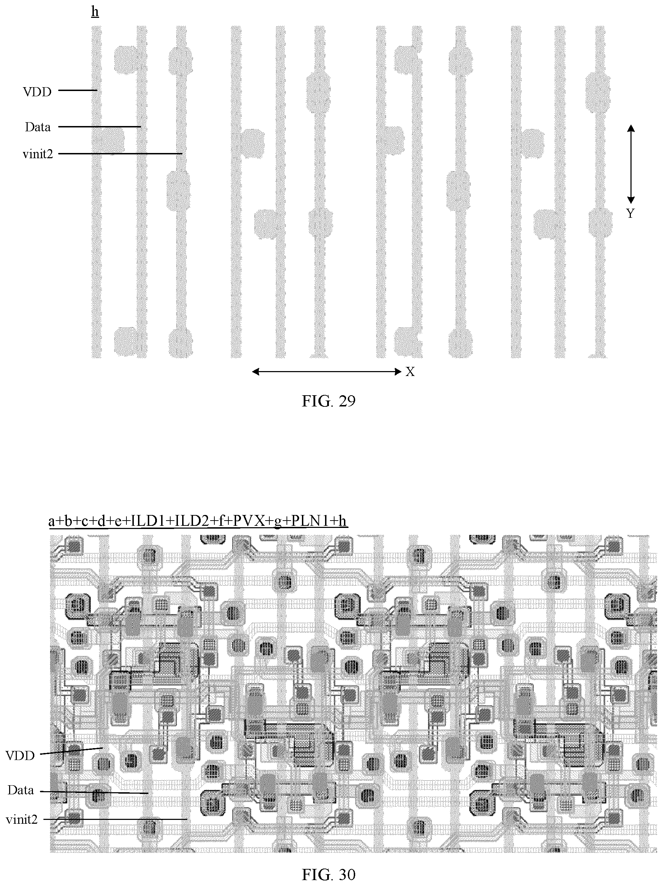

FIG. 29 is a partial schematic diagram of a second trace layer in a display panel according to some embodiments of the present disclosure; and FIG. 30 is a partial schematic diagram of superposition of an active layer, a first gate layer, a second gate layer, an oxide layer, a third gate layer, a first interlayer dielectric layer, a second interlayer dielectric layer, a first source-drain layer, the passivation layer, a first trace layer, a first planarization layer, and a second trace layer in a display panel according to some embodiments of the present disclosure. As shown in FIG. 29 and FIG. 30, the second trace layer h includes the driving power line VDD, the data signal line Data, and the second reset power line vinit2. The driving power line VDD, the data signal line Data, and the second reset power line vinit2 extend along the pixel column direction Y and are sequentially arranged along the pixel row direction X.

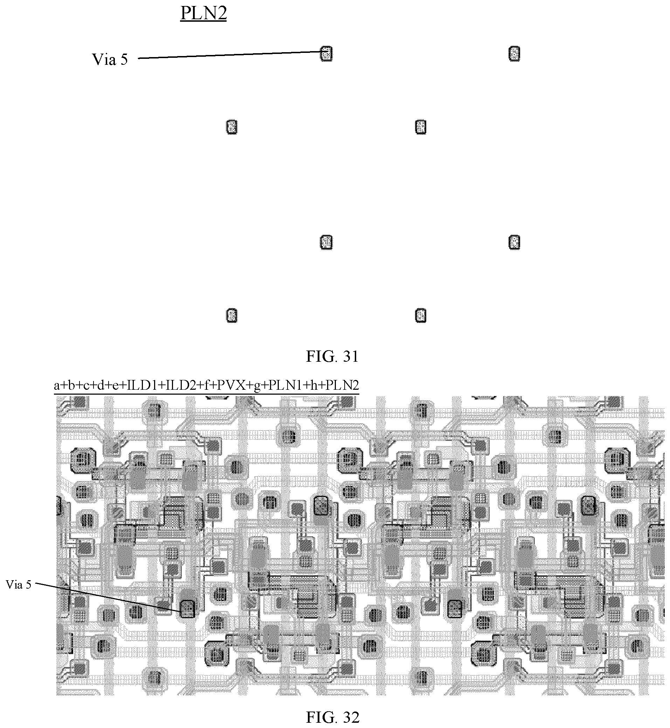

Additionally, a second planarization layer is formed on the second trace layer h for insulating the second trace layer h from the second source-drain layer i formed subsequently. FIG. 31 is a partial schematic diagram of a second planarization layer in a display panel according to some embodiments of the present disclosure; and FIG. 32 is a partial schematic diagram of superposition of an active layer, a first gate layer, a second gate layer, an oxide layer, a third gate layer, a first interlayer dielectric layer, a second interlayer dielectric layer, a first source-drain layer, a passivation layer, a first trace layer, a first planarization layer, a second trace layer, and a second planarization layer in a display panel according to some embodiments of the present disclosure.

For an illustration of vias 5 in the first planarization layer, fill patterns are used to represent the vias in FIG. 30 and FIG. 31. Other regions without a fill pattern represent the regions of the second planarization layer where materials are provided. It should be noted that the vias formed in the second planarization layer are configured to connect the film layers formed subsequently and the film layer on the side of the second planarization layer close to the base substrate 101. That is, the vias are used for connecting film layers.

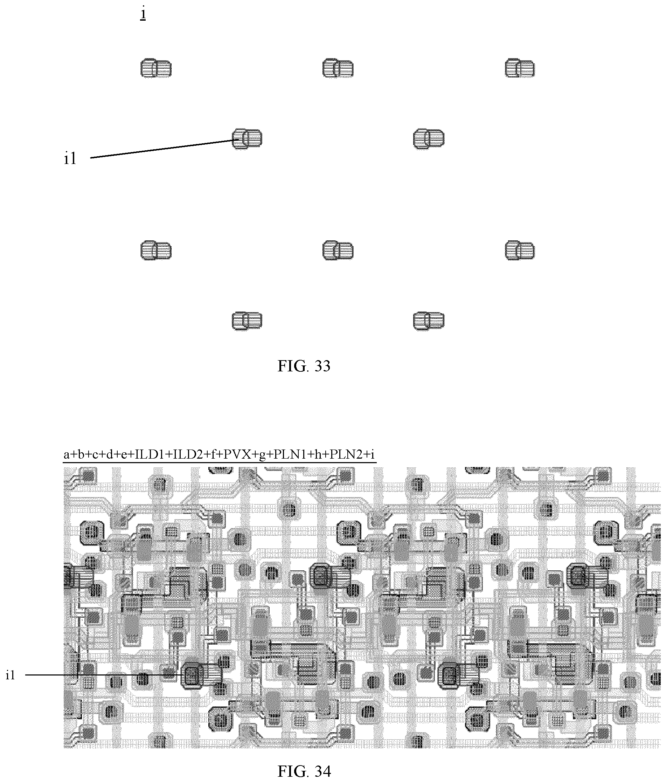

FIG. 33 is a partial schematic diagram of a second source-drain layer in a display panel according to some embodiments of the present disclosure; and FIG. 34 is a partial schematic diagram of superposition of an active layer, a first gate layer, a second gate layer, an oxide layer, a third gate layer, a first interlayer dielectric layer, a second interlayer dielectric layer, a first source-drain layer, a passivation layer, the first trace layer, a first planarization layer, a second trace layer, a second planarization layer, and a second source-drain layer in a display panel according to some embodiments of the present disclosure. As shown in FIG. 33 and FIG. 34, the second source-drain layer i includes a sixteenth source-drain pattern i1. The sixteenth source-drain pattern i1 is connected to the seventh transistor T7 and an anode layer of a light-emitting unit formed subsequently.

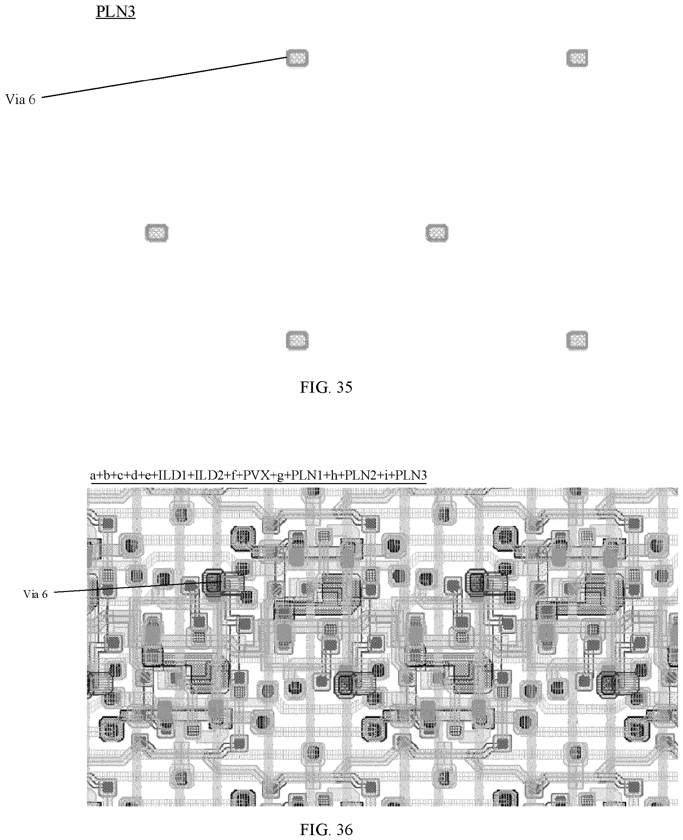

Additionally, a third planarization layer is formed on the second source-drain layer i for insulating the second source-drain layer i from the anode layer of the light-emitting unit formed subsequently. FIG. 35 is a partial schematic diagram of a third planarization layer in a display panel according to some embodiments of the present disclosure; and FIG. 36 is a partial schematic diagram of superposition of an active layer, a first gate layer, a second gate layer, an oxide layer, a third gate layer, a first interlayer dielectric layer, a second interlayer dielectric layer, a first source-drain layer, a passivation layer, a first trace layer, a first planarization layer, a second trace layer, a second planarization layer, a first source-drain layer, and a third planarization layer in a display panel according to some embodiments of the present disclosure.

For an illustration of vias 6 in the third planarization layer, fill patterns are used to represent the vias in FIG. 35 and FIG. 36. Other regions without a fill pattern represent the regions of the third planarization layer where materials are provided. It should be noted that the vias formed in the third planarization layer are configured to connect the film layers formed subsequently and the film layer on the side of the third planarization layer close to the base substrate 101. That is, the vias are used for connecting film layers.

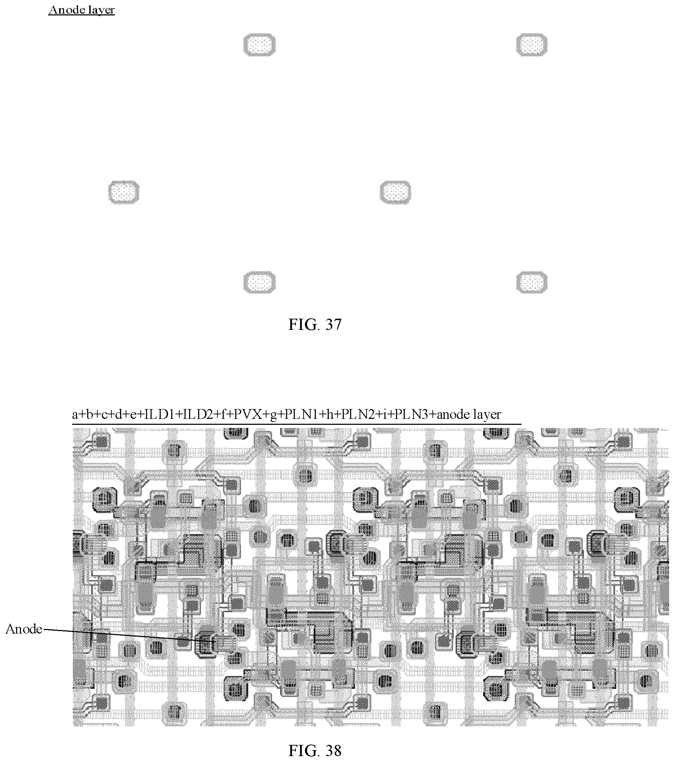

FIG. 37 is a partial schematic diagram of an anode layer in a display panel according to some embodiments of the present disclosure; and FIG. 38 is a partial schematic diagram of superposition of an active layer, a first gate layer, a second gate layer, an oxide layer, a third gate layer, a first interlayer dielectric layer, a second interlayer dielectric layer, a first source-drain layer, a passivation layer, a first trace layer, a first planarization layer, a second trace layer, a second planarization layer, a second source-drain layer, a third planarization layer, and a anode layer in a display panel according to some embodiments of the present disclosure. As shown in FIG. 37 and FIG. 38, the anode of the light-emitting unit is connected to the fifteenth source-drain pattern i1 of the second source-drain layer i through the via 6 in the third planarization layer. The various patterns shown in FIG. 37 and FIG. 38 are only intended to illustrate the position of the anode and do not indicate the actual shape of the anode.

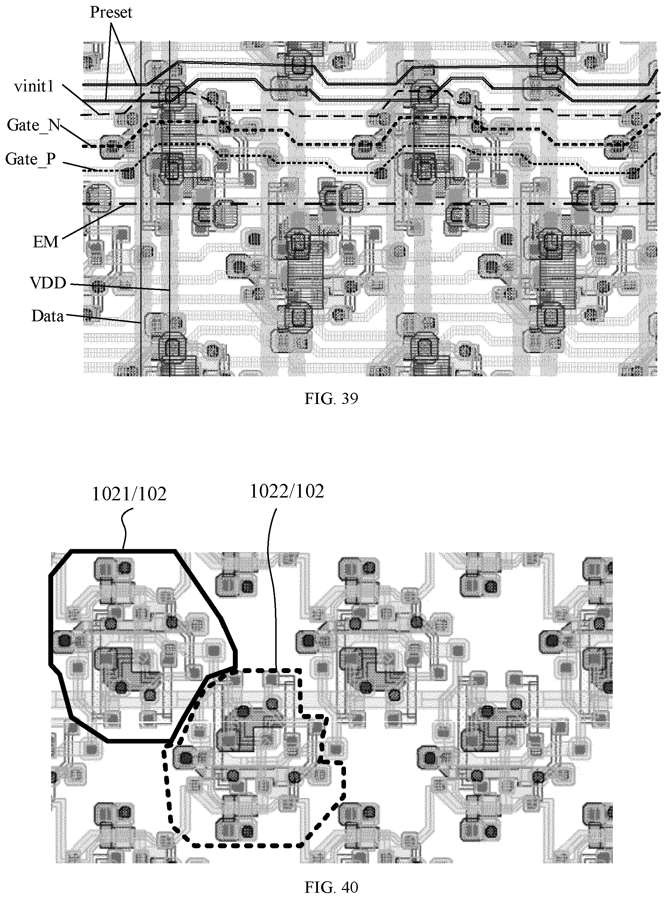

In a second optional implementation, each of the plurality of first pixel circuits 1021 and the plurality of second pixel circuits 1022 in each pixel circuit group 102 includes seven transistors and one storage capacitor Cst (i.e., 7T1C), such as shown in FIG. 39 and FIG. 40. For a clear illustration of the pixel circuit, FIG. 40 only shows up to the first source-drain layer, but does not show the film layers on the side of the first source-drain layer away from the base substrate 101.

The difference between FIG. 39 and FIG. 40 lies in that the first reset power line vinit1 in FIG. 39 needs to cross layers through the trace layer, while the first reset power line vinit1 in FIG. 40 does not need to cross layers through the trace layer.

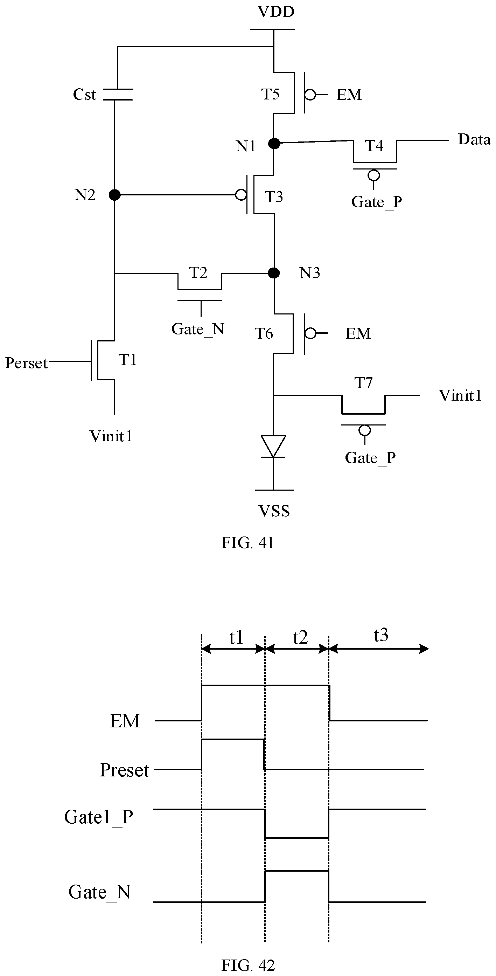

FIG. 41 is an equivalent circuit diagram of a pixel circuit in the display panel shown in FIG. 39 or FIG. 40. Referring to FIG. 41, the pixel circuit includes a first transistor T1, a second transistor T2, a third transistor T3, a fourth transistor T4, a fifth transistor T5, a sixth transistor T6, a seventh transistor T7, and a storage capacitor Cst.

A gate of the first transistor T1 is connected to a first reset signal line Preset, a first electrode of the first transistor T1 is connected to a first reset power line vinit1, and a second electrode of the first transistor T1 is connected to a second node N2. The first transistor T1 is also referred to as a reset transistor.

A gate of the second transistor T2 is connected to a first gate signal line Gate_N, a first electrode of the second transistor T2 is connected to a third node N3, and a second electrode of the second transistor T2 is connected to the second node N2. The second thin film transistor T2 is also referred to as a compensation transistor.

A gate of the third transistor T3 is connected to the second node N2, a first electrode of the third transistor T3 is connected to a first node N1, and a second electrode of the third transistor T3 is connected to the third node N3. The third transistor T3 is also referred to as a driving transistor.

A gate of the fourth transistor T4 is connected to a second gate signal line Gate_P, a first electrode of the fourth transistor T4 is connected to a data signal line Data, and a second electrode of the fourth transistor T4 is connected to the first node N1. The fourth transistor T4 is a data-writing transistor in the pixel circuit.

A gate of the fifth transistor T5 is connected to a light-emitting control signal line EM, a first electrode of the fifth transistor T5 is connected to a driving power line VDD, and a second electrode of the fifth transistor T5 is connected to the first node N1. As the gate of the fifth transistor T5 is connected to the light-emitting control signal line EM, the fifth transistor T5 is also referred to as a light-emitting control transistor.

A gate of the sixth transistor T6 is connected to the light-emitting control signal line EM, a first electrode of the sixth transistor T6 is connected to the third node N3, and a second electrode of the sixth transistor T6 is connected to an anode of the light-emitting unit. As the gate of the sixth transistor T6 is connected to the light-emitting control signal line EM, the sixth transistor T6 is also referred to as a light-emitting control transistor.

A gate of the seventh transistor T7 is connected to the second gate signal line Gate_P, a first electrode of the seventh transistor T7 is connected to the first reset power line vinit1, and a second electrode of the seventh transistor T7 is connected to the anode of the light-emitting unit. The seventh transistor T7 is a reset transistor in the pixel circuit.

One terminal of the storage capacitor Cst is connected to the driving power line VDD, and the other terminal of the storage capacitor Cst is connected to the second node N2. Optionally, the storage capacitor Cst includes two capacitance plates Cstl and Cst2, and in the embodiments of the present disclosure, the capacitance plate Cst1 is referred to as one terminal, a first terminal, or a first storage capacitance electrode of the storage capacitor Cst, and the capacitance plate Cst2 is referred to as the other storage capacitance electrode, a second storage capacitance electrode, or a second storage capacitance electrode of the storage capacitor Cst.

In the embodiments of the present disclosure, the third signal line 106 is a second gate signal line Gate_P. That is, in the case that the pixel circuit includes seven transistors and one storage capacitor Cst, the third signal line 106 is the second gate signal line Gate_P, and the second gate signal line Gate_P provides second gate signals for the plurality of first pixel circuits 1021 and the plurality of second pixel circuits 1022 in one pixel circuit group 102.

Optionally, the first transistor T1 and the second transistor T2 are N-type transistors, and the third transistor T3, the fourth transistor T4, the fifth transistor T5, the sixth transistor T6, and the seventh transistor T7 are P-type transistors.

Optionally, in the embodiments of the present disclosure, each N-type transistor is an oxide thin film transistor, and each P-type transistor is an LTPS thin film transistor. The oxide material includes IGZO, i.e., the oxide thin film transistor is an IGZO thin film transistor. The pixel circuit consisting of the seven transistors is also referred to as an LTPO pixel circuit. A display panel having the LTPO pixel circuit is also referred to as an LTPO display panel.

Taking the pixel circuit shown in FIG. 41 in which a first potential is a high potential relative to the second potential as an example, the driving principle of the pixel circuit in the embodiments of the present disclosure is described as follows. FIG. 42 is a timing diagram of signal lines in another pixel circuit according to some embodiments of the present disclosure. As shown in FIG. 42:
In an initialization stage t1, the potential of a reset signal provided by the first reset signal line Preset, the potential of a second gate driving signal provided by the second gate signal line Gate_P, and the potential of a light-emitting control signal provided by the light-emitting control signal line EM are all the first potential, and the potential of a first gate driving signal provided by the first gate signal line Gate_N is the second potential. Accordingly, the first transistor T1 is turned on, and the second transistor T2, the fourth transistor T4, the fifth transistor T5, the sixth transistor T6, and the seventh transistor T7 are turned off. In this way, the reset power signal at the second potential provided by the first reset power line vinit1 can be transmitted to the second node N2 through the turned-on first transistor T1, thereby resetting the second node N2.

In a compensation stage t2, the potential of the reset signal provided by the first reset signal line Preset and the potential of the second gate driving signal provided by the second gate signal line Gate_P jump to the second potential, the potential of the first gate driving signal provided by the first gate signal line Gate_N jumps to the first potential, and the potential of the light-emitting control signal provided by the light-emitting control signal line EM maintains at the first potential. Under the bootstrap effect of the storage capacitor Cst, the potential of the second node N2 maintains at the second potential. Accordingly, the second transistor T2, the third transistor T3, the fourth transistor T4, and the seventh transistor T7 are turned on, and the first transistor T1, the fifth transistor T5, and the sixth transistor T6 are turned off. In this way, the data signal at the first potential can be transmitted to the first node N1 through the turned-on fourth transistor T4, and is then transmitted to the third node N3 through the turned-on third transistor T3, and the second transistor T2 adjusts the potential of the second node N2 based on the potential of the third node N3. In addition, the reset power signal at the second potential provided by the first reset power line vinit1 can be transmitted to the light-emitting unit a2 through the turned-on seventh transistor T7, thereby resetting the light-emitting unit.

In a light-emitting stage t3, the potential of the reset signal provided by the first reset signal line Preset maintains at the second potential, the potential of the second gate driving signal provided by the second gate signal line Gate_P jumps to the first potential, and the potential of the first gate driving signal provided by the first gate signal line Gate_N jumps to the second potential. Under the bootstrap effect of the storage capacitor Cst, the potential of the second node N2 maintains at the second potential. Accordingly, the third transistor T3, the fifth transistor T5, and the sixth transistor T6 are turned on, and the first transistor T1, the second transistor T2, the fourth transistor T4, and the seventh transistor T7 are turned off. In this way, the driving power signal provided by the driving power line VDD can be transmitted to the first node N1 through the turned-on fifth transistor T5, and the third transistor T3 can transmit a driving current to the third node N3 based on the potential of the second node N2 and the potential transmitted to the first node N1. Then, the driving current can be transmitted again to an anode pattern of the light-emitting unit through the turned-on sixth transistor T6, a voltage difference is generated between the anode pattern of the light-emitting unit and a cathode layer, and the light-emitting unit emits light. The cathode layer is connected to the driving power line VSS.

For the stacking relationship of the film layers in this implementation, reference can be made to FIG. 7. The first signal line 103 is disposed in the first gate layer b, and the third signal line 106 includes a first portion, a second portion, and a third portion that are connected in sequence. An orthographic projection of the first portion on the base substrate 101 is at least partially overlapped with an orthographic projection of the first pixel circuit 1021 on the base substrate 101, an orthographic projection of the second portion on the base substrate 101 is not overlapped with the orthographic projection of the first pixel circuit 1021 on the base substrate 101 and the orthographic projection of the second pixel circuit 1022 on the base substrate 101, and an orthographic projection of the third portion on the base substrate 101 is at least partially overlapped with the orthographic projection of the second pixel circuit 1022 on the base substrate 101. The first portion and the third portion are disposed in the first gate layer b, and the second portion is disposed in the first source-drain layer f. That is, in this implementation, the third signal line 106 needs to cross layers, and both layers are metal layers.

In the embodiments of the present disclosure, the first transistor T1 and the second transistor T2 are oxide thin film transistors, and thus the first transistor T1 and the second transistor T2 are composed of a second gate layer c, an oxide layer d, and a third gate layer e. The oxide layer d is made of IGZO.

Exemplarily, the first transistor T1 and the second transistor T2 are dual gate transistors. The second gate layer c includes a gate pattern of a bottom gate of the first transistor T1 and a gate pattern of a bottom gate of the second transistor T2. The oxide layer d includes an oxide pattern of the first transistor T1 and an oxide pattern of the second transistor T2. The third gate layer e includes a gate pattern of the bottom gate of the first transistor T1 and a gate pattern of a top gate of the second transistor T2.

Additionally, the third transistor T3, the fourth transistor T4, the fifth transistor T5, the sixth transistor T6, and the seventh transistor T7 are all LTPS thin film transistors, and thus the third transistor T3, the fourth transistor T4, the fifth transistor T5, the sixth transistor T6, and the seventh transistor T7 are composed of the active layer a, the first gate layer b, and the first source-drain layer f.

Exemplarily, the active layer a includes an active pattern of the third transistor T3, an active pattern of the fourth transistor T4, an active pattern of the fifth transistor T5, an active pattern of the sixth transistor T6, and an active pattern of the seventh transistor T7.

The first gate layer b includes a gate pattern of the third transistor T3, a gate pattern of the fourth transistor T4, a gate pattern of the fifth transistor T5, a gate pattern of the sixth transistor T6, and a gate pattern of the seventh transistor T7.

In the embodiments of the present disclosure, in the first display region 10a, the light-emitting control signal line EM is disposed in the first gate layer b, the first reset power line vinit1 is disposed in the first source-drain layer f, and the second gate signal line Gate_P is disposed in the first gate layer b and the first source-drain layer f.

In the embodiments of the present disclosure, for a clear illustration of the various film layers, the various film layers in the case that the pixel circuit in FIG. 40 includes seven transistors are introduced by describing each layer and a step-by-step stacking of layers.

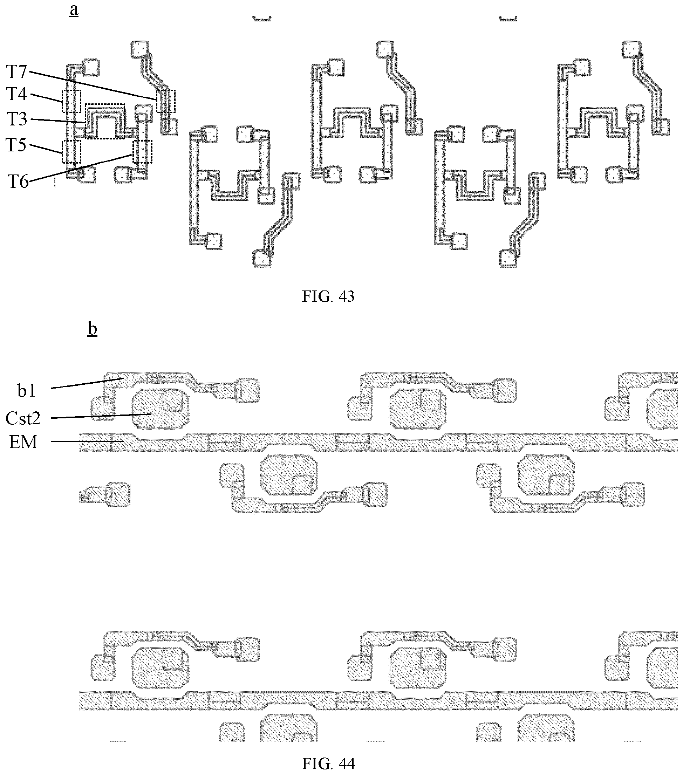

FIG. 43 is a partial schematic diagram of an active layer in another display panel according to some embodiments of the present disclosure. Referring to FIG. 43, the active layer a is provided with structures in a curved or bent shape, the active layer a includes the active patterns (channel regions) and the doped region patterns (source-drain doped regions) of the various transistors, and the active patterns and the doped region patterns of the various transistors in the same pixel circuit are arranged integrally.

It should be noted that the active layer a may include a low-temperature polysilicon layer integrally formed, and the source region and the drain region may be conducted by doping or the like to electrically connect various structures. That is, the semiconductor layers of the transistors of the various pixel circuits are an integral pattern formed of p-silicon, and the transistors in the same pixel circuit include doped region patterns (i.e., source regions and drain regions) and active patterns, and the active patterns of different transistors are spaced apart from each other.

The active layer a is made of amorphous silicon, polysilicon, oxide semiconductor material, or the like. It should be noted that the source region and the drain region described above may be regions doped with n-type impurities or p-type impurities.

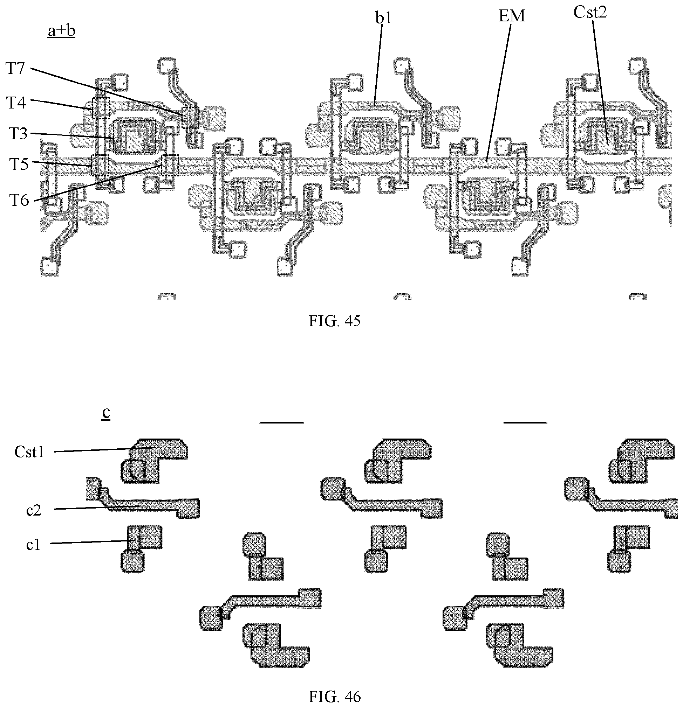

The display panel includes a first gate insulating layer disposed on the side of the active layer a away from the base substrate 101 for insulating the active layer a from the first gate layer b formed subsequently. FIG. 44 is a partial schematic diagram of a first gate layer in another display panel according to some embodiments of the present disclosure; and FIG. 45 is a partial schematic diagram of superposition of an active layer and a first gate layer in another display panel according to some embodiments of the present disclosure. The first gate layer b in the display panel shown in FIG. 44 and FIG. 45 is disposed on the first gate insulating layer, so as to be insulated from the active layer a. The first gate layer b includes the second storage capacitance electrode Cst2, the light-emitting control signal line EM, and a gate layer pattern b1 of the second gate signal line Gate_P. The overlapping portions of the first gate layer b and the active layer a constitute the gates of the various transistors.

For example, in combination with FIG. 43 to FIG. 45, the gate of the third transistor T3 is the second storage capacitance electrode Cst2. The gate of the fourth transistor T4 and the gate of the seventh transistor T7 are the overlapping portions of the gate layer pattern b2 of the second gate signal line Gate_P and different regions of the active layer a, respectively. The gate of the fifth transistor T5 and the gate of the sixth transistor T6 are the overlapping portions of the light-emitting control signal line EM and different regions of the active layer a, respectively.

It should be noted that the dashed rectangular boxes in FIG. 45 illustrate the overlapping portions of the first gate layer b and the active layer a. For the channel region of each transistor, the active layers a on two sides of the channel region are conducted by processes such as ion doping and serve as the first electrode and the second electrode of the transistor. The source and the drain of the transistor are structurally symmetrical, and thus the source and the drain of the transistor are physically indistinguishable. In the embodiments of the present disclosure, in order to differentiate the transistors, except for the gate which serves as a control electrode, one electrode of the transistor is directly described as the first electrode, and the other electrode is described as the second electrode. Therefore, the first electrodes and the second electrodes of all or some of the transistors in the embodiments of the present disclosure are interchangeable as needed.

As shown in FIG. 44 and FIG. 45, the light-emitting control signal line EM is of an integral structure disposed in the first gate layer b. Additionally, a second gate insulating layer is formed on the first gate layer b for insulating the first gate layer b from a second gate layer c formed subsequently.

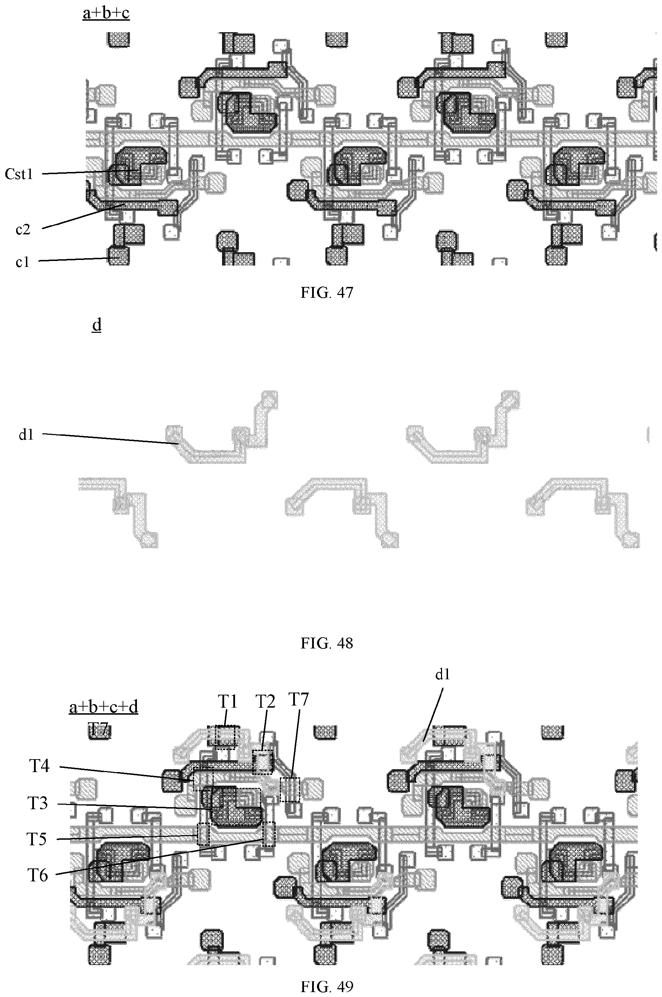

FIG. 46 is a partial schematic diagram of a second gate layer in another display panel according to some embodiments of the present disclosure; and FIG. 47 is a partial schematic diagram of superposition of an active layer, a first gate layer, and a second gate layer in another display panel according to some embodiments of the present disclosure.

As shown in FIG. 46 and FIG. 47, the second gate layer c includes:
a first storage capacitance electrode Cst1, wherein the first storage capacitance electrode Cst1 disposed in the second gate layer c is at least partially overlapped with the second storage capacitance electrode Cst2 disposed in the first gate layer b to form a storage capacitor Cst;
a bottom gate pattern c1 of the first transistor T1, wherein the bottom gate pattern c1 is also used as a portion of the first reset signal line Preset that is disposed in the second gate layer c; and
a bottom gate pattern c2 of the second transistor T2, wherein the bottom gate pattern c2 is also used as a portion of the first gate signal line Gate_N that is disposed in the second gate layer c.

In addition, a third gate insulating layer is formed on the second gate layer c for insulating the second gate layer c from the oxide layer d formed subsequently.

FIG. 48 is a partial schematic diagram of an oxide layer in another display panel according to some embodiments of the present disclosure; and FIG. 49 is a partial schematic diagram of superposition of an active layer, a first gate layer, a second gate layer, and an oxide layer in another display panel according to some embodiments of the present disclosure. As shown in FIG. 48 and FIG. 49, the oxide layer d includes an oxide pattern d1 for forming the first transistor T1 and the second transistor T2. The first transistor T1 and the second transistor T2 are connected, and thus the oxide pattern of the first transistor T1 and the oxide pattern of the second transistor T2 are of an integral structure.

Additionally, a fourth gate insulating layer is formed on the oxide layer d for insulating the oxide layer d from a third gate layer e formed subsequently.

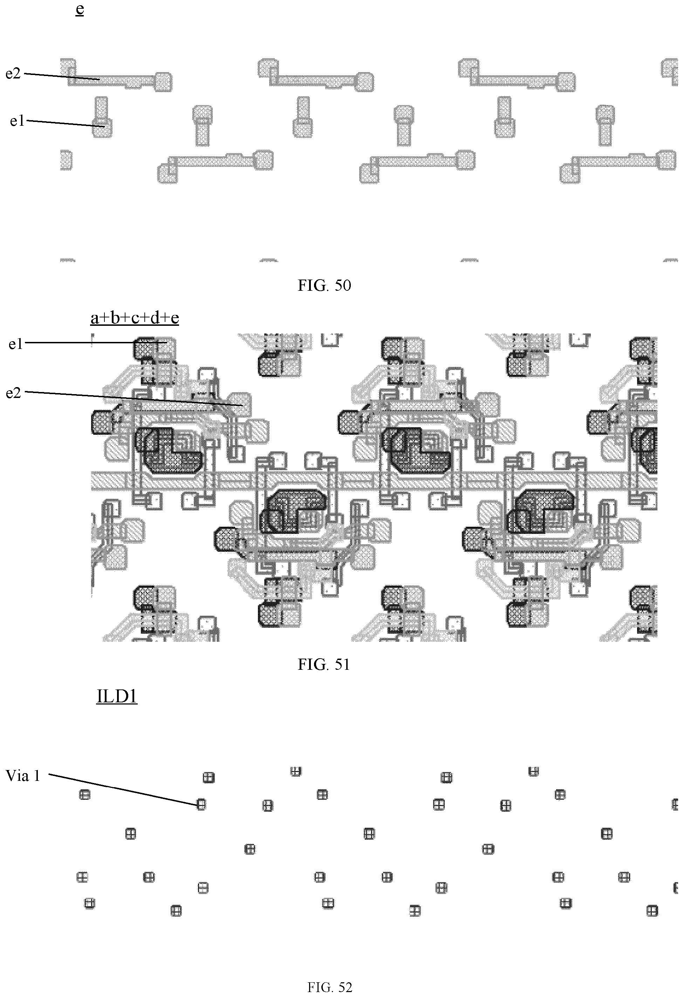

FIG. 50 is a partial schematic diagram of a third gate layer in another display panel according to some embodiments of the present disclosure; and FIG. 51 is a partial schematic diagram of superposition of an active layer, a first gate layer, a second gate layer, an oxide layer, and a third gate layer in another display panel according to some embodiments of the present disclosure.

As shown in FIG. 50 and FIG. 51, the third gate layer e includes:
a top gate pattern e1 of the first transistor T1, wherein the top gate pattern e1 is also used as a portion of the first reset signal line Preset that is disposed in the third gate layer e; and
a top gate pattern e2 of the second transistor T2, wherein the top gate pattern e2 is also used as a portion of the first gate signal line Gate_N that is disposed in the third gate layer e.

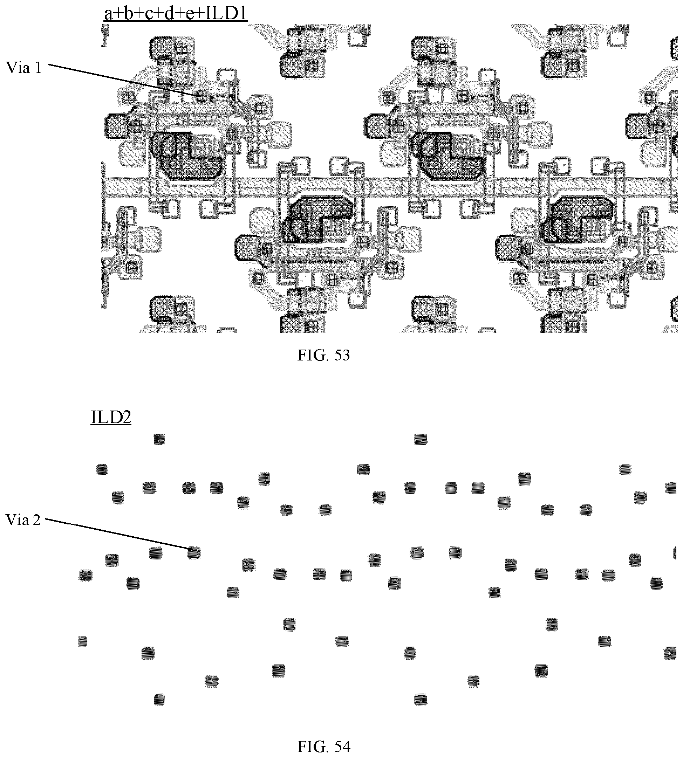

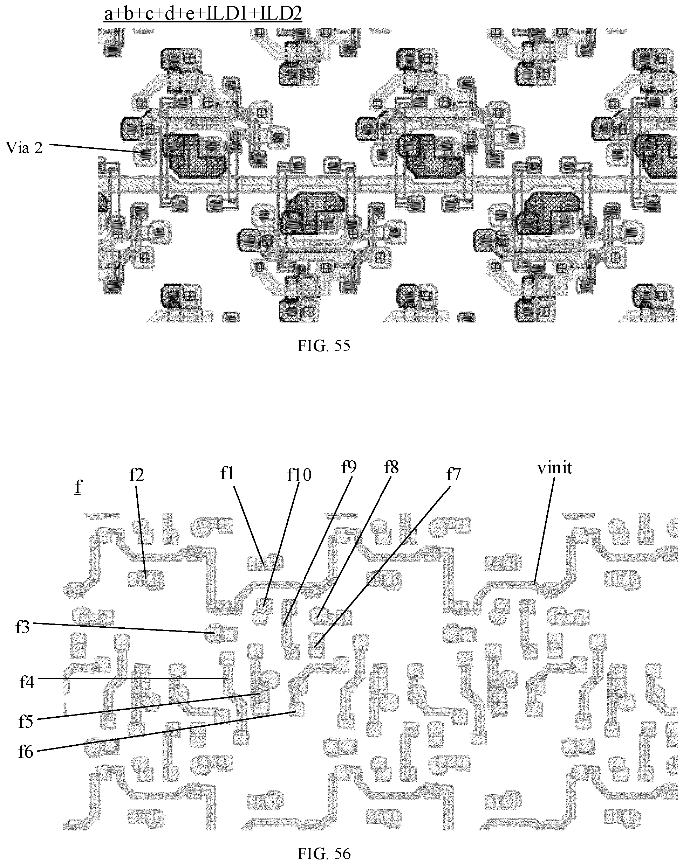

Additionally, two interlayer dielectric layers are formed on the second gate layer c for insulating the third gate layer e from the first source-drain layer f formed subsequently. FIG. 52 is a partial schematic diagram of a first interlayer dielectric layer in another display panel according to some embodiments of the present disclosure. FIG. 53 is a partial schematic diagram of superposition of an active layer, a first gate layer, a second gate layer, an oxide layer, a third gate layer, and a first interlayer dielectric layer in another display panel according to some embodiments of the present disclosure. FIG. 54 is a partial schematic diagram of a second interlayer dielectric layer in another display panel according to some embodiments of the present disclosure. FIG. 55 is a partial schematic diagram of superposition of an active layer, a first gate layer, a second gate layer, an oxide layer, a third gate layer, a first interlayer dielectric layer, and a second interlayer dielectric layer in another display panel according to some embodiments of the present disclosure.

For an illustration of vias 1 in the first interlayer dielectric layer ILD1 and vias 2 in the second interlayer dielectric layer ILD2, fill patterns are used to represent the vias in FIG. 52 to FIG. 55. Other regions without a fill pattern represent the regions of the interlayer dielectric layers where materials are provided. It should be noted that the vias formed in each of the interlayer dielectric layers are configured to connect the film layers formed subsequently and the film layer on the side of the interlayer dielectric layer close to the base substrate 101. That is, the vias are used for connecting film layers.

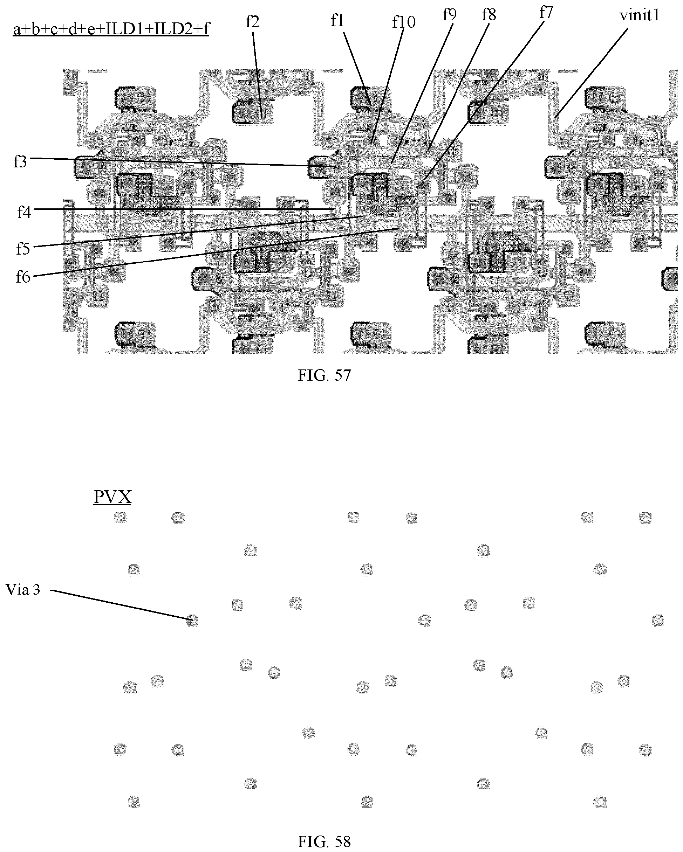

FIG. 56 is a partial schematic diagram of a first source-drain layer in another display panel according to some embodiments of the present disclosure; and FIG. 57 is a partial schematic diagram of superposition of an active layer, a first gate layer, a second gate layer, an oxide layer, a third gate layer, a first interlayer dielectric layer, a second interlayer dielectric layer, and a first source-drain layer in another display panel according to some embodiments of the present disclosure.

As shown in FIG. 56 and FIG. 57, the first source-drain layer f includes:
a first reset power line vinit1, wherein the first reset power line vini,1 implements signal transmission directly through the first source-drain layer f, without the need to design lap holes in the trace layer, which facilitates the arrangement of other signal lines. Moreover, as the resistance of the first source-drain layer f is smaller than the resistance of the trace layer, the resistance of the first reset power line vinit1 is smaller in this case, which can improve the picture uniformity of the display panel;
a first source-drain pattern f1, wherein the first source-drain pattern f1 is connected to the bottom gate pattern c1 disposed in the second gate layer c and the top gate pattern e1 disposed in the third gate layer e in the first transistor T1 in the first pixel circuit 1021;
a second source-drain pattern f2, wherein the second source-drain pattern f2 is connected to the bottom gate pattern c1 disposed in the second gate layer c and the top gate pattern e1 disposed in the third gate layer e in the first transistor T1 in the second pixel circuit 1022;
a third source-drain pattern f3, wherein the third source-drain pattern f3 is connected to the bottom gate pattern c2 of the second transistor T2 disposed in the second gate layer c and the top gate pattern e2 of the second transistor T2 disposed in the third gate layer e;
a fourth source-drain pattern f4, wherein the fourth source-drain pattern f4 is connected to the gate layer pattern b1 of the second gate signal line Gate_P disposed in the first gate layer b in the first pixel circuit 1021 and the gate layer pattern b1 of the second gate signal line Gate_P disposed in the first gate layer b in the second pixel circuit 1022. That is, the signals from the second gate signal line Gate_P achieve lapping simply through the first source-drain layer f, without the need to design a lap hole in the trace layer. This design can improve the transmittance partially, the most important is that the second gate signal line Gate_P implements signal transmission totally through the first gate layer and the first source-drain layer, without the need to adopt the trace layer with a big resistance. Thus, the resistance of the second gate signal line Gate_P can be greatly reduced, and the requirement of a high refresh rate is satisfied. Although the projections of the second gate signal line Gate_P and the light-emitting control signal line EM are overlapped, there is no overlap of the pulses of the signals from the second gate signal line Gate_P and the light-emitting control signal line EM (the pulses of the light-emitting control signal line EM always wrap around the pulses of the second gate signal line Gate_P), and thus there is only small interference;
a fifth source-drain pattern f5, wherein the fifth source-drain pattern f5 is connected to the first electrode of the third transistor T3 and the second electrode of the fifth transistor T5, the first electrode of the third transistor T3 and the second electrode of the fifth transistor T5 are both connected to the first node N1, and the fifth source-drain pattern f5 is further connected to the first electrode of the fifth transistor T5 and the driving power line VDD in the second trace layer h;
a sixth source-drain pattern f6, wherein the sixth source-drain pattern f6 is connected to the second electrode of the sixth transistor T6 and the second electrode of the seventh transistor T7, and the second electrode of the sixth transistor T6 and the second electrode of the seventh transistor T7 are both connected to an anode layer of a light-emitting unit subsequently formed;
a seventh source-drain pattern f7, wherein the seventh source-drain pattern f7 is connected to the first electrode of the second transistor T2 and the first electrode of the sixth transistor T6, and the first electrode of the second transistor T2 and the first electrode of the sixth transistor T6 are both connected to the third node N3,
an eighth source-drain pattern f8, wherein the eighth source-drain pattern f8 is connected to a gate layer pattern of the first gate signal line Gate_N that is disposed in the third gate layer e (the top gate pattern of the second transistor T2) and a pattern of the first trace layer g formed subsequently;
a ninth source-drain pattern f9, wherein the ninth source-drain pattern f9 is connected to the second electrode of the second transistor T2 and the gate of the third transistor T3, and the second electrode of the second transistor T2 and the gate of the third transistor T3 are both connected to the second node N2; and
a tenth source-drain pattern f10, wherein the tenth source-drain pattern f10 is connected to the first electrode of the fourth transistor T4 and a data signal line Data in the second trace layer formed subsequently.

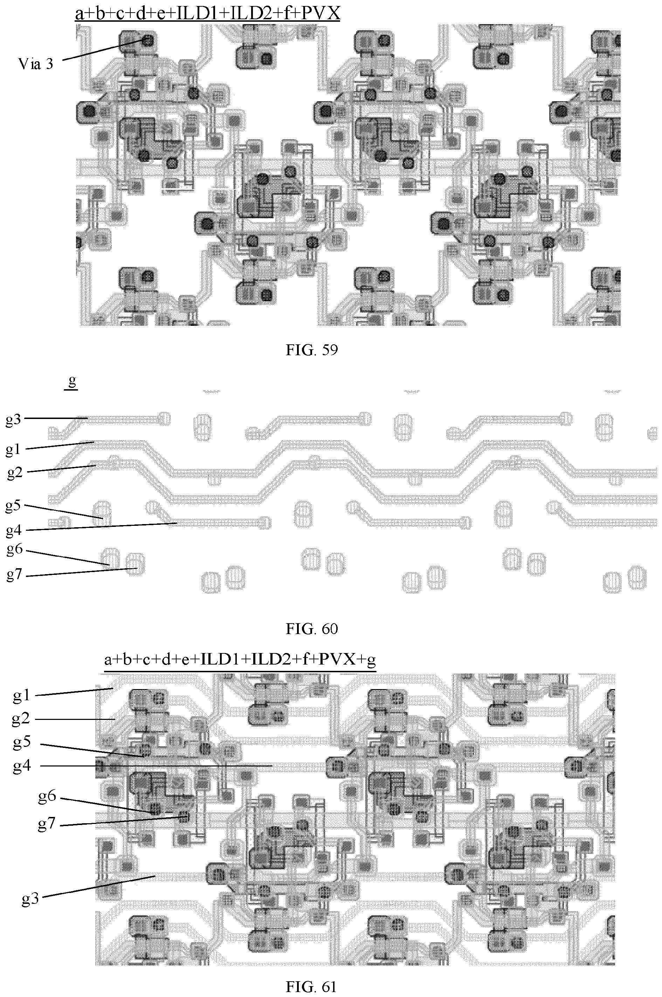

Additionally, a passivation layer is formed on the first source-drain layer f for insulating the first source-drain layer f from the first trace layer g formed subsequently. FIG. 58 is a partial schematic diagram of a passivation layer in another display panel according to some embodiments of the present disclosure. FIG. 59 is a partial schematic diagram of superposition of an active layer, a first gate layer, a second gate layer, an oxide layer, a third gate layer, a first interlayer dielectric layer, a second interlayer dielectric layer, a first source-drain layer, and a passivation layer in another display panel according to some embodiments of the present disclosure.

For an illustration of vias 3 in the passivation layer, fill patterns are used to represent the vias in FIG. 58 and FIG. 59. Other regions without a fill pattern represent the regions of the passivation layer where materials are provided. It should be noted that the vias formed in passivation layer are configured to connect the film layers formed subsequently and the film layer on the side of the passivation layer close to the base substrate 101. That is, the vias are used for connecting film layers.

FIG. 60 is a partial schematic diagram of a first trace layer in another display panel according to some embodiments of the present disclosure; and FIG. 61 is a partial schematic diagram of superposition of an active layer, a first gate layer, a second gate layer, an oxide layer, a third gate layer, a first interlayer dielectric layer, a second interlayer dielectric layer, a first source-drain layer, a passivation layer, and a first trace layer in another display panel according to some embodiments of the present disclosure.

As shown in FIG. 60 and FIG. 61, the first trace layer g includes:
a first trace pattern g1, wherein the first trace pattern g1 is a pattern of the first reset signal line Preset for connecting the plurality of second pixel circuits 1022;
a second trace pattern g2, wherein the second trace pattern g2 is a pattern of the first reset signal line Preset for connecting the plurality of first pixel circuits 1021;
a third trace pattern g3, wherein the third trace pattern g3 is a trace layer pattern of the first gate signal line Gate_N of the second pixel circuit 1022;
a fourth trace pattern g4, wherein the fourth trace pattern g4 is a trace layer pattern of the first gate signal line Gate_N of the first pixel circuit 1021;
a fifth trace pattern g5, wherein the fifth trace pattern g5 is connected to the first electrode of the fourth transistor T4 and a data signal line Data in the second trace layer h formed subsequently;
a sixth trace pattern g6, wherein the sixth trace pattern g6 is connected to the first electrode of the fifth transistor T5 and the portion of the driving power line VDD that is disposed in the second trace layer h; and
a seventh trace pattern g7, wherein the seventh trace pattern g7 is connected to the sixth transistor T6 and the anode layer of the light-emitting unit formed subsequently.

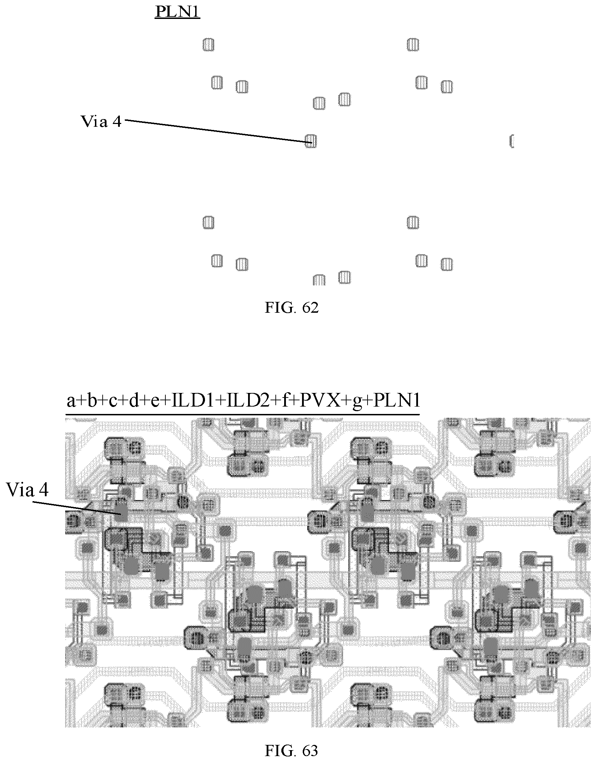

Additionally, a first planarization layer is formed on the first trace layer g for insulating the first trace layer g from the second trace layer h formed subsequently. FIG. 62 is a partial schematic diagram of a first planarization layer in another display panel according to some embodiments of the present disclosure. FIG. 63 is a partial schematic diagram of superposition of an active layer, a first gate layer, a second gate layer, an oxide layer, a third gate layer, a first interlayer dielectric layer, a second interlayer dielectric layer, a first source-drain layer, a passivation layer, a first trace layer, and a first planarization layer in another display panel according to some embodiments of the present disclosure.

For an illustration of vias 4 in the first planarization layer, fill patterns are used to represent the vias in FIG. 62 and FIG. 63. Other regions without a fill pattern represent the regions of the first planarization layer where materials are provided. It should be noted that the vias formed in the first planarization layer are configured to connect the film layers formed subsequently and the film layer on the side of the first planarization layer close to the base substrate 101. That is, the vias are used for connecting film layers.

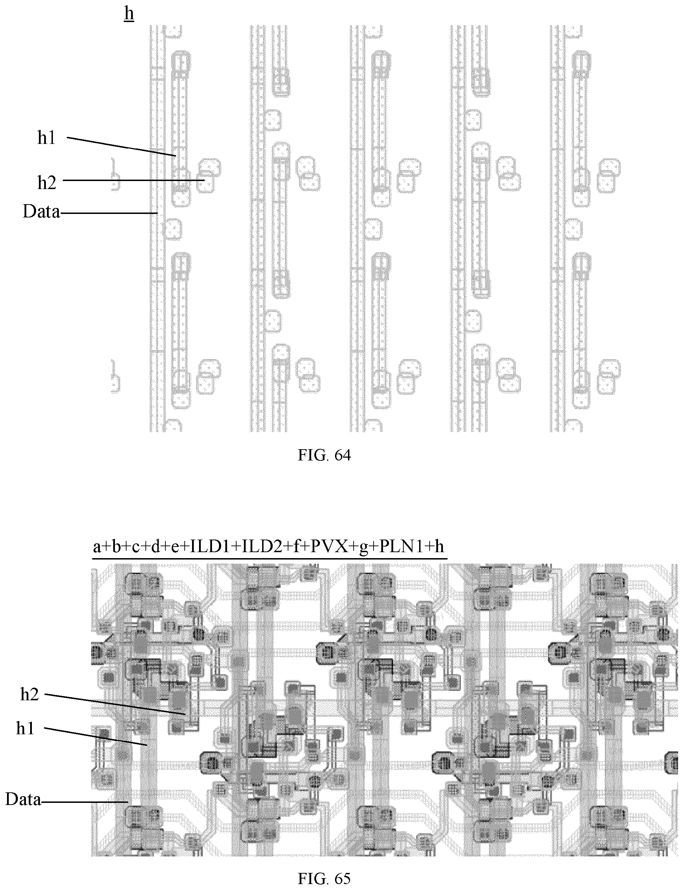

FIG. 64 is a partial schematic diagram of a second trace layer in another display panel according to some embodiments of the present disclosure; and FIG. 65 is a partial schematic diagram of superposition of an active layer, a first gate layer, a second gate layer, an oxide layer, a third gate layer, a first interlayer dielectric layer, a second interlayer dielectric layer, a first source-drain layer, a passivation layer, a first trace layer, a first planarization layer, and a second trace layer in another display panel according to some embodiments of the present disclosure. As shown in FIG. 64 and FIG. 65, the second trace layer h includes a data signal line Data, a pattern h1 of the driving power line VDD that is disposed in the second trace layer h, and a pattern h2 connected to the anode layer of the light-emitting unit.

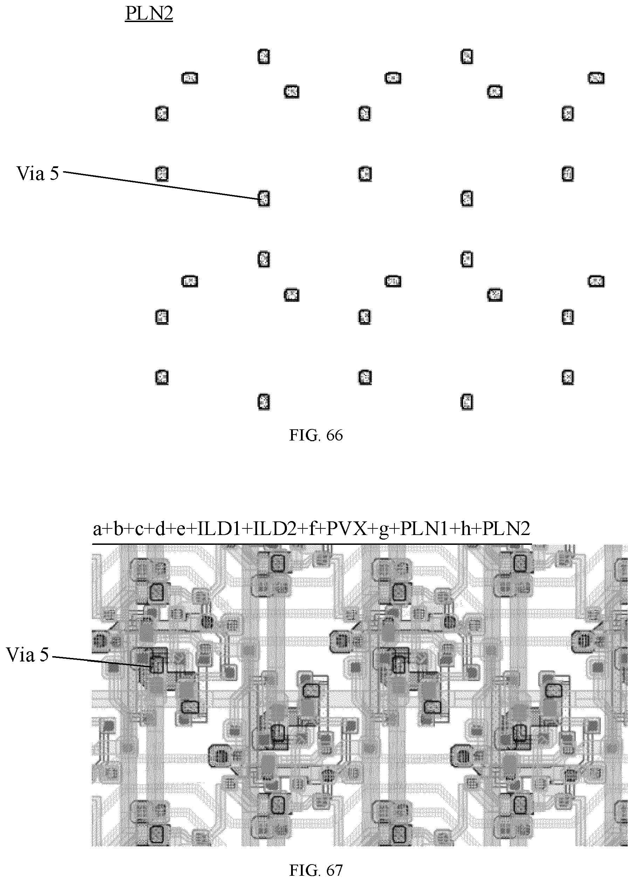

Additionally, a second planarization layer is formed on the second trace layer h for insulating the second trace layer h from a second source-drain layer i formed subsequently. FIG. 66 is a partial schematic diagram of a second planarization layer in another display panel according to some embodiments of the present disclosure. FIG. 67 is a partial schematic diagram of superposition of an active layer, a first gate layer, a second gate layer, an oxide layer, a third gate layer, a first interlayer dielectric layer, a second interlayer dielectric layer, a first source-drain layer, a passivation layer, a first trace layer, a first planarization layer, a second trace layer, and a second planarization layer in another display panel according to some embodiments of the present disclosure.

For an illustration of vias 5 in the first planarization layer, fill patterns are used to represent the vias in FIG. 66 and FIG. 67. Other regions without a fill pattern represent the regions of the second planarization layer where materials are provided. It should be noted that the vias formed in the second planarization layer are configured to connect the film layers formed subsequently and the film layer on the side of the second planarization layer close to the base substrate 101. That is, the vias are used for connecting film layers.

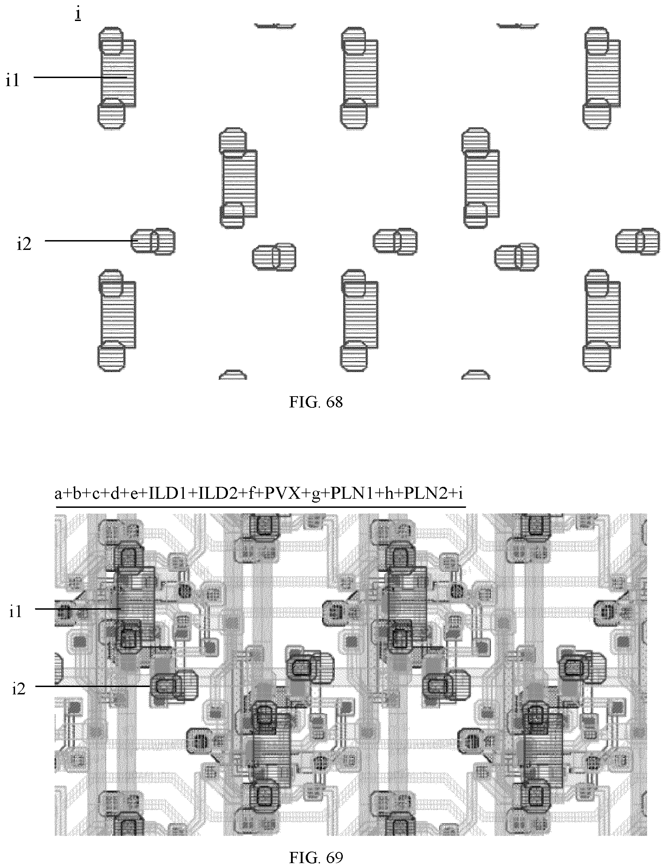

FIG. 68 is a partial schematic diagram of a second source-drain layer in another display panel according to some embodiments of the present disclosure; and FIG. 69 is a partial schematic diagram of superposition of an active layer, a first gate layer, a second gate layer, an oxide layer, a third gate layer, a first interlayer dielectric layer, a second interlayer dielectric layer, a first source-drain layer, a passivation layer, a first trace layer, a first planarization layer, a second trace layer, a second planarization layer, and a second source-drain layer in another display panel according to some embodiments of the present disclosure. As shown in FIG. 68 and FIG. 69, the second source-drain layer i includes an eleventh source-drain pattern i1 and a twelfth source-drain pattern i2. The eleventh source-drain pattern i1 is a pattern of the driving power line VDD that is disposed in the second source-drain layer i, and the eleventh source-drain pattern i1 is connected to the pattern h1 of the driving power line VDD that is disposed in the second trace layer h through a via in the second planarization layer. The twelfth source-drain pattern i2 is connected to the anode layer of the light-emitting unit, and is connected to the pattern h2 disposed in the second electrode layer through a via in the second planarization layer.

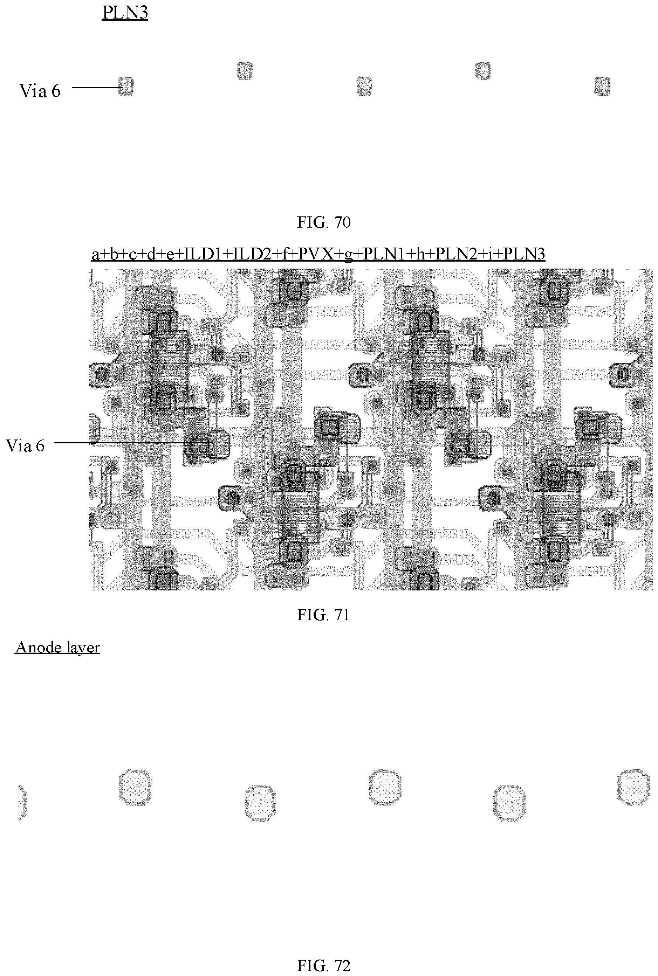

Additionally, a third planarization layer is formed on the second source-drain layer i for insulating the second source-drain layer i from the anode layer of the light-emitting unit formed subsequently. FIG. 70 is a partial schematic diagram of a third planarization layer in another display panel according to some embodiments of the present disclosure. FIG. 71 is a partial schematic diagram of superposition of an active layer, a first gate layer, a second gate layer, an oxide layer, a third gate layer, a first interlayer dielectric layer, a second interlayer dielectric layer, a first source-drain layer, a passivation layer, a first trace layer, a first planarization layer, a second trace layer, a second planarization layer, a first source-drain layer, and a third planarization layer in another display panel according to some embodiments of the present disclosure.

For an illustration of vias 6 in the third planarization layer, fill patterns are used to represent the vias in FIG. 70 and FIG. 71. Other regions without a fill pattern represent the regions of the third planarization layer where materials are provided. It should be noted that the vias formed in the third planarization layer are configured to connect the film layers formed subsequently and the film layer on the side of the third planarization layer close to the base substrate 101. That is, the vias are used for connecting film layers.

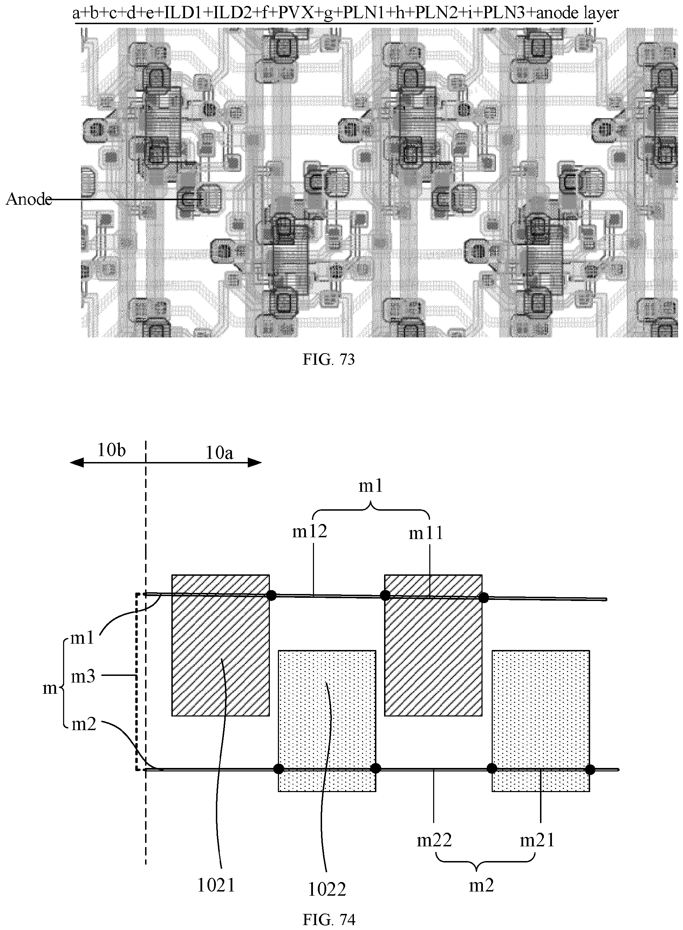

FIG. 72 is a partial schematic diagram of an anode layer in another display panel according to some embodiments of the present disclosure; and FIG. 73 is a partial schematic diagram of superposition of an active layer, a first gate layer, a second gate layer, an oxide layer, a third gate layer, a first interlayer dielectric layer, a second interlayer dielectric layer, a first source-drain layer, a passivation layer, a first trace layer, a first planarization layer, a second trace layer, a second planarization layer, a second source-drain layer, a third planarization layer, and an anode layer in another display panel according to some embodiments of the present disclosure. As shown in FIG. 72 and FIG. 73, the anode layer of the light-emitting unit is connected to the twelfth source-drain pattern i2 of the second source-drain layer i through the via 6 in the third passivation layer. The various patterns shown in FIG. 72 and FIG. 73 are only intended to illustrate the position of the anode layer, but do not represent the actual shape of the anode layer.

In the above two implementations, referring to FIG. 74, each target signal line m in the display panel 10 includes a first sub-signal line m1, a second sub-signal line m2, and a second connection trace m3. The target signal line m is a signal line providing signals along the second direction Y other than the first signal line 103, the second signal line 104, and the third signal line 106 in the display panel 10. For example, in the first implementation, the target signal line m includes the first gate signal line Gate_N, the second gate signal line Gate_P, the first reset signal line Preset, and the second reset signal line Preset_H. In the second implementation, the target signal line m includes the first reset signal line Preset and the first gate signal line Gate_N.

The first sub-signal line m1 is disposed in the first display region 10a, and the first sub-signal line m1 is connected to a plurality of first pixel circuits 1021 in one pixel circuit group 102. The second sub-signal line m2 is disposed in the first display region 10a, and the second sub-signal line m2 is connected to a plurality of second pixel circuits 1022 in one pixel circuit group 102. The plurality of second pixel circuits 1022 connected to the second sub-signal line m2 of each target signal line m and the plurality of first pixel circuits 1021 connected to the first sub-signal line m1 of the target signal line m belong to the same pixel circuit group 102. The second connection trace m3 is disposed in the second display region 10b, one end of the second connection trace m3 is connected to the first sub-signal line m1, and the other end of the second connection trace m3 is connected to the second sub-signal line m2. That is, the first sub-signal line m1 and the second sub-signal line m2 are connected by the second connection trace m3. Therefore, the signals provided by the first sub-signal line m1 for the plurality of first pixel circuits 1021 in the pixel circuit group 102 are the same as the signals provided by the second sub-signal line m2 for the plurality of second pixel circuits 1022 in the pixel circuit group 102.

Optionally, the first sub-signal line m1 includes a fourth portion m11 and a fifth portion m12 that are connected. An orthographic projection of the fourth portion m11 on the base substrate 101 is at least partially overlapped with an orthographic projection of the first pixel circuit 1021 on the base substrate 101, and an orthographic projection of the fifth portion m12 on the base substrate 101 is between an orthographic projections of two adjacent first pixel circuits 1021 on the base substrate 101. The second sub-signal line m2 includes a sixth portion m21 and a seventh portion m22 that are connected. An orthographic projection of the sixth portion m21 on the base substrate 101 is at least partially overlapped with an orthographic projection of the second pixel circuit 1022 on the base substrate 101, and an orthographic projection of the seventh portion m22 on the base substrate 101 is between the orthographic projections of two adjacent second pixel circuits 1022 on the base substrate 101.

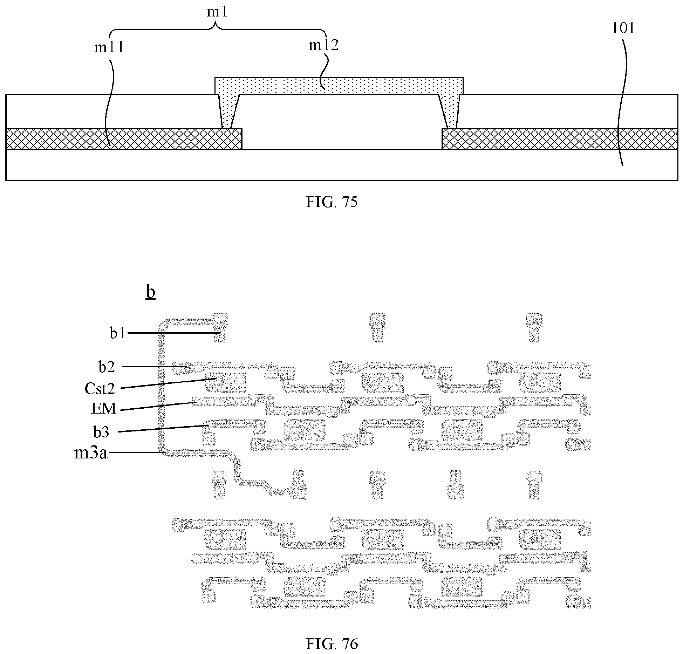

The fourth portion m11 and the sixth portion m21 are disposed in the same layer, and the fourth portion m11 and the sixth portion m21 are disposed in a metal layer, e.g., a gate layer or a source-drain layer. The fifth portion m12 and the seventh portion m22 are disposed in the same layer, and the fifth portion m12 and the seventh portion m22 are disposed in a trace layer, e.g., the first trace layer g. Therefore, referring to FIG. 75, the fourth portion m11 and the fifth portion m12 are connected through a via in the insulating layer therebetween. Similarly, the sixth portion m21 and the seventh portion m22 are connected through a via in the insulating layer therebetween.

Exemplarily, in the case that the target signal line m is the first gate signal line Gate_N, the fourth portion m11 and the sixth portion m21 are both disposed in the second gate layer c and the third gate layer e, and the fifth portion m12 and the seventh portion m22 are disposed in the first trace layer g. In this case, the insulating layer between the fourth portion m11 and the fifth portion m12 and the insulating layer between the sixth portion m21 and the seventh portion m22 both include the first interlayer dielectric layer ILD1, the second interlayer dielectric layer ILD2, and the passivation layer PVX.

In the case that the target signal line m is the second gate signal line Gate_P or the second reset signal line Preset_H, the fourth portion m11 and the sixth portion m21 are both disposed in the first gate layer b, and the fifth portion m12 and the seventh portion m22 are disposed in the first trace layer g. In this case, the insulating layer between the fourth portion m11 and the fifth portion m12 and the insulating layer between the sixth portion m21 and the seventh portion m22 both include the second gate insulating layer G2, the third gate insulating layer G3, the fourth gate insulating layer G4, the first interlayer dielectric layer ILD1, the second interlayer dielectric layer ILD2, and the passivation layer PVX.

Alternatively, the first sub-signal line m1 and the second sub-signal line m2 of the target signal line m are both disposed in a trace layer and do not include portions disposed in the metal layer. For example, the first sub-signal line m1 and the second sub-signal line m2 are both disposed in the first trace layer g, e.g., the first trace pattern g1 and the second trace pattern g2 of the first trace layer g in the first implementation.

It is noted that the second connection trace m3 may be disposed in a metal layer or in a trace layer, which is not limited in the embodiments of the present disclosure, as long as the first sub-signal line m1 and the second sub-signal line m2 can be connected.

For a clear illustration of the various film layers at the location of the second connection trace (the region, close to the first display region 10a, of the second display region 10b, which is referred to as an FDC transition region), the various film layers at the location of the second connection trace in the case that the pixel circuit includes eight transistors are introduced by describing each layer and a step-by-step stacking of layers.

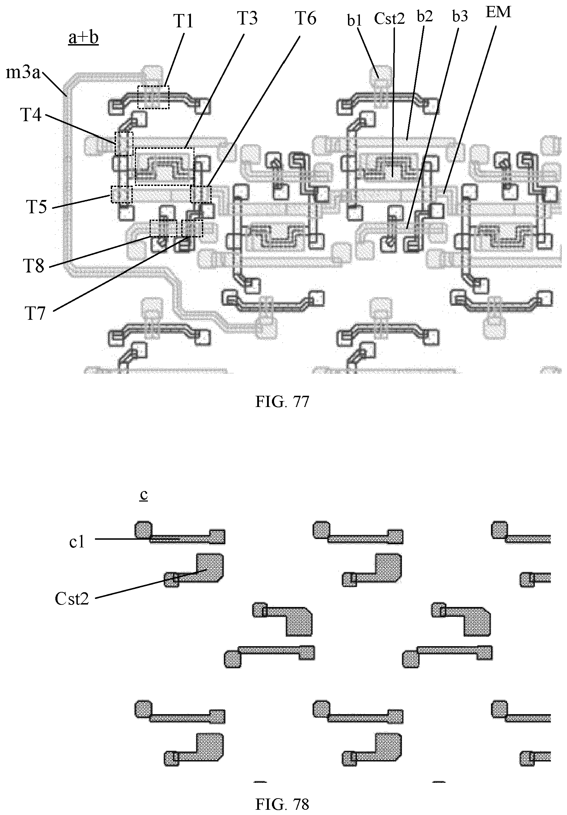

FIG. 76 is a partial schematic diagram of a first gate layer in yet another display panel according to some embodiments of the present disclosure. FIG. 77 is a partial schematic diagram of superposition of an active layer and a first gate layer in yet another display panel according to some embodiments of the present disclosure. Referring to FIG. 76 and FIG. 77, the first gate layer b further includes a second connection trace m3a, in addition to the patterns shown in FIG. 9 and FIG. 10. One end of the second connection trace m3a is connected to the gate layer pattern b1 of the first reset signal line Preset connected to the first transistor T1 in the first pixel circuit, and the other end of the second connection trace m3a is connected to the gate layer pattern b1 of the first reset signal line Preset connected to the first transistor T1 in the second pixel circuit.

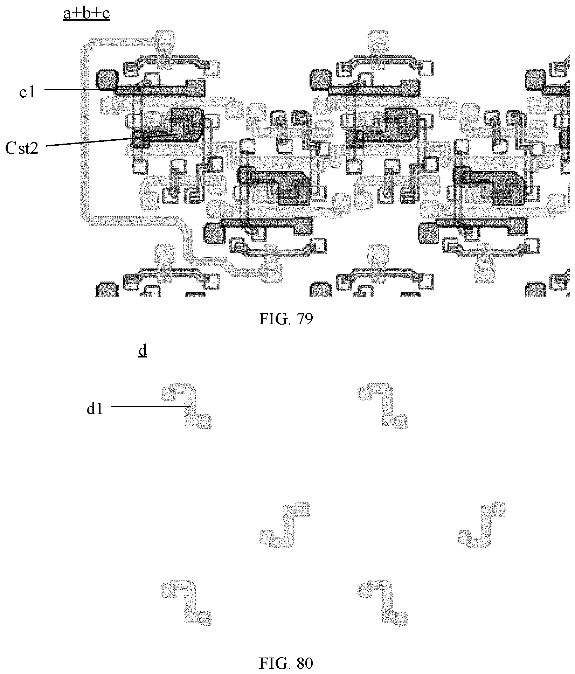

FIG. 78 is a partial schematic diagram of a second gate layer in yet another display panel according to some embodiments of the present disclosure. FIG. 79 is a partial schematic diagram of superposition of the active layer, the first gate layer, and the second gate layer in yet another display panel according to some embodiments of the present disclosure. Referring to FIG. 78 and FIG. 79, the design of the second gate layer c is the same as that shown in FIG. 11 and FIG. 12, and details are not repeated herein.

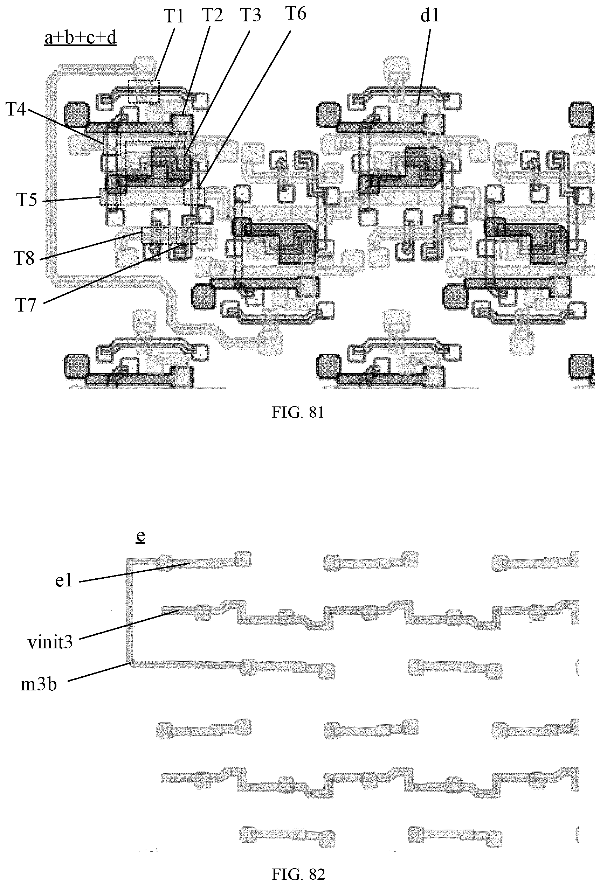

FIG. 80 is a partial schematic diagram of an oxide layer in yet another display panel according to some embodiments of the present disclosure. FIG. 81 is a partial schematic diagram of superposition of an active layer, a first gate layer, a second gate layer, and an oxide layer in yet another display panel according to some embodiments of the present disclosure. Referring to FIG. 78 and FIG. 79, the design of the second gate layer c is the same as that shown in FIG. 13 and FIG. 14, and details are not repeated herein.

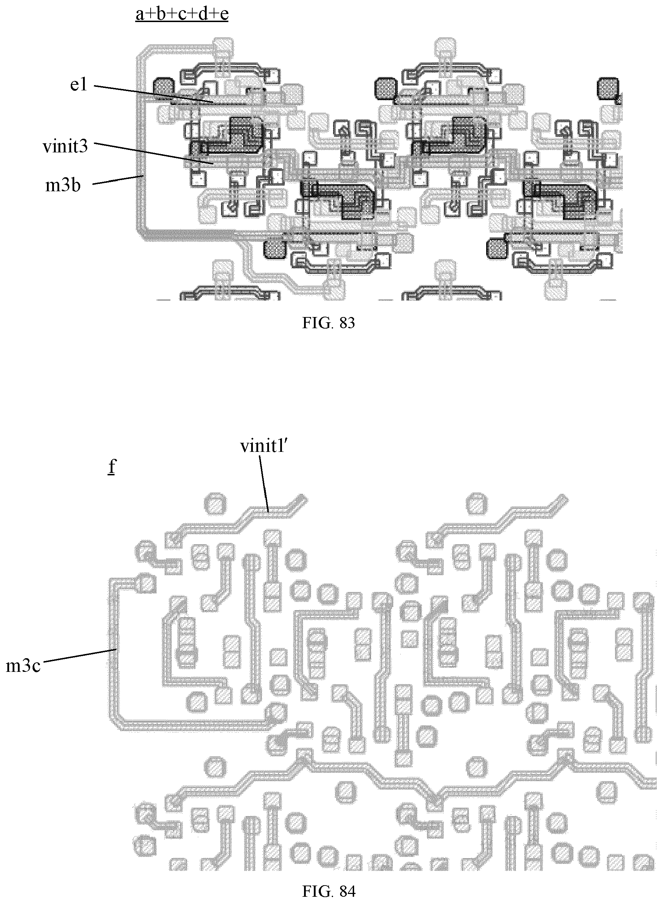

FIG. 82 is a partial schematic diagram of a third gate layer in yet another display panel according to some embodiments of the present disclosure. FIG. 83 is a partial schematic diagram of superposition of an active layer, a first gate layer, a second gate layer, an oxide layer, and a third gate layer in yet another display panel according to some embodiments of the present disclosure. Referring to FIG. 82 and FIG. 83, the third gate layer e further includes a second connection trace m3b, in addition to the patterns shown in FIG. 15 and FIG. 16. One end of the second connection trace m3b is connected to the top gate pattern e1 of the second transistor T2 in the first pixel circuit, and the other end of the second connection trace m3b is connected to the top gate pattern e1 of the second transistor T2 in the second pixel circuit. The second connection trace m3b serves as a portion of the first gate signal line Gate_N.

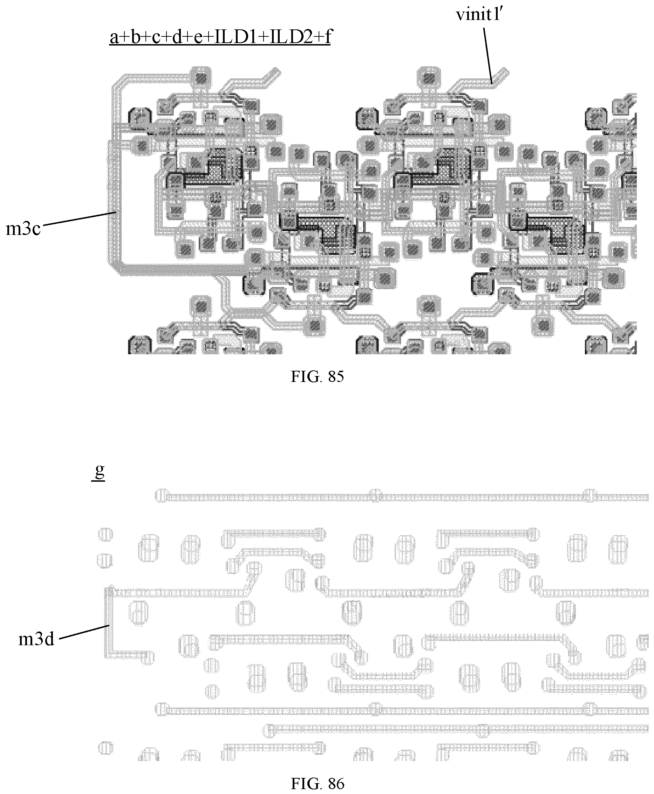

FIG. 84 is a partial schematic diagram of a first source-drain layer in yet another display panel according to some embodiments of the present disclosure. FIG. 85 is a partial schematic diagram of superposition of an active layer, a first gate layer, a second gate layer, an oxide layer, a third gate layer, a first interlayer dielectric layer, a second interlayer dielectric layer, and a first source-drain layer in yet another display panel according to some embodiments of the present disclosure. Referring to FIG. 84 and FIG. 85, the first source-drain layer f further includes a second connection trace m3c, in addition to the patterns shown in FIG. 21 and FIG. 22. One end of the second connection trace m3c is connected to the gate layer pattern b2 of the second gate signal line Gate_P in the first pixel circuit, and the other end of the second connection trace m3c is connected to the gate layer pattern b2 of the second gate signal line Gate_P in the second pixel circuit. As the gate layer pattern b2 is disposed in the first gate layer b and the second connection trace m3c is disposed in the first source-drain layer f, the second connection trace m3 and the gate layer pattern b2 are connected through a via in the insulating layer therebetween.

Additionally, the reason why the first reset power line vinit1' shown in FIG. 84 and FIG. 85 is a short line is that the first reset power line vinit1' is a first reset power line in a portion of the first display region 10a closest to the second display region 10b, and the first reset power line vinit1' may be directly connected to the first connection trace 105.

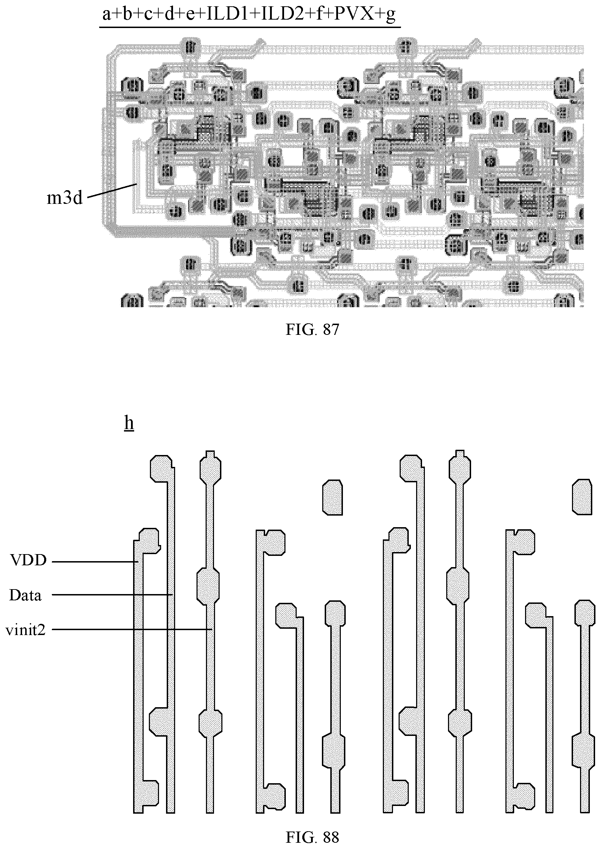

FIG. 86 is a partial schematic diagram of a first trace layer in yet another display panel according to some embodiments of the present disclosure. FIG. 87 is a partial schematic diagram of superposition of an active layer, a first gate layer, a second gate layer, an oxide layer, a third gate layer, a first interlayer dielectric layer, a second interlayer dielectric layer, a first source-drain layer, and a first trace layer in yet another display panel according to some embodiments of the present disclosure. Referring to FIG. 86 and FIG. 87, the first trace layer g further includes a second connection trace m3d, in addition to the patterns shown in FIG. 25 and FIG. 26. One end of the second connection trace m3d is connected to the gate layer pattern b3 of the second reset signal line Preset_H in the first pixel circuit, and the other end of the second connection trace m3d is connected to the gate layer pattern b3 of the second reset signal line Preset_H in the second pixel circuit. As the gate layer pattern b3 is disposed in the first gate layer b, and the second connection trace m3d is disposed in the first trace layer g, the second connection trace m3d and the gate layer pattern b3 are connected through a via in the insulating layer therebetween.

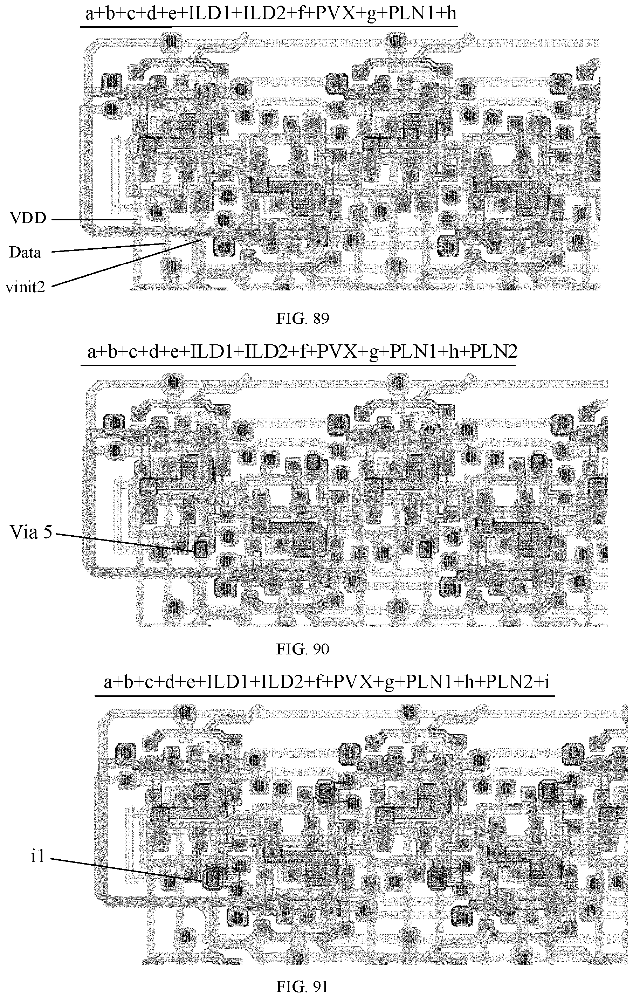

FIG. 88 is a partial schematic structural diagram of a second trace layer according to some embodiments of the present disclosure. FIG. 89 is a partial schematic diagram of superposition of an active layer, a first gate layer, a second gate layer, an oxide layer, a third gate layer, a first interlayer dielectric layer, the second interlayer dielectric layer, the first source-drain layer, the first trace layer, a first planarization layer, and a second trace layer in yet another display panel according to some embodiments of the present disclosure. Referring to FIG. 88 and FIG. 89, the design of the second trace layer h is the same as that shown in FIG. 29 and FIG. 30, and details are not repeated herein.

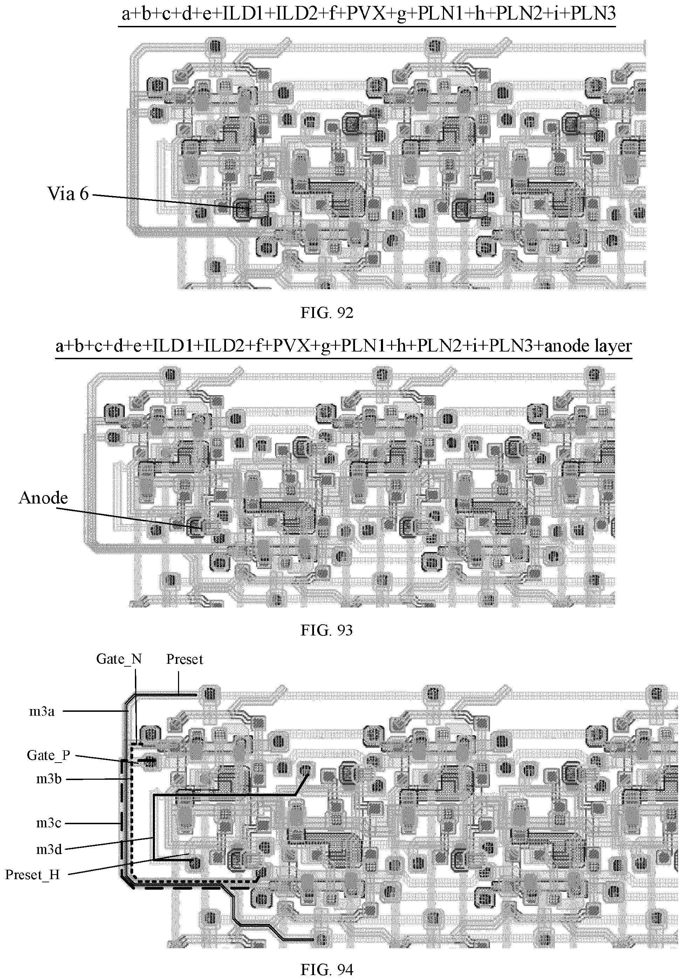

FIG. 90 is a partial schematic diagram of superposition of an active layer, a first gate layer, a second gate layer, an oxide layer, a third gate layer, a first interlayer dielectric layer, a second interlayer dielectric layer, a first source-drain layer, a first trace layer, a first planarization layer, a second trace layer, and a second planarization layer in yet another display panel according to some embodiments of the present disclosure. FIG. 91 is a partial schematic diagram of superposition of an active layer, a first gate layer, a second gate layer, an oxide layer, a third gate layer, a first interlayer dielectric layer, a second interlayer dielectric layer, a first source-drain layer, a first trace layer, a first planarization layer, a second trace layer, a second planarization layer, and a second source-drain layer in yet another display panel according to some embodiments of the present disclosure. FIG. 92 is a partial schematic diagram of superposition of an active layer, a first gate layer, a second gate layer, an oxide layer, a third gate layer, a first interlayer dielectric layer, a second interlayer dielectric layer, a first source-drain layer, a first trace layer, a first planarization layer, a second trace layer, a second planarization layer, a second source-drain layer, and a third planarization layer in yet another display panel according to some embodiments of the present disclosure. FIG. 93 is a partial schematic diagram of superposition of an active layer, a first gate layer, a second gate layer, an oxide layer, a third gate layer, a first interlayer dielectric layer, a second interlayer dielectric layer, a first source-drain layer, a first trace layer, a first planarization layer, a second trace layer, a second planarization layer, a second source-drain layer, a third planarization layer, and an anode layer in yet another display panel according to some embodiments of the present disclosure. Referring to FIG. 90 to FIG. 93, the designs of the second planarization layer PLN2, the second trace layer i, the third second planarization layer PLN3 and the anode layer are the same as those described in the first implementation, and details are not repeated herein.

In combination with FIG. 76 to FIG. 94, a first target signal line is the first reset signal line Preset. The first sub-signal line m1 and the second sub-signal line m2 of the first reset signal line Preset both do not include a portion disposed in the metal layer, but are both disposed in the first trace layer g. The second connection trace m3a of the first reset signal line Preset is disposed in the first gate layer. A second target signal line is the first gate signal line Gate_N, and the second connection trace m3b of the first gate signal line Gate_N is disposed in the third gate layer. A third target signal line is the second gate signal line Gate_P, and the second connection trace m3c of the second gate signal line Gate_P is disposed in the first source-drain layer. A fourth target signal line is the second reset signal line Preset_H, and the second connection trace m3d of the second reset signal line Preset_H is disposed in the first trace layer g.

It should be noted that the second connection traces m3 of different target signal lines may also be designed in other ways, which is not limited in the embodiments of the present disclosure.

Referring to FIG. 7, the display panel 10 further includes an anode layer 1071, a pixel definition layer (PDL) 1072, a light-emitting layer 1073, and a cathode layer 1074 that constitute the light-emitting unit 107 and are stacked sequentially in the direction away from the base substrate 101. The anode layer 1071 of each light-emitting unit is connected to at least one pixel circuit. The pixel definition layer has a plurality of hollowed-out regions, and each hollowed-out region exposes the anode layer of one light-emitting unit.

It should be noted that the display panel 10 further includes a pixel circuit group disposed in the second display region 10b, and the pixel circuit group in the second display region 10b further includes a plurality of first pixel circuits and a plurality of second pixel circuits.

The second display region 10b is the same as the first display region 10a in that the plurality of first pixel circuits and the plurality of second pixel circuits are offset in the first direction X, and the plurality of first pixel circuits and the plurality of second pixel circuits are staggered.

The second display region 10b is different from the first display region 10a in that the plurality of first pixel circuits and the plurality of second pixel circuits in the second display region 10b are arranged in the same direction. Moreover, there is no need to provide an optical sensor in the second display region 10b, and thus the second display region 10b has a lower transmittance requirement than the first display region 10a. Therefore, the signal lines in the second display region 10b can implement signal transmission using a metal layer, without the need to cross layers using a trace layer.

In the embodiments of the present disclosure, the first trace layer g and the second trace layer h are both made of conductive and transparent materials, such as indium tin oxide (ITO). The first trace layer g is referred to as an ITO1 layer, and the second alignment layer is referred to as an ITO2 layer.

In summary, the embodiments of the present disclosure provide a display panel. The plurality of first pixel circuits and the plurality of second pixel circuits in each pixel circuit group in the display panel are alternately arranged, the plurality of first pixel circuits and the plurality of second pixel circuits in each pixel circuit group are designed in opposite directions, and the plurality of first pixel circuits and the plurality of second pixel circuits are offset in the first direction. In this way, the distance between the first connection of the first pixel circuit and the second connection of the second pixel circuit in the first direction is smaller. Furthermore, the first signal line is directly connected to the first connection and the second connection, without the need to design connection holes between adjacent pixel circuits and implement the connection using a trace layer. According to the solution of the embodiments of the present disclosure, the number of connection holes to be designed in the layout can be reduced, and there is sufficient space to design a smaller number of connection holes for signal transmission even if the requirement on the PPI of the display panel is high.

In some embodiments of the present disclosure, referring to FIG. 1, the base substrate 101 of the display panel 10 is provided with a first display region 10a, and the first display region 10a is configured to be provided with an optical sensor. Optionally, the optical sensor is a front camera, and the first display region 10a is referred to as an FDC region.

Referring to FIG. 2, the display panel 10 includes a base substrate 101, a plurality of pixel circuit groups 102, and a plurality of first signal lines 103 in one-to-one correspondence with the plurality of pixel circuit groups 102.

In the embodiments of the present disclosure, the plurality of pixel circuit groups 102 are disposed in the first display region 10a and are arranged along the first direction X. At least one pixel circuit group 102 includes a plurality of first pixel circuits 1021 arranged along the second direction Y and a plurality of second pixel circuits 1022 arranged along the second direction Y The first direction X is perpendicular to the second direction Y. For example, the first direction X is a pixel column direction, and the second direction Y is a pixel row direction.

The plurality of first pixel circuits 1021 and the plurality of second pixel circuits 1022 in each pixel circuit group 102 are alternately arranged, and each pixel circuit of the plurality of first pixel circuits 1021 and the plurality of second pixel circuits 1022 includes a first boundary and a second boundary that extend along the second direction Y and are arranged along the first direction X. The arrangement direction of the first boundary 1021a and the second boundary 1021b of the first pixel circuit 1021 is opposite to the arrangement direction of the first boundary 1022a and the second boundary 1022b of the second pixel circuit 1022.

Additionally, for each pixel circuit group 102, the distance, in the first direction X, between the first boundary 1021a of the first pixel circuit 1021 and the first boundary 1022a of the second pixel circuit 1022 is greater than a first distance H1, and the distance, in the first direction X, between the second boundary 1021b of the first pixel circuit 1021 and the second boundary 1022b of the second pixel circuit 1022 is less than the first distance H1. The first distance H1 is a distance between the first boundary and the second boundary of the same pixel circuit along the first direction X, e.g., the distance between the first boundary and the second boundary of the first pixel circuit 1021 or the second pixel circuit 1022 along the first direction X. The distance between the first boundary 1021a and the second boundary 1021b of the first pixel circuit 1021 along the first direction X is equal to the distance between the first boundary 1022a and the second boundary 1022b of the second pixel circuit 1022 along the first direction X.

The first boundary 1021a of the first pixel circuit 1021 corresponds to the first boundary 1022a of the second pixel circuit 1022, and the second boundary 1021b of the first pixel circuit 1021 corresponds to the second boundary 1022b of the second pixel circuit 1022. Two boundaries corresponding to each other means that the pixel circuits at the locations of the two boundaries are of the same structure, and the plurality of first pixel circuits 1021 and the plurality of second pixel circuits 1022 are designed in opposite directions. Assuming that the design direction of the first pixel circuits 1021 is a forward direction, then the design direction of the second pixel circuits 1022 is a reverse direction. Alternatively, assuming that the design direction of the first pixel circuits 1021 is a reverse direction, then the design direction of the second pixel circuits 1022 is a forward direction.

Therefore, with the above arrangement of the first pixel circuits 1021 and the second pixel circuits 1022, there is a certain offset, in the first direction X, between the plurality of first pixel circuits 1021 and the plurality of second pixel circuits 1022. With the offset, the second boundaries 1021b of the plurality of first pixel circuits 1021 and the second boundaries 1022b of the plurality of second pixel circuits 1022 are all disposed between the extension line of the first boundary 1021a of the first pixel circuit 1021 and the extension line of the first boundary 1022a of the second pixel circuit 1022.

In the embodiments of the present disclosure, each first signal line 103 is of an integral structure and is connected to each of the plurality of first pixel circuits 1021 and the plurality of second pixel circuits 1022 in the corresponding pixel circuit group 102. In this way, each first signal line 103 provides signals for all pixel circuits disposed in the first display region 10a in the corresponding pixel circuit group 102. The first signal line 103 being of an integral structure refers to that the portion of the first signal line 103 in the first display region 10a is disposed in only one film layer of the display panel 10, without the need to cross layers.

Optionally, as the plurality of first pixel circuits 1021 and the plurality of second pixel circuits 1022 are offset in the first direction X and are designed in opposite directions, there is a certain offset between the connection positions of the first signal line 103 and the plurality of first pixel circuits 1021 and the connection positions of the first signal line 103 and the plurality of second pixel circuits 1022 in the first direction X. For example, each first signal line 103 is connected to each first pixel circuit 1021 in the corresponding pixel circuit group 102 and each second pixel circuit 1022 in the corresponding pixel circuit group 102.

In the embodiments of the present disclosure, as the plurality of first pixel circuits 1021 and the plurality of second pixel circuits 1022 are offset and alternately arranged in the first direction X, and are designed in opposite directions, the first pixel circuits 1021 and the second pixel circuits 1022 in adjacent two pixel circuit groups of the plurality of pixel circuit groups 102 enclose a plurality of target regions. Orthographic projections of the target region on the base substrate 101 are not overlapped with orthographic projections of the first pixel circuit 1021 on the base substrate 101 and orthographic projections of the second pixel circuit 1022 on the base substrate 101. The transmittance of the target regions is greater than the transmittance of the regions where the first pixel circuits 1021 and the second pixel circuits 1022 are disposed. Therefore, even if the pixel circuits are disposed within the FDC region, the target region of the FDC region has a certain degree of transmittance, and the photoelectric sensor provided in the FDC region can be used normally.

Additionally, by designing the plurality of first pixel circuits 1021 and the plurality of second pixel circuits 1022 in different directions to have a certain offset in the first direction X and to be alternately arranged, the distance between the connection of the first signal line 103 and the first pixel circuit 1021 and the connection of the first signal line 103 and the second pixel circuit 1022 is smaller in the first direction X, for example, the two connections are in the same horizontal line or near the same horizontal line in the second direction Y.

In this way, the first signal line 103 can be directly connected to the pixel circuits (the plurality of first pixel circuits 1021 and the plurality of second pixel circuits 1022) in the pixel circuit group 102, without the need to design connection holes between adjacent pixel circuits and implement the connection by a trace layer. Furthermore, the number of connection holes to be designed in the layout can be reduced, and there is sufficient space to design a smaller number of connection holes for signal transmission even if the requirement on the PPI of the display panel is high.

Optionally, the distance, in the first direction X, between the connection of the first signal line 103 and the first pixel circuit 1021 and the connection of the first signal line 103 and the second pixel circuit 1022 is less than a distance threshold. The distance threshold is a predetermined fixed value, and the distance threshold may be small enough, such that the two connections are in the same horizontal line or near the same horizontal line.

In summary, the embodiments of the present disclosure provide a display panel. The plurality of first pixel circuits and the plurality of second pixel circuits in each pixel circuit group in the display panel are alternately arranged, the plurality of first pixel circuits and the plurality of second pixel circuits in each pixel circuit group are designed in opposite directions, and the plurality of first pixel circuits and the plurality of second pixel circuits are offset in the first direction. In this way, the distance between the connection of the first signal line and the first pixel circuit and the connection of the first signal line and the second pixel circuit in the first direction is smaller. Furthermore, adjacent pixel circuits are directly connected by the first signal line, and there is no need to design connection holes between adjacent pixel circuits and implement the connection using a trace layer. According to the solution of the embodiments of the present disclosure, the number of connection holes to be designed in the layout can be reduced, and there is sufficient space to design a smaller number of connection holes for signal transmission even if the requirement on the PPI of the display panel is high.

Other relevant features in this embodiment are the same as those in the foregoing embodiments and can be referred to the detailed description in the foregoing embodiments, which are not repeated herein.

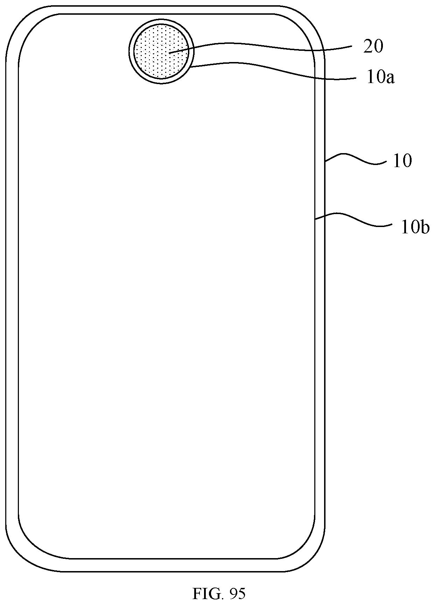

FIG. 95 is a schematic structural diagram of a display device according to some embodiments of the present disclosure. Referring to FIG. 95, the display device includes the display panel 10 provided in the foregoing embodiments and an electrical component, such as a sensor 02, e.g., an optical sensor. Taking the display device being a mobile phone as an example, the display device includes an optical sensor such as a front camera, a proximity optical sensor, and a 3D sensing module, and these optical components need to receive light from the display surface of the display device to implement corresponding functions. In the display device, the optical sensor is generally mounted on the non-display surface of the display panel, with the light-sensing surface of the optical sensor facing the display panel. The orthographic projection of the optical sensor on the base substrate 101 is at least partially overlapped with the first display region 10a in the base substrate 101.

In the embodiments of the present disclosure, the display device may be any product or component having a display function, such as an active-matrix organic light-emitting diode (AMOLED) display device, a passive-matrix organic light-emitting diode (PMOLED) display device, a quantum dot light-emitting diode (QLED) display device, electronic paper, a mobile phone, a tablet computer, a television, a display, laptop computer, a digital photo frame, and or navigator.

As the display device has basically the same technical effect as the display panel described in the foregoing embodiments, the technical effects of the display device are not repeated herein for brevity.

It is understandable that although terms such as first and second are used herein to describe various elements, components, regions, layers, and/or portions, these elements, components, regions, layers, and/or portions should not be limited by these terms. These terms are merely used to distinguish one element, component, region, layer, or portion from another region, layer, or portion. Thus, the first element, first component, first region, first layer, or first portion discussed above may be referred to as a second element, second component, second region, second layer, or second portion without departing from the teachings of the present disclosure.

Spatially relative terms such as "under," "on," "left," and "right" are used herein for describing the relationship of one element or feature and other elements (s) or feature(s) as illustrated in the figures. Understandably, these spatially relative terms are intended to encompass different orientations of the device in use or operation in addition to the orientation depicted in the drawings. For example, if the device in the figure is flipped, then a component described as "under another component or feature" will be oriented "on the component or feature". Thus, the exemplary term "under" encompasses orientations of "on" and "under". The device may be oriented in other ways (rotated by 90 degrees or in other orientations) and the spatially relative descriptors used herein are interpreted accordingly. It is further understandable that when a layer is referred to as "between two layers", it may be the only layer between the two layers, or there may be one or more intermediate layers.

The terms used herein are merely to describe particular embodiments but are not intended to limit the present disclosure. As used herein, the singular forms "a/an," "one," and "said" are intended to include the plural form as well, unless the context clearly indicates otherwise. It is further understandable that the terms "including" and/or "comprising" used herein indicate the existence of the described feature, entirety, step, operation, element and/or component, but do not exclude the existence or addition of one or more other features, entireties, steps, operations, elements, components and/or groups. As used herein, the term "and/or" includes any one and all combinations of one or more of the associated items as listed. In this specification, the described specific features, structures, materials, or characteristics may be combined in any one or more embodiments or examples suitably. In addition, without contradicting each other, those skilled in the art may combine different embodiments or examples and features of different embodiments or examples described in this specification.

Unless otherwise defined, all terms used herein (including technical and scientific terms) have the same meaning as commonly understood by those of ordinary skill in the art to which the present disclosure belongs. It is further understandable that terms such as those defined in commonly used dictionaries should be construed as having a meaning consistent with the meaning in the relevant field and/or context of this specification and will not be construed in an idealized or overly formal sense unless expressly so defined herein.

Described above are merely optional embodiments of the present disclosure, and are not intended to limit the present disclosure. Within the spirit and principles of the present disclosure, any modifications, equivalent substitutions, improvements, and the like are within the protection scope of the present disclosure.

## Claims

1. A display panel, comprising:
a base substrate, the base substrate being provided with a first display region;
a plurality of pixel circuit groups disposed in the first display region and arranged in a first direction, wherein at least one of the plurality of pixel circuit groups comprises a plurality of first pixel circuits arranged in a second direction and a plurality of second pixel circuits arranged in the second direction, wherein the plurality of first pixel circuits and the plurality of second pixel circuits are arranged alternately, each pixel circuit comprises a first boundary and a second boundary that extend along the second direction and are arranged in the first direction, an arrangement direction of a first boundary and a second boundary of the first pixel circuit is opposite to an arrangement direction of a first boundary and a second boundary of the second pixel circuit; and for each of the plurality of pixel circuit groups, a distance, in the first direction, between the first boundary of the first pixel circuit and the first boundary of the second pixel circuit is greater than a first distance, and a distance, in the first direction, between the second boundary of the first pixel circuit and the second boundary of the second pixel circuit is less than the first distance, the first distance being a distance, in the first direction, between the first boundary and the second boundary of a same pixel circuit; and
a plurality of first signal lines in one-to-one correspondence with the plurality of pixel circuit groups, wherein each of the plurality of first signal lines is connected to each first pixel circuit in a corresponding pixel circuit group at a first connection and is connected to each second pixel circuit in the corresponding pixel circuit group at a second connection;
wherein a distance between the first connection and the first boundary of the first pixel circuit is equal to a distance between the second connection and the first boundary of the second pixel circuit, and a distance, in the first direction, between the first connection and the second connection is less than a second distance, the second distance being a distance, in the first direction, between the first boundary of the first pixel circuit and the second boundary of the second pixel circuit.

2. The display panel as claimed in claim 1, wherein the first signal line is a light-emitting control signal line.

3. The display panel as claimed in claim 1 or 2, wherein the plurality of pixel circuit groups at least comprise a first pixel circuit group and a second pixel circuit group arranged in the first direction, wherein a distance, in the first direction, between a first boundary of a second pixel circuit in the first pixel circuit group and a first boundary of a first pixel circuit in the second pixel circuit group is less than the second distance; and
the display panel comprises a plurality of second signal lines disposed in the first display region, wherein each of the plurality of second signal lines is connected to a second pixel circuit in the first pixel circuit group and a first pixel circuit in the second pixel circuit group

4. The display panel as claimed in claim 3, wherein the base substrate is provided with a second display region, the second display region at least partially surrounding the first display region; and the display panel comprises a first connection trace disposed in the second display region, the first connection trace at least partially surrounding the first display region;
wherein at least one end of each second signal line of the plurality of second signal lines is connected to the first connecting trace, and the each second signal line transmits a signal received from the first connection trace to a pixel circuit connected to the second signal line.

5. The display panel as claimed in claim 3 or 4, wherein the second signal line is a first reset power line.

6. The display panel as claimed in any one of claims 1 to 5, comprising: a plurality of third signal lines in one-to-one correspondence with the plurality of pixel circuit groups; wherein
each of the plurality of third signal lines is connected to a first pixel circuit and a second pixel circuit in a corresponding pixel circuit group;
wherein a signal transmitted by the third signal line is different from a signal transmitted by the first signal line.

7. The display panel as claimed in claim 6, wherein each of the first pixel circuits and the second pixel circuits in each of the plurality of pixel circuit groups comprises:
a first transistor, wherein a gate of the first transistor is connected to a first reset signal line, a first electrode of the first transistor is connected to a first reset power line, and a second electrode of the first transistor is connected to a second node;
a second transistor, wherein a gate of the second transistor is connected to a first gate signal line in the display panel, a first electrode of the second transistor is connected to a third node, and a second electrode of the second transistor is connected to the second node;
a third transistor, wherein a gate of the third transistor is connected to the second node, a first electrode of the third transistor is connected to a first node, and a second electrode of the third transistor is connected to the third node;
a fourth transistor, wherein a gate of the fourth transistor is connected to a second gate signal line in the display panel, a first electrode of the fourth transistor is connected to a data signal line in the display panel, and a second electrode of the fourth transistor is connected to the first node;
a fifth transistor, wherein a gate of the fifth transistor is connected to a light-emitting control signal line, a first electrode of the fifth transistor is connected to a driving power line in the display panel, and a second electrode of the fifth transistor is connected to the first node;
a sixth transistor, wherein a gate of the sixth transistor is connected to the light-emitting control signal line, a first electrode of the sixth transistor is connected to the third node, and a second electrode of the sixth transistor is connected to the light-emitting unit;
a seventh transistor, wherein a gate of the seventh transistor is connected to the second gate signal line in the display panel, a first electrode of the seventh transistor is connected to a second reset power line, and a second electrode of the seventh transistor is connected to the light-emitting unit; and
a storage capacitor, wherein one terminal of the storage capacitor is connected to the driving power line, and another terminal of the storage capacitor is connected to the second node.

8. The display panel as claimed in claim 7, wherein the third signal line is the second gate signal line.

9. The display panel as claimed in claim 7 or 8, wherein the first transistor and the second transistor are oxide thin film transistors; and
the third transistor, the fourth transistor, the fifth transistor, the sixth transistor, and the seventh transistor are low-temperature polysilicon thin film transistors.

10. The display panel as claimed in claim 9, comprising: an active layer, a first gate insulating layer, a first gate layer, a second gate insulating layer, a second gate layer, a buffer layer, an oxide layer, a third gate insulating layer, a third gate layer, an interlayer dielectric layer, and a first source-drain layer that constitute a pixel circuit and are sequentially stacked in a direction away from the base substrate; wherein
the second transistor is composed of the second gate layer, the oxide layer, and the third gate layer; and
the first transistor, the third transistor, the fourth transistor, the fifth transistor, the sixth transistor, the seventh transistor, and the eighth thin film transistor are composed of the active layer, the first gate layer, and the first source-drain layer.

11. The display panel as claimed in any one of claims 7 to 10, comprising: an active layer, a first gate insulating layer, a first gate layer, a second gate insulating layer, a second gate layer, a buffer layer, an oxide layer, a third gate insulating layer, a third gate layer, an interlayer dielectric layer, and a first source-drain layer that constitute a pixel circuit and are sequentially stacked in a direction away from the base substrate;
wherein the first signal line is disposed in the first gate layer, and the second signal line is disposed in the first source-drain layer; and
the third signal line comprises a first portion, a second portion, and a third portion that are connected in sequence, wherein an orthographic projection of the first portion on the base substrate is at least partially overlapped with an orthographic projection of the first pixel circuit on the base substrate, an orthographic projection of the second portion on the base substrate is not overlapped with the orthographic projection of the first pixel circuit on the base substrate and an orthographic projection of the second pixel circuit on the base substrate, and an orthographic projection of the third portion on the base substrate is at least partially overlapped with the orthographic projection of the second pixel circuit on the base substrate; and the first portion and the third portion are disposed in the first gate layer, and the second portion is disposed in the first source-drain layer.

12. The display panel as claimed in claim 7, wherein each of the first pixel circuits and the second pixel circuits in each of the plurality of pixel circuit groups comprises: an eighth transistor, wherein a gate of the eighth transistor is connected to the second reset signal line, a first electrode of the eighth transistor is connected to a third reset power line in the display panel, and a second electrode of the eighth transistor is connected to the first node;
wherein the third signal line is the third reset power line.

13. The display panel as claimed in claim 12, wherein the second transistor is an oxide thin film transistor; and
the first transistor, the third transistor, the fourth transistor, the fifth transistor, the sixth transistor, the seventh transistor, and the eighth transistor are low-temperature polysilicon thin film transistors.

14. The display panel as claimed in claim 13, comprising: an active layer, a first gate insulating layer, a first gate layer, a second gate insulating layer, a second gate layer, a buffer layer, an oxide layer, a third gate insulating layer, a third gate layer, an interlayer dielectric layer, and a first source-drain layer that constitute a pixel circuit and are sequentially stacked in a direction away from the base substrate; wherein
the second transistor is composed of the second gate layer, the oxide layer, and the third gate layer; and
the first transistor, the third transistor, the fourth transistor, the fifth transistor, the sixth transistor, the seventh transistor, and the eighth thin film transistor are composed of the active layer, the first gate layer, and the first source-drain layer.

15. The display panel as claimed in claim 13 or 14, comprising: an active layer, a first gate insulating layer, a first gate layer, a second gate insulating layer, a second gate layer, a third gate insulating layer, an oxide layer, a fourth gate insulating layer, a third gate layer, an interlayer dielectric layer, and a first source-drain layer that constitute a pixel circuit and are sequentially stacked in a direction away from the base substrate;
wherein the first signal line is disposed in the first gate layer, the second signal line is disposed in the first source-drain layer, and the third signal line is disposed in the third gate layer.

16. The display panel as claimed in any one of claims 10 to 11 and 14 to 15, comprising: a passivation layer, a first trace layer, a first planarization layer, a second trace layer, a second planarization layer, a second source-drain layer, and a third planarization layer that constitute a pixel circuit and are sequentially stacked in a direction away from the first source-drain layer.

17. The display panel as claimed in any one of claims 6 to 16, wherein each target signal line in the display panel comprises a first sub-signal line, a second sub-signal line, and a second connection trace; wherein
the first sub-signal line is disposed in the first display region, and the first sub-signal line is connected to a plurality of first pixel circuits in one of the plurality of pixel circuit groups;
the second sub-signal line is disposed in the first display region, and the second sub-signal line is connected to a plurality of second pixel circuits in one of the plurality of pixel circuit groups, wherein the plurality of second pixel circuits connected to the second sub-signal line of each target signal line and the plurality of first pixel circuits connected to the first sub-signal line of the target signal line belong to a same pixel circuit group; and
the second connection trace is disposed in a second display region, one end of the second connection trace is connected to the first sub-signal line, and another end of the second connection trace is connected to the second sub-signal line;
wherein the target signal line is a signal line providing a signal along the second direction other than the first signal line, the second signal line, and the third signal line in the display panel.

18. The display panel as claimed in claim 17, wherein the first sub-signal line comprises a fourth portion and a fifth portion that are connected; wherein an orthographic projection of the fourth portion on the base substrate is at least partially overlapped with an orthographic projection of a first pixel circuit on the base substrate, and an orthographic projection of the fifth portion on the base substrate is between orthographic projections of two adjacent first pixel circuits on the base substrate; and
the second sub-signal line comprises a sixth portion and a seventh portion that are connected; wherein an orthographic projection of the sixth portion on the base substrate is at least partially overlapped with an orthographic projection of a second pixel circuit on the base substrate, and an orthographic projection of the seventh portion on the base substrate is between orthographic projections of two adjacent second pixel circuits on the base substrate;
wherein the fourth portion and the sixth portion are disposed in a same layer, and the fourth portion and the sixth portion are disposed in a metal layer; and the fifth portion and the seventh portion are disposed in a same layer, and the fifth portion and the seventh portion are disposed in a trace layer.

19. A display panel, comprising:
a base substrate, wherein the base substrate is provided with a first display region;
a plurality of pixel circuit groups disposed in the first display region and arranged in a first direction, wherein at least one of the plurality of pixel circuit groups comprises a plurality of first pixel circuits arranged in a second direction and a plurality of second pixel circuits arranged in the second direction, wherein the plurality of first pixel circuits and the plurality of second pixel circuits are arranged alternately, each pixel circuit comprises a first boundary and a second boundary that extend along the second direction and are arranged in the first direction, an arrangement direction of a first boundary and a second boundary of the first pixel circuit is opposite to an arrangement direction of a first boundary and a second boundary of the second pixel circuit; and for each of the plurality of pixel circuit groups, a distance, in the first direction, between the first boundary of the first pixel circuit and the first boundary of the second pixel circuit is greater than a first distance, and a distance, in the first direction, between the second boundary of the first pixel circuit and the second boundary of the second pixel circuit is less than the first distance, the first distance being a distance, in the first direction, between the first boundary and the second boundary of a same pixel circuit; and
a plurality of first signal lines in one-to-one correspondence with the plurality of pixel circuit groups, wherein each of the plurality of first signal lines is connected to a first pixel circuit and a second pixel circuit in a corresponding pixel circuit group;
wherein first pixel circuits and second pixel circuits in two adjacent pixel circuit groups of the plurality of pixel circuit groups enclose a plurality of target regions, wherein orthographic projections of the target regions on the base substrate are not overlapped with orthographic projection of the first pixel circuits on the base substrate and orthographic projection of the second pixel circuits on the base substrate, and transmittance of the target regions is greater than transmittance of the regions where the first pixel circuits and the second pixel circuits are disposed.

20. A display device, comprising: the display panel as claimed in any one of claims 1 to 19 and an optical sensor; wherein
an orthographic projection of the optical sensor on the display panel is at least partially overlapped with a first display region of the display panel.
